# EUROPÄISCHE PATENTSCHRIFT

(11) **EP 2 742 054 B1**
(45) Veröffentlichungstag und Bekanntmachung des Hinweises auf die Patenterteilung: **12.10.2016**
(21) Anmeldenummer: 12735791.1
(22) Anmeldetag: 17.07.2012
(51) Int. Cl.: C07F 15/00, H01L 51/00, C07F 1/00, C07F 15/04

(54) **METALLKOMPLEXE**
METAL COMPLEXES
COMPLEXES MÉTALLIQUES

(30) Priorität: 10.08.2011 EP 11006562
(43) Veröffentlichungstag der Anmeldung: 18.06.2014
(73) Patentinhaber: Merck Patent GmbH, 64293 Darmstadt (DE)
(72) Erfinder: STOESSEL, Philipp, 60487 Frankfurt am Main (DE); BREUNING, Esther, 64372 Ober-Ramstadt (DE)
(86) Internationale Anmeldenummer: PCT/EP2012/002991
(87) Internationale Veröffentlichungsnummer: WO 2013/020631

(56) Entgegenhaltungen:
- WO-A1-2006/081973
- WO-A1-2007/006380
- WO-A1-2011/035836

## Beschreibung

Die vorliegende Erfindung betrifft Metallkomplexe, welche sich für den Einsatz in organischen Elektrolumineszenzvorrichtungen eignen, insbesondere als Emitter.

Der Aufbau organischer Elektrolumineszenzvorrichtungen (OLEDs), in denen organische Halbleiter als funktionelle Materialien eingesetzt werden, ist beispielsweise in US 4539507, US 5151629, EP 0676461 und WO 98/27136 beschrieben. Als emittierende Materialien werden häufig metallorganische Komplexe eingesetzt, die Phosphoreszenz statt Fluoreszenz zeigen (M. A. Baldo et al., Appl. Phys. Lett. 1999, 75, 4-6). Aus quantenmechanischen Gründen ist unter Verwendung metallorganischer Verbindungen als Phosphoreszenzemitter eine bis zu vierfache Energie- und Leistungseffizienz möglich. Generell gibt es bei OLEDs, die Triplettemission zeigen, immer noch Verbesserungsbedarf, insbesondere im Hinblick auf Effizienz, Betriebsspannung und Lebensdauer.

Gemäß dem Stand der Technik werden in phosphoreszierenden OLEDs als Triplettemitter vor allem Iridium- oder Platinkomplexe eingesetzt. Eine Verbesserung der verwendeten Platinkomplexe kann erzielt werden, indem Metallkomplexe mit tetradentatem Liganden eingesetzt werden, wodurch die Komplexe eine höhere thermische Stabilität aufweisen (WO 2004/108857, WO 2005/042550, WO 2005/042444). In diesen Komplexen werden zwei bidentate Teilliganden durch einen verbrückende Gruppe, im Folgenden Brückenkopf genannt, miteinander verbunden. Gemäß dem Stand der Technik sind auch Platinkomplexe mit tetradentatem Liganden bekannt (WO 2010/069442), welche als Brückenkopf ein Fluoren enthalten, wobei die beiden bidentaten Teilliganden jeweils an der 9-Position des Fluorens gebunden sind. Diese Komplexe weisen generell eine gute Effizienz und Lebensdauer auf, jedoch gibt es hier insbesondere bei der Lebensdauer noch Verbesserungsbedarf.

WO 2011/035836 offenbart Metallkomplexe mit einem tetradentaten Liganden, der zwei koordinierende Aryl- oder Heteroarylgruppen und zwei koordinierende Atome, ausgewählt aus C, N_{.} P, O, S oder Se, aufweist. Metallkomplexe mit Liganden, die vier koordinierende Aryl- oder Heteroarylgruppen aufweisen, sind nicht offenbart.

Aufgabe der vorliegenden Erfindung ist daher die Bereitstellung neuer Metallkomplexe, welche hier Verbesserungen aufweisen und sich als Emitter für die Verwendung in OLEDs eignen.

Überraschend wurde gefunden, dass die unten näher beschriebenen Metallchelatkomplexe diese Aufgabe lösen und zu Verbesserungen der organischen Elektrolumineszenzvorrichtung führen. Diese Metallkomplexe und organische Elektrolumineszenzvorrichtungen, welche diese Komplexe enthalten, sind daher der Gegenstand der vorliegenden Erfindung.

Gegenstand der Erfindung ist eine Verbindung gemäß Formel (1), 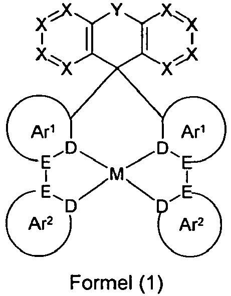 wobei für die verwendeten Symbole gilt:
- M: ist bei jedem Auftreten gleich oder verschieden ausgewählt aus der Gruppe bestehend aus Platin, Palladium, Nickel, Rhodium, Iridium und Gold;
- X: ist bei jedem Auftreten gleich oder verschieden CR¹ oder N;
- Y: ist CR₂, C=O, BR, SiR₂, NR, PR, P(=O)R, 0, S, CR=CR, CR₂-CR₂ oder CR=N; oder Y steht für eine Gruppe der folgenden Formel (2), 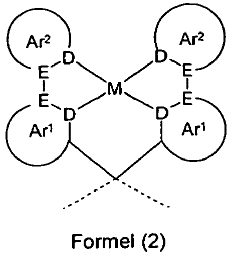 wobei die gestrichelten Bindungen die Verknüpfung dieser Gruppe andeutet;
- D: ist bei jedem Auftreten gleich oder verschieden C oder N;
- E: ist C, wenn der Cyclus, in dem dieses E gebunden ist, ein aromatischer oder heteroaromatischer Sechsring ist; bzw. ist C oder N, wenn der Cyclus, in dem dieses E gebunden ist, ein heteroaromatischer Fünfring ist;
- Ar¹: ist bei jedem Auftreten gleich oder verschieden zusammen mit den Gruppen D und E eine Aryl- oder Heteroarylgruppe mit 5 bis 18 aromatischen Ringatomen, die durch einen oder mehrere Reste R¹ substituiert sein kann; dabei können benachbarte Gruppen Ar¹ und Ar² auch durch zwei Reste R¹, die miteinander verknüpft sind, oder durch eine Gruppe CR²=N miteinander verknüpft sein;
- Ar²: ist bei jedem Auftreten gleich oder verschieden zusammen mit den Gruppen D und E eine Aryl- oder Heteroarylgruppe mit 5 bis 18 aromatischen Ringatomen, die durch einen oder mehrere Reste R¹ substituiert sein kann; dabei können benachbarte Gruppen Ar² und Ar¹ auch durch zwei Reste R¹, die miteinander verknüpft sind, oder durch eine Gruppe CR²=N miteinander verknüpft sein;
- R: ist bei jedem Auftreten gleich oder verschieden H, D, F, N(R²)₂, CN, C(=O)N(R²)₂, Si(R²)₃, B(OR²)₂, C(=O)R², P(=O)(R²)₂, S(=O)R², S(=O)₂R², eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten R² substituiert sein kann, wobei eine oder mehrere nicht benachbarte CH₂-Gruppen durch R²C=CR², C=C, Si(R²)₂, C≡O, NR², O, S oder CONR² ersetzt sein können und wobei ein oder mehrere H-Atome durch D, F, Cl, Br, I oder CN ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 40 aromatischen Ringatomen, die durch einen oder mehrere Reste R² substituiert sein kann, oder eine Aralkyl- oder Heteroaralkylgruppe mit 5 bis 40 aromatischen Ringatomen, die durch einen oder mehrere Reste R² substituiert sein kann; dabei können auch zwei Reste R, die an dasselbe C- bzw. Si-Atom binden, miteinander ein mono- oder polycyclisches, aliphatisches oder aromatisches Ringsystem bilden;
- R¹: ist bei jedem Auftreten gleich oder verschieden H, D, F, Cl, Br, I, N(R²)₂, CN, NO₂, OH, COOH, C(=O)N(R₂)₂, Si(R²)₃, B(OR²)₂, C(=O)R², P(=O)(R²)₂, S(=+R², S(=O)₂R², OSO₂R², eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten R² substituiert sein kann, wobei eine oder mehrere nicht benachbarte CH₂-Gruppen durch R²C=CR², C=C, Si(R²)₂, C=O, NR², S oder CONR² ersetzt sein können und wobei ein oder mehrere H-Atome durch D, F, C, Br, I oder CN ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 40 aromatischen Ringatomen, die durch einen oder mehrere Reste R² substituiert sein kann, oder eine Aralkyl- oder Heteroaralkylgruppe mit 5 bis 40 aromatischen Ringatomen, die durch einen oder mehrere Reste R² substituiert sein kann; dabei können zwei benachbarte Reste R¹ auch miteinander ein mono- oder polycyclisches, aliphatisches oder aromatisches Ringsystem bilden; weiterhin können auch die Reste R¹, die an benachbarte Gruppen Ar¹ und Ar² binden, miteinander ein mono- oder polycyclisches, aliphatisches oder aromatisches Ringsystem bilden; weiterhin können auch zwei Gruppen R¹, die an die beiden Gruppen Ar² binden, miteinander ein Ringsystem bilden und so einen cyclischen Liganden aufbauen;
- R²: ist bei jedem Auftreten gleich oder verschieden H, D, F, Cl, Br, I, N(R³)₂, CN, NO₂, Si(R³)₃, B(OR³)₂, C(=O)R³, P(=O)(R³)₂, S(=O)R³, S(=O)₂R³, OSO₂R³, eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten R³ substituiert sein kann, wobei eine oder mehrere nicht benachbarte CH₂-Gruppen durch R³C=CR³, C=C, Si(R³)2, C=O, NR³, O, S oder CONR³ ersetzt sein können und wobei ein oder mehrere H-Atome durch D, F, CL, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 40 aromatischen Ringatomen, die durch einen oder mehrere Reste R³ substituiert sein kann, oder eine Aralkyl- oder Heteroaralkylgruppe mit 5 bis 40 aromatischen Ringatomen, die durch einen oder mehrere Reste R³ substituiert sein kann; dabei können zwei oder mehrere benachbarte Reste R³ miteinander ein mono- oder polycyclisches, aliphatisches Ringsystem bilden;
- R³: ist bei jedem Auftreten gleich oder verschieden H, D, F oder ein aliphatischer, aromatischer und/oder heteroaromatischer Kohlenwasserstoffrest mit 1 bis 20 C-Atomen, in dem auch ein oder mehrere H-Atome durch F ersetzt sein können; dabei können zwei oder mehrere Substituenten R³ auch miteinander ein mono- oder polycyclisches, aliphatisches Ringsystem bilden;
dabei können auch zwei Gruppen Ar² durch eine Gruppe Y miteinander verbrückt sein.

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden.

Ein aromatisches Ringsystem im Sinne dieser Erfindung enthält 6 bis 60 C-Atome im Ringsystem. Ein heteroaromatisches Ringsystem im Sinne dieser Erfindung enthält 1 bis 60 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Weiterhin sollen Systeme, in denen zwei oder mehrere Aryl- oder Heteroarylgruppen direkt aneinander gebunden sind, wie z. B. Biphenyl oder Terphenyl, ebenfalls als aromatisches bzw. heteroaromatisches Ringsystem verstanden werden.

Unter einer cyclischen Alkyl-, Alkoxy- oder Thioalkoxygruppe im Sinne dieser Erfindung wird eine monocyclische, eine bicyclische oder eine polycyclische Gruppe verstanden.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, tert-Pentyl, 2-Pentyl, neo-Pentyl, Cyclopentyl, n-Hexyl, s-Hexyl, tert-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]-octyl, 2-(2,6-Dimethyl)octyl, 3-(3,7-Dimethyl)octyl, Adamantyl, Trifluormethyl, Pentafluorethyl oder 2,2,2-Trifluorethyl verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer C₁- bis C₄₀-Alkoxygruppe werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden.

Unter einem aromatischen oder heteroaromatischen Ringsystem mit 5 - 60 aromatischen Ringatomen, welches noch jeweils mit den oben genannten Resten R substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Indenocarbazol, cis- oder trans-Indolocarbazol, cis- oder trans-Monobenzoindenofluoren, cis- oder trans-Di-benzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Wie oben aufgeführt, können auch Reste R, die an dasselbe C- bzw. Si-Atom binden, bzw. benachbarte Reste R¹ bzw. Reste R¹ an benachbarten Gruppen Ar¹ und Ar² miteinander ein Ringsystem bilden. Unter benachbarten Resten im Sinne der vorliegenden Erfindung werden Reste verstanden, die an Atome gebunden sind, welche direkt aneinander gebunden sind. Unter benachbarten Gruppen Ar¹ und Ar² werden Gruppen Ar¹ und Ar² verstanden, die direkt aneinander gebunden sind. Dabei sind die Reste wie oben definiert, und zwei Reste binden jeweils unter formaler Abspaltung eines Wasserstoffatoms unter Bildung einer chemischen Bindung aneinander. Wenn es sich bei den Resten um Alkylgruppen handelt, ist so beispielsweise die Bildung einer ankondensierten Cycloalkylgruppe möglich. Wenn es sich bei den Resten um Vinylgruppen bzw. um eine Vinylgruppe und ein Wasserstoffatom handelt, ist so beispielsweise die Bildung einer kondensierten Arylgruppe möglich. Wenn die Reste R bzw. R¹ ein Ringsystem bilden, dann handelt es sich bevorzugt um einen Fünfring oder einen Sechsring. Wenn zwei Reste R miteinander ein Ringsystem bilden, entsteht dadurch ein Spirosystem.

Die Ringbildung wird durch das folgende Schema nochmals verdeutlicht:

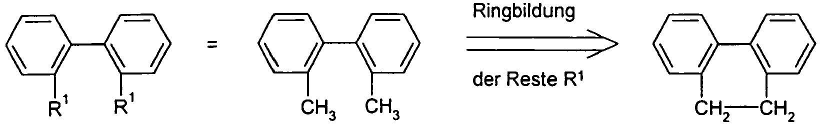

Weiterhin soll unter der oben genannten Formulierung aber auch verstanden werden, dass für den Fall, dass einer der beiden Reste Wasserstoff darstellt, der zweite Rest unter Bildung eines Rings an die Position, an die das Wasserstoffatom gebunden war, bindet. Dies wird durch das folgende Schema verdeutlicht:

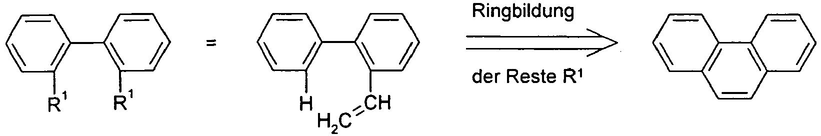

Bevorzugt sind Verbindungen gemäß Formel (1), dadurch gekennzeichnet, dass diese nicht geladen, d. h. elektrisch neutral, sind. Dies wird auf einfache Weise dadurch erreicht, dass die Ladung des Liganden so gewählt wird, dass sie die Ladung des komplexierten Metallatoms M kompensiert. Die Ladung des Liganden ergibt sich aus der Anzahl der koordinierenden Kohlenstoff- bzw. Stickstoffatome, welche jeweils eine negative Ladung aufweisen.

Bevorzugt sind weiterhin Verbindungen gemäß Formel (1), dadurch gekennzeichnet, dass die Summe der Valenzelektronen um das Metallatom 16 beträgt.

Bevorzugt ist das Metall ausgewählt aus den oben genannten Metallen in den Oxidationsstufen Pt(II), Pd(II), Ni(II), Rh(I), Ir(I) und Au(III). Besonders bevorzugt sind Pt(II), Ir(I) und Au(III). Ganz besonders bevorzugt ist Pt(II).

Weiterhin bevorzugt stehen in der erfindungsgemäßen Verbindung zwei Gruppen D für N, und die anderen beiden Gruppen D stehen für C.

Bevorzugte Strukturen der Formel (1) sind daher die Strukturen der folgenden Formeln (3), (4), (5) oder (6), 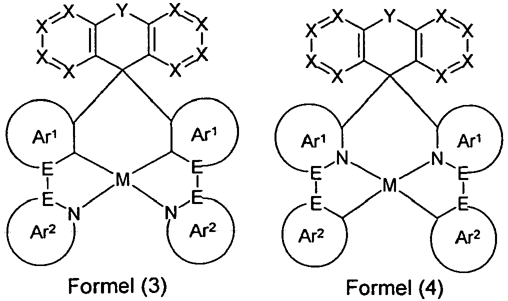 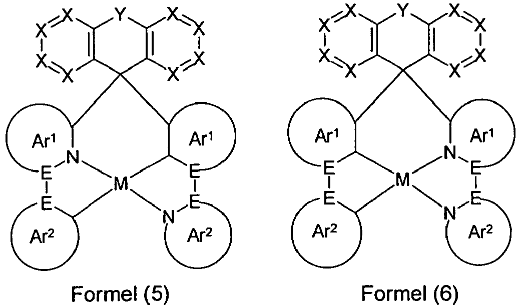 wobei die verwendeten Symbole die oben genannten Bedeutungen aufweisen. Dabei sind die Strukturen gemäß Formel (3) und (4) besonders bevorzugt.

Weiterhin bevorzugt steht Y für CR₂, NR, O, S oder für eine Struktur der Formel (2), besonders bevorzugt für CR₂, NR oder O, ganz besonders bevorzugt für O. Wenn Y für eine Struktur der Formel (2) steht, sind die beiden platinhaltigen Hälften der Verbindung elektronisch entkoppelt.

Weiterhin bevorzugt stehen in Formel (1), (3), (4), (5) und (6) maximal zwei Symbole X pro Cyclus für N und die weiteren Symbole X stehen für CR¹. Besonders bevorzugt steht maximal ein Symbol X pro Cyclus für N, und ganz besonders bevorzugt stehen alle Symbole X für CR¹.

Besonders bevorzugten Ausführungsformen sind daher die Strukturen gemäß den Formeln (3a), (4a), (5a) und (6a), 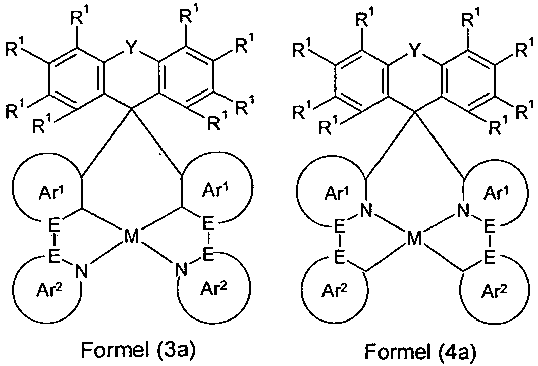 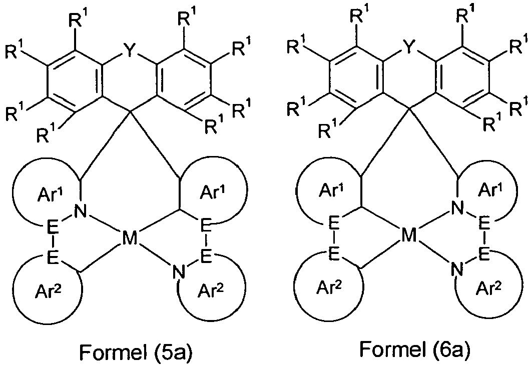 wobei die verwendeten Symbole die oben genannten Bedeutungen aufweisen und die explizit eingezeichneten Reste R¹ bevorzugt für H stehen.

Nochmal weiterhin bevorzugt steht E in den oben genannten Formeln für C.

Weiterhin bevorzugt sind alle Gruppen Ar¹ gleich gewählt und auch gleich substituiert. Ebenso bevorzugt sind alle Gruppen Ar² gleich gewählt und auch gleich substituiert. Es handelt sich also bevorzugt um symmtrische Liganden der Formel (3) oder (4) bzw. (3a) oder (4a) mit zwei gleichen Teilliganden.

In einer bevorzugten Ausführungsform der Erfindung weisen Ar¹ bzw. Ar² 5 bis 13 aromatische Ringatome auf, besonders bevorzugt 5 bis 10 aromatische Ringatome, und könnnen durch einen oder mehrere Reste R¹ substituiert sein.

Bevorzugt sind die Teilliganden Ar¹-Ar² jeweils bidentate monoanionische Liganden, wie sie allgemein auf dem Gebiet der phosphoreszierenden Metallkomplexe für organische Elektrolumineszenzvorrichtungen verwendet werden. Bevorzugt eignet sich als Gruppe Ar¹ jeweils eine der folgenden Gruppen (7) bis (26) und als Gruppe Ar² jeweils eine der folgenden Gruppen (27) bis (48). Dabei sind die Gruppen bevorzugt derart gewählt, dass eine der Gruppen Ar¹ bzw. Ar² im Teilliganden Ar¹-Ar² über ein neutrales Stickstoffatom oder ein Carbenkohlenstoffatom bindet und die andere der Gruppen Ar¹ bzw. Ar² im Teilliganden Ar¹-Ar² über ein negativ geladenes Kohlenstoffatom oder ein negativ geladenes Stickstoffatom bindet.

Geeignete Strukturen Ar¹ sind somit die Strukturen der folgenden Formeln (7) bis (26h),

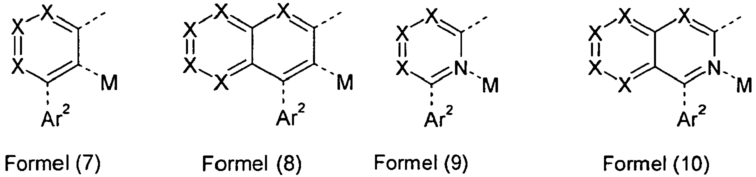

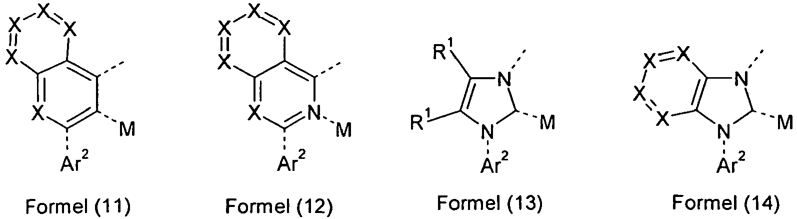

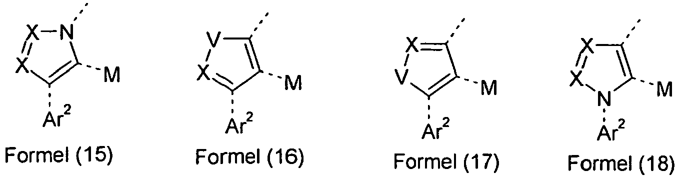

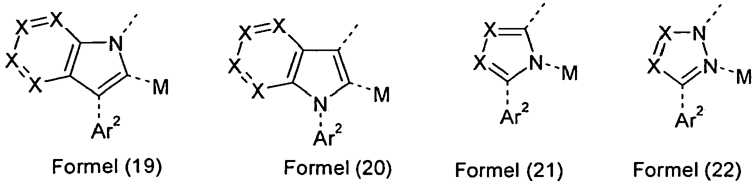

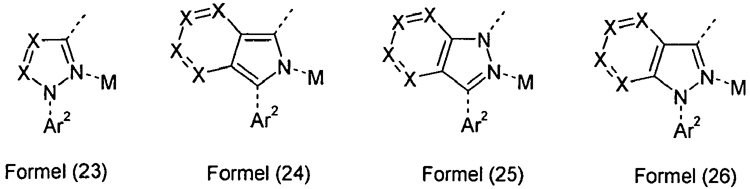

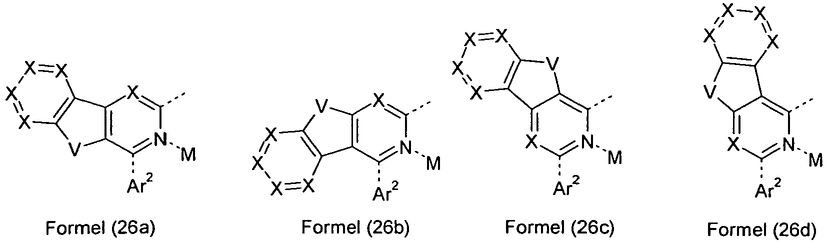

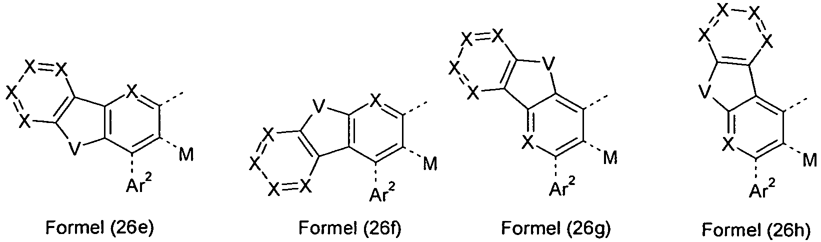

Geeignete Strukturen Ar² sind die Strukturen der folgenden Formeln (27) bis (48d),

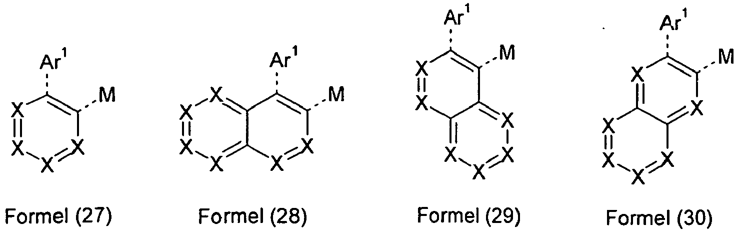

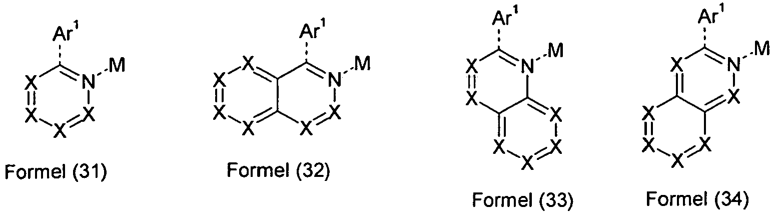

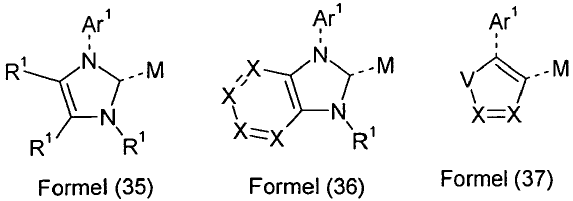

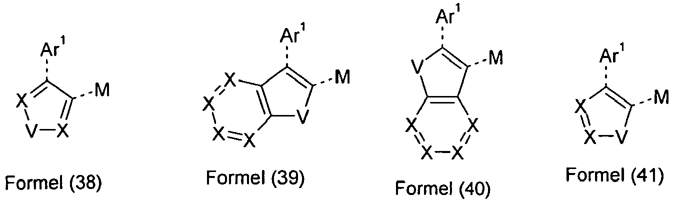

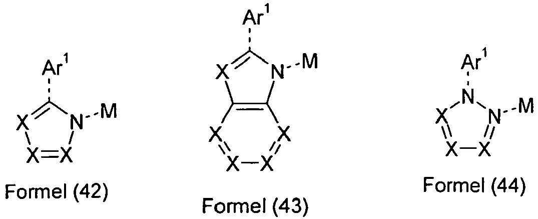

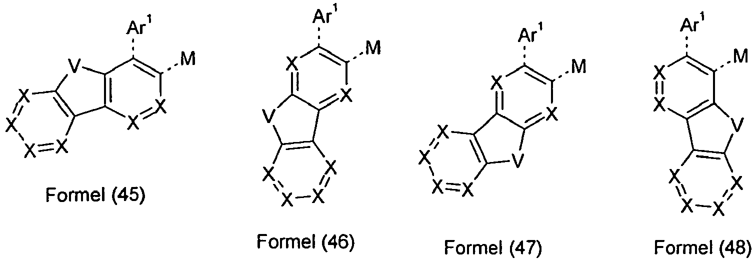

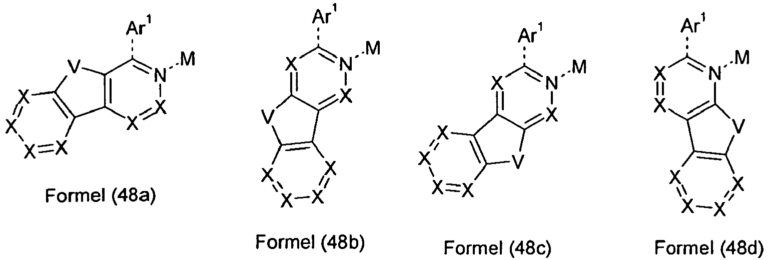

In den Strukturen der Formeln (7) bis (48) ist durch gestrichelte Bindungen jeweils die Bindung an das Kohlenstoffatom des Brückenkopfes, an M und an Ar¹ bzw. an Ar² angedeutet. Weiterhin haben X und R¹ in den Formeln (7) bis (48) dieselbe Bedeutung, wie oben beschrieben und V steht bei jedem Auftreten gleich oder verschieden für O, S, NR¹ oder C(R¹)₂. Bevorzugt stehen maximal zwei Symbole X in jeder Gruppe für N, besonders bevorzugt steht maximal ein Symbol X in jeder Gruppe für N. Ganz besonders bevorzugt stehen alle Symbole X für CR¹.

Besonders bevorzugte Gruppen Ar¹ sind die Gruppen der Formeln (7), (8), (9), (10), (13) und (14). Besonders bevorzugte Gruppen Ar² sind die Gruppen der Formeln (27), (28), (30), (31), (32), (34), (35), (36), (39), (40), (43), (44), (46), (47) und (48).

Besonders bevorzugt sind daher die folgenden Kombinationen aus Ar¹ und Ar²:

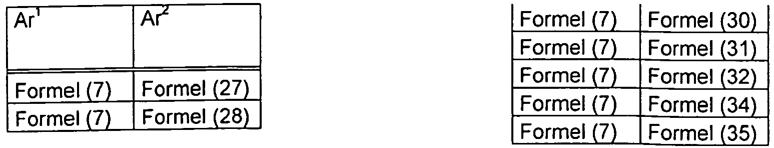

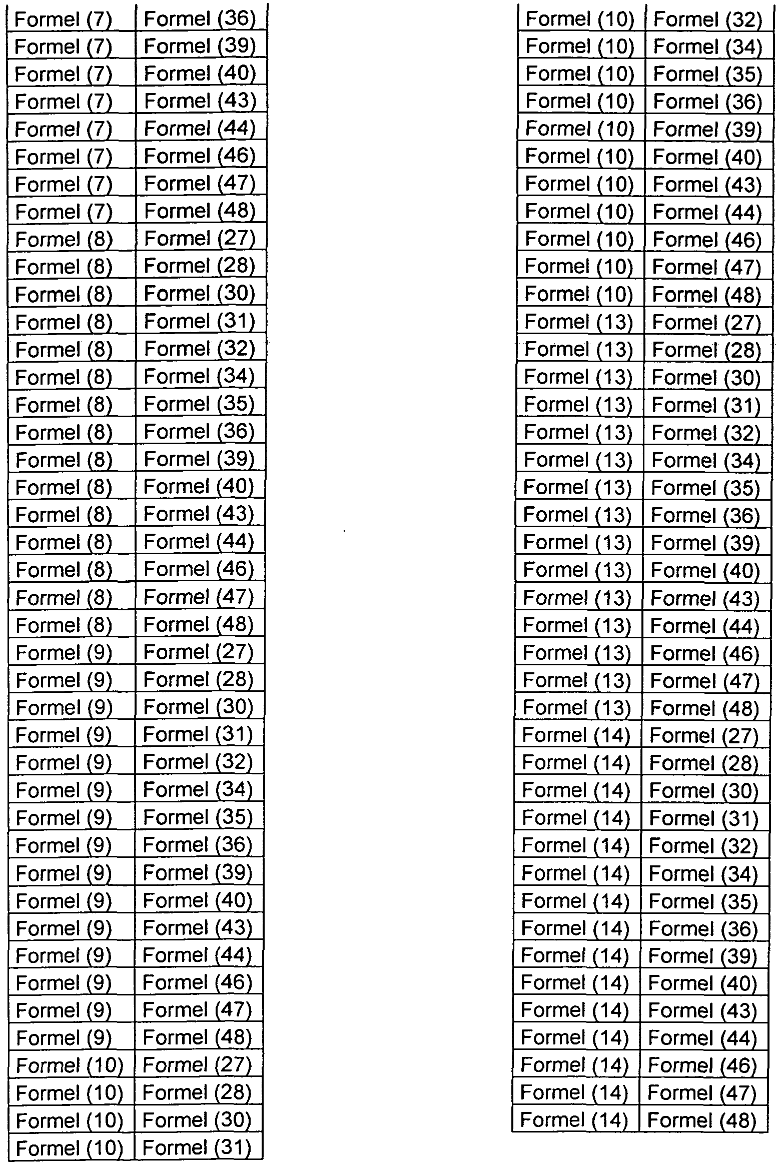

Wie oben aufgeführt, können zwei Reste an benachbarten Gruppen Ar¹ und Ar² auch miteinander einen Ring bilden. Ein solcher Ringschluss erfolgt bevorzugt über eine Gruppe CR²=CR², CR²=N, C(R²)₂₋C(R²)₂, C(=O)-O oder C(=O)-NR², wobei CR²=CR² bzw. CR²=N bevorzugt sind.

Dadurch kann auch insgesamt eine kondensierte Aryl- bzw. Heteroarylgruppe entstehen, so dass Ar¹ und Ar² nicht mehr separate Arylgruppen darstellen.

Bevorzugte Gruppen Ar¹-Ar², die durch eine solche Ringschlussreaktion entstehen, sind die Gruppen der folgenden Formeln (49) bis (59), 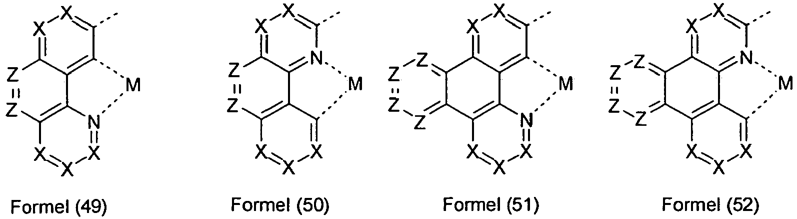 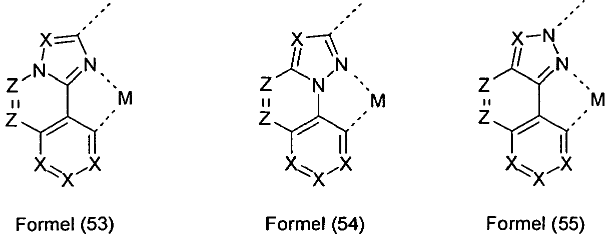 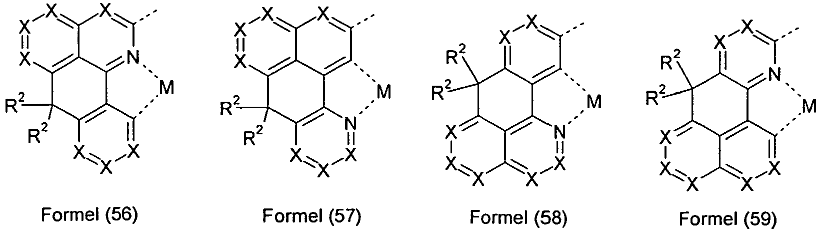 wobei durch gestrichelte Bindungen jeweils die Bindung an das Metall bzw. an das Brückenkopfkohlenstoffatom angedeutet sind, Z bei jedem Auftreten gleich oder verschieden für CR² oder N steht, wobei maximal eine Gruppe Z für N steht, und die weiteren Symbole die oben genannten Bedeutungen aufweisen.

Bevorzugte Reste R¹ an Ar¹ bzw. Ar² bzw. an den aromatischen Gruppen des Brückenkopfes sind bei jedem Auftreten gleich oder verschieden ausgewählt aus der Gruppe bestehend aus H, D, F, N(R²)₂, CN, C(=O)R², einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, die jeweils mit einem oder mehreren Resten R² substituiert sein kann, wobei ein oder mehrere H-Atome durch D oder F ersetzt sein können, oder einem aromatischen oder heteroaromatischen Ringsystem mit 5 bis 30 aromatischen Ringatomen, das jeweils durch einen oder mehrere Reste R² substituiert sein kann. Besonders bevorzugt sind diese Reste R¹ bei jedem Auftreten gleich oder verschieden ausgewählt aus der Gruppe bestehend aus H, D, F, N(R²)₂, einer geradkettigen Alkylgruppe mit 1 bis 6 C-Atomen oder einer verzweigten oder cyclischen Alkylgruppe mit 3 bis 10 C-Atomen, wobei ein oder mehrere H-Atome durch D oder F ersetzt sein können, oder einem aromatischen oder heteroaromatischen Ringsystem mit 5 bis 24 aromatischen Ringatomen, das jeweils durch einen oder mehrere Reste R² substituiert sein kann.

Weiterhin ist es bevorzugt, wenn eine Gruppe X in den Formeln (7) bis (59) für N steht, dass die Gruppe X bzw. Z, die diesem Stickstoffatom benachbart ist, für CR¹ (im Fall einer Gruppe X) bzw. für CR² (im Fall einer Gruppe Z) steht und R¹ bzw. R² ungleich H oder D ist und bevorzugt für eine Alkylgruppe mit 1 bis 10 C-Atomen oder ein aromatisches Ringsystem mit 5 bis 30 aromatischen Ringatomen. Dabei handelt es sich bei der Alkylgruppe bevorzugt um eine sekundäre oder tertiäre Alkylgruppe mit 3 bis 10 C-Atomen, besonders bevorzugt mit 3 bis 5 C-Atomen.

Dabei bedeutet "benachbart", dass dieses X bzw. Z direkt an den Stickstoff binden kann oder dass es sich um die nächstmögliche Position handelt, in der ein X vorhanden ist. Dies wird anhand von einem spezifischen Liganden in der folgenden schematischen Darstellung nochmals erläutert:

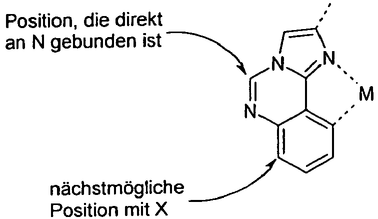

In dieser Darstellung ist sowohl die Position markiert, welche direkt an den Stickstoff gebunden ist, wie auch die nächstmögliche Position, in der ein X vorhanden ist. Beide Positionen gelten im Sinne der vorliegenden Anmeldung als benachbarte Positionen zu dem Stickstoffatom.

Weiterhin ist es bevorzugt, wenn eine Gruppe Z in den Formeln (49) bis (55) für N steht, dass die Gruppe X bzw. Z, die diesem Stickstoffatom benachbart ist, für CR¹ (im Fall einer Gruppe X) bzw. für CR² (im Fall einer Gruppe Z) steht und R¹ bzw. R² ungleich H oder D ist und bevorzugt für eine Alkylgruppe mit 1 bis 10 C-Atomen oder ein aromatisches Ringsystem mit 5 bis 30 aromatischen Ringatomen. Dabei handelt es sich bei der Alkylgruppe bevorzugt um eine sekundäre oder tertiäre Alkylgruppe mit 3 bis 10 C-Atomen, besonders bevorzugt mit 3 bis 5 C-Atomen.

Wenn die Gruppe Y für eine Gruppe CR₂ oder SiR₂ steht, dann steht die Gruppe R gleich oder verschieden bei jedem Auftreten bevorzugt für eine geradkettige Alkylgruppe mit 1 bis 10 C-Atomen oder eine Alkenylgruppe mit 2 bis 10 C-Atomen oder eine verzweigte oder cyclische Alkylgruppe mit 3 bis 10 C-Atomen, die jeweils mit einem oder mehreren Resten R² substituiert sein kann, wobei ein oder mehrere H-Atome durch D oder F ersetzt sein können, oder ein aromatisches oder heteroaromatisches Ringsystem mit 5 bis 18 aromatischen Ringatomen, das jeweils durch einen oder mehrere Reste R² substituiert sein kann und das bevorzugt keine kondensierten Aryl- oder Heteroarylgruppen enthält; dabei können zwei oder mehrere Reste R, welche an dasselbe Kohlenstoff- bzw. Siliciumatom binden, auch miteinander ein mono- oder polycyclisches, aliphatisches oder aromatisches Ringsystem bilden. Besonders bevorzugte Reste R sind bei jedem Auftreten gleich oder verschieden ausgewählt aus der Gruppe bestehend aus H, einer geradkettigen Alkylgruppe mit 1 bis 5 C-Atomen, insbesondere Methyl, oder einer verzweigten oder cyclischen Alkylgruppe mit 3 bis 5 C-Atomen, insbesondere iso-Propyl oder tert-Butyl, wobei ein oder mehrere H-Atome durch D oder F ersetzt sein können, oder einem aromatischen oder heteroaromatischen Ringsystem mit 5 bis 12 aromatischen Ringatomen, das keine kondensierten Aryl- oder Heteroarylgruppen enthält und das jeweils durch einen oder mehrere Reste R² substituiert sein kann; dabei können zwei Reste R, die an dasselbe Kohlenstoff- bzw. Siliciumatom binden, auch miteinander ein mono- oder polycyclisches, aliphatisches oder aromatisches Ringsystem bilden.

Wenn die Reste R, die an dasselbe Kohlenstoff- bzw. Siliciumatom binden, miteinander ein Ringsystem bilden, dann handelt es sich in einer bevorzugten Ausführungsform der Erfindung um eine Struktur der folgenden Formel (a), Formel (b) oder Formel (c), 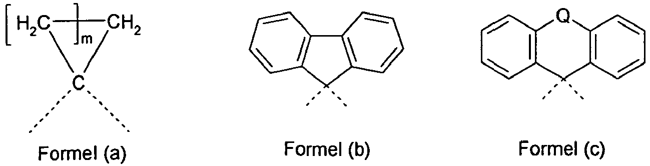 wobei Q für C(R²)₂, NR², O oder S steht, die Strukturen auch durch einen oder mehrere Reste R² substituiert sein können und m für 1, 2, 3, 4 oder 5 steht, bevorzugt für 3 oder 4. Die gestrichelt dargestellten Bindungen stehen dabei für die Bindung dieser Gruppe Y an den Brückenkopf. Dabei sind die Phenylgruppen in den Formeln (b) und (c) bevorzugt unsubstituiert.

Wenn die Gruppe Y für eine Gruppe NR, BR, PR oder P(=O)R steht, dann steht die Gruppe R bevorzugt für ein aromatisches oder heteroaromatisches Ringsystem mit 5 bis 18 aromatischen Ringatomen, das jeweils durch einen oder mehrere Reste R² substituiert sein kann und das bevorzugt keine kondensierten Aryl- oder Heteroarylgruppen enthält. Besonders bevorzugte aromatische oder heteroaromatische Ringsysteme sind ausgewählt aus ortho-, meta- oder para-Biphenyl, Terphenyl, Quaterphenyl, 2,4,6-Trialkylphenyl, insbesondere Mesityl, oder 2,6-Dialkylphenyl, insbesondere 2,6-Dimethylphenyl.

Wenn Y für eine Gruppe der Formel (2) steht, dann gilt bevorzugt, dass die beiden Metallkomplexe, die über den Brückenkopf miteinander verknüpft sind, gleich sind und auch gleich substituiert sind.

Die oben genannten bevorzugten Ausführungsformen sind beliebig miteinander kombinierbar. In einer besonders bevorzugten Ausführungsform der Erfindung gelten die oben genannten bevorzugten Ausführungsformen gleichzeitig.

In einer bevorzugten Ausführungsform der Erfindung sind daher die Verbindungen gemäß Formel (1) bzw. (3) bis (6) bzw. (3a) bis (6a) ungeladen, und es gilt:
- M: ist ausgewählt aus der Gruppe bestehend aus Pt(II), Pd(11), Ni(II), Rh(I), Ir(I) und Au(III);
- Y: ist ausgewählt aus der Gruppe bestehend aus CR₂, C=O, NR, O und S;
- X: ist gleich oder verschieden bei jedem Auftreten CR¹ oder N, wobei maximal zwei Symbole X pro Cyclus für N und die weiteren Symbole X stehen für CR¹;
- Ar¹: ist gleich oder verschieden bei jedem Auftreten ausgewählt aus den Strukturen der oben genannten Formeln (7) bis (26);
- Ar²: ist gleich oder verschieden bei jedem Auftreten ausgewählt aus den Strukturen der oben genannten Formeln (27) bis (48);
oder
- Ar¹-Ar²: ist gleich oder verschieden bei jedem Auftreten ausgewählt aus den Strukturen der oben genannten Formeln (49) bis (59);
- R¹: ist bei jedem Auftreten gleich oder verschieden ausgewählt aus der Gruppe bestehend aus H, D, F, N(R²)₂, CN, C(=O)R², einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, die jeweils mit einem oder mehreren Resten R² substituiert sein kann, wobei ein oder mehrere H-Atome durch D oder F ersetzt sein können, oder einem aromatischen oder heteroaromatischen Ringsystem mit 5 bis 30 aromatischen Ringatomen, das jeweils durch einen oder mehrere Reste R² substituiert sein kann;
- R: steht für Y = CR₂ gleich oder verschieden bei jedem Auftreten für eine geradkettige Alkylgruppe mit 1 bis 10 C-Atomen oder eine Alkenylgruppe mit 2 bis 10 C-Atomen oder eine verzweigte oder cyclische Alkylgruppe mit 3 bis 10 C-Atomen, die jeweils mit einem oder mehreren Resten R² substituiert sein kann, wobei ein oder mehrere H-Atome durch D oder F ersetzt sein können, oder ein aromatisches oder heteroaromatisches Ringsystem mit 5 bis 18 aromatischen Ringatomen, das jeweils durch einen oder mehrere Reste R² substituiert sein kann und das bevorzugt keine kondensierten Aryl- oder Heteroarylgruppen enthält; dabei können zwei oder mehrere Reste R, welche an dasselbe Kohlenstoff- bzw. Siliciumatom binden, auch miteinander ein mono- oder polycyclisches, aliphatisches oder aromatisches Ringsystem bilden, wodurch ein Spirosystem entsteht; und steht für Y = NR für ein aromatisches oder heteroaromatisches Ringsystem mit 5 bis 18 aromatischen Ringatomen, das jeweils durch einen oder mehrere Reste R² substituiert sein kann und das bevorzugt keine kondensierten Aryl- oder Heteroarylgruppen enthält.

In einer besonders bevorzugten Ausführungsform der Erfindung sind daher die Verbindungen gemäß Formel (1) bzw. (3) bis (6) bzw. (3a) bis (6a) ungeladen, und es gilt:
- M: ist ausgewählt aus der Gruppe bestehend aus Pt(II), Ir(I) und Au(III), insbesondere Pt(II);
- Y: ist ausgewählt aus der Gruppe bestehend aus CR₂, NR und S;
- X: ist gleich oder verschieden bei jedem Auftreten CR¹ oder N, wobei maximal ein Symbol X pro Cyclus für N steht und die weiteren Symbole X für CR¹ stehen und bevorzugt alle Symbole X für CR¹ stehen.
- Ar¹: ist gleich oder verschieden bei jedem Auftreten ausgewählt aus den Strukturen der oben genannten Formeln (7), (8), (9), (10), (13) und (14);
- Ar²: ist gleich oder verschieden bei jedem Auftreten ausgewählt aus den Strukturen der oben genannten Formeln (27), (28), (30), (31), (32), (34), (35), (36), (39), (40), (43), (44), (46) und (47);
oder
- Ar¹-Ar²: ist gleich oder verschieden bei jedem Auftreten ausgewählt aus den Strukturen der oben genannten Formeln (49) bis (59);
- R¹: ist bei jedem Auftreten gleich oder verschieden ausgewählt aus der Gruppe bestehend aus H, D, F, N(R²)₂, einer geradkettigen Alkylgruppe mit 1 bis 6 C-Atomen oder einer verzweigten oder cyclischen Alkylgruppe mit 3 bis 10 C-Atomen, wobei ein oder mehrere H-Atome durch D oder F ersetzt sein können, oder einem aromatischen oder heteroaromatischen Ringsystem mit 5 bis 24 aromatischen Ringatomen, das jeweils durch einen oder mehrere Reste R² substituiert sein kann;
- R: steht für Y = CR₂ gleich oder verschieden bei jedem Auftreten für eine geradkettige Alkylgruppe mit 1 bis 5 C-Atomen, insbesondere Methyl, oder eine verzweigte oder cyclische Alkylgruppe mit 3 bis 5 C-Atomen, insbesondere iso-Propyl oder tert-Butyl, wobei ein oder mehrere H-Atome durch D oder F ersetzt sein können, oder ein aromatisches oder heteroaromatisches Ringsystem mit 5 bis 12 aromatischen Ringatomen, das keine kondensierten Aryl- oder Heteroarylgruppen enthält und das jeweils durch einen oder mehrere Reste R² substituiert sein kann; dabei können zwei Reste R, die an dasselbe Kohlenstoff- bzw. Siliciumatom binden, auch miteinander ein mono- oder polycyclisches, aliphatisches oder aromatisches Ringsystem bilden, wodurch ein Spirosystem entsteht; und steht für Y = NR für ein aromatisches oder heteroaromatisches Ringsystem mit 5 bis 18 aromatischen Ringatomen, das jeweils durch einen oder mehrere Reste R² substituiert sein kann und das keine kondensierten Aryl- oder Heteroarylgruppen enthält.

Die Liganden der erfindungsgemäßen Verbindungen können gemäß Schema 1 dargestellt werden. ortho-Halogen-funktionalisierte Pyridinketone werden mit Organometallverbindungen zu den entsprechenden Triarylmethanolen umgesetzt, die dann in einem zweiten Schritt säurekatalysiert zu den entsprechenden Spiroverbindungen cyclisiert werden. Eine anschließende Ullmann- oder Suzuki-Kupplung ergibt die Liganden, die mit geeigneten Metall-Precursoren zu den erfindungsgemäßen Metallkomplexen umgesetzt werden können. Dabei ist in den folgenden Schemata exemplarisch die Synthese der Platinkomplexe dargestellt.

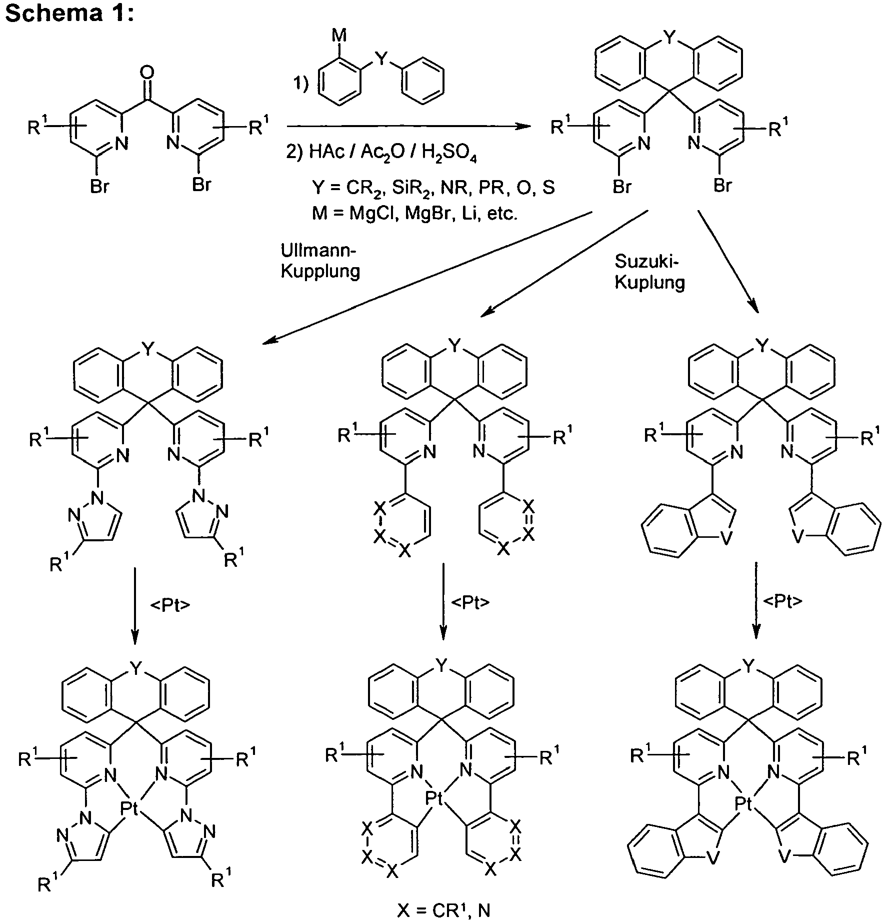

Analog können auch Ketone, die die beiden Teilliganden bereits tragen, mit Organometallverbindungen zu den entsprechenden Triarylmethanolen umgesetzt werden, die dann in einem zweiten Schritt säurekatalysiert zu den entsprechenden Spiroverbindungen cyclisiert werden, wie dies in Schema 2 exemplarisch an Phenanthridin-Derivaten gezeigt ist. Die dazu verwendeten Ketone können nach dem Fachmann geläufigen Methoden, z. B. aus Arylheteroarylhalogeniden und C1-Elektrophilen, dargestellt werden. Auf diesem Wege sind aus unsymmetrischen Ketonen unsymmetrische Metallkomplexe zugänglich.

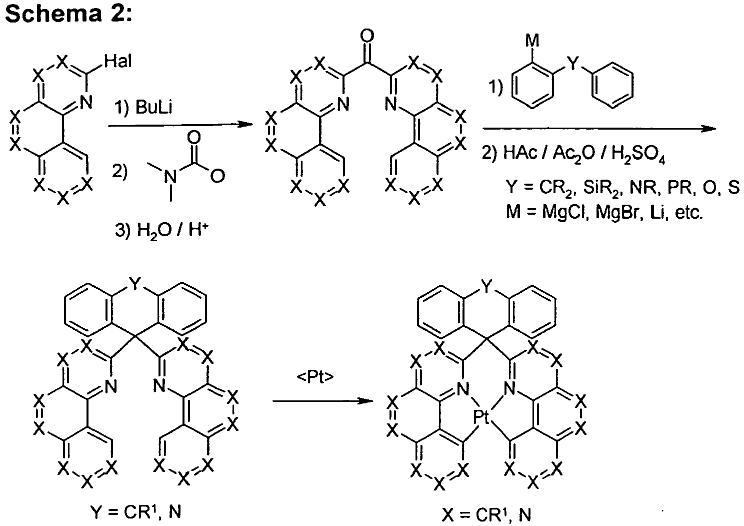

Geht man von 3,3'-Diarylketonen aus, so sind gemäß Schema 3 Metallkomplexe zugänglich, die das Spiro-verbrückende C-Atom am o-metallierten Aromaten tragen.

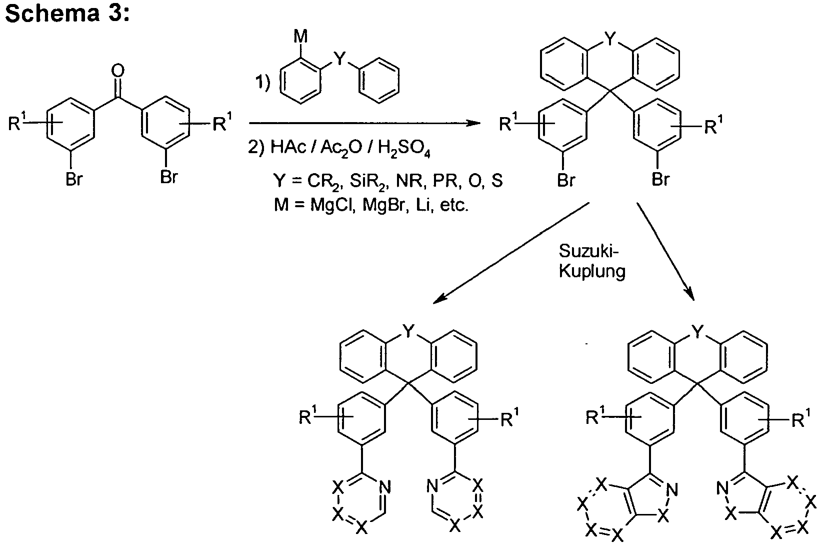

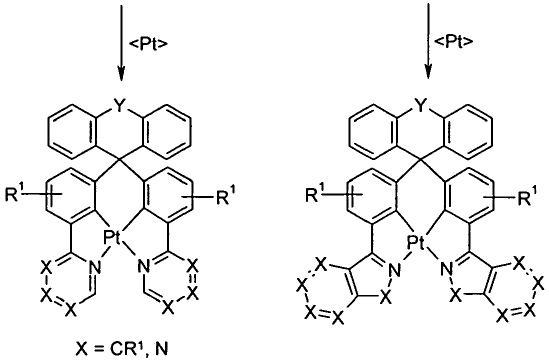

Ein weiterer Gegenstand der vorliegenden Erfindung ist ein Verfahren zur Herstellung der Verbindungen gemäß Formel (1) durch Umsetzung des entsprechenden freien Liganden mit einer geeigneten Metallverbindung. Geeignete Platinedukte sind beispielsweise PtCl₂, K₂[PtCl₄], PtCl₂(DMSO)₂, Pt(Me)₂(DMSO)₂, PtCl₂(Benzonitril)₂, PtCl₂(Acetonitril)₂ oder Pt-Olefin-Komplexe, wie z. B. (COD)PtCl₂. Geeignete Iridiumedukte sind beispielsweise Iridium(III)chlorid-Hydrat, Iridium-Olefin-Komplexe, beispielsweise mit COD als Ligand, Ir(acac)₃, Ir(tBu-acac)₃ oder Vaskas Komplex. Geeignete Goldedukte sind beispielsweise AuCl₃ oder HAuCl₄.

Die Synthese kann auch thermisch, photochemisch und/oder durch Mikrowellenstrahlung aktiviert werden. In einer möglichen Ausführungsform der Erfindung wird die Reaktion ohne die Verwendung eines zusätzlichen Lösemittels in der Schmelze durchgeführt. Dabei bedeutet "Schmelze", dass der Ligand geschmolzen vorliegt und das Metalledukt in dieser Schmelze gelöst oder suspendiert ist. In einer weiteren bevorzugten Ausführungsform der Erfindung wird der entsprechende freie Ligand mit dem Metalledukt, beispielsweise K₂PtCl₄, in Eisessig umgesetzt.

Durch diese Verfahren, gegebenenfalls gefolgt von Aufreinigung, wie z. B. Umkristallisation oder Sublimation, lassen sich die erfindungsgemäßen Verbindungen gemäß Formel (1) in hoher Reinheit, bevorzugt mehr als 99 % (bestimmt mittels ¹H-NMR und/oder HPLC) erhalten.

Beispiele für geeignete erfindungsgemäße Verbindungen sind die in der folgenden Tabelle aufgeführten Strukturen.

| | | |
|---|---|---|
| 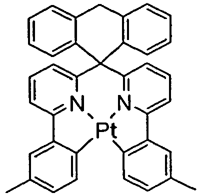 | 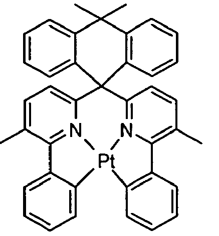 | 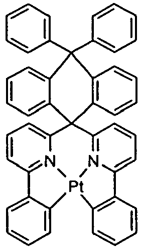 |
| (1) | (2) | (3) |
| 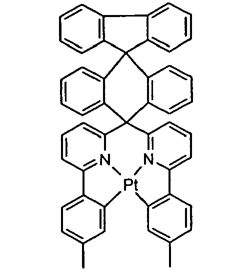 | 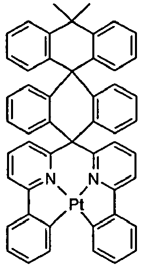 | 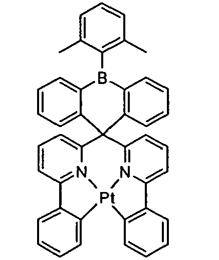 |
| (4) | (5) | (6) |
| 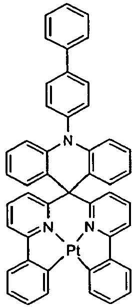 | 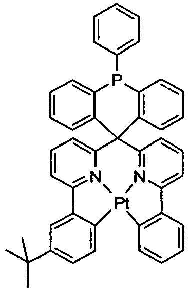 | 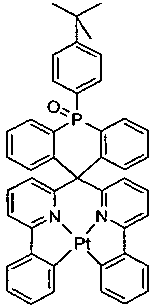 |
| (7) | (8) | (9) |
| 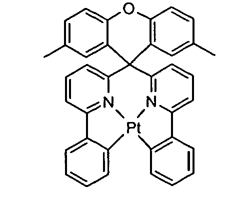 | 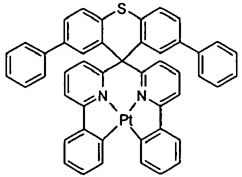 | 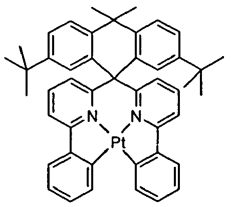 |
| (10) | (11) | (12) |
| 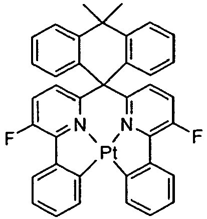 | 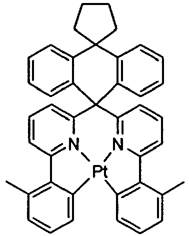 | 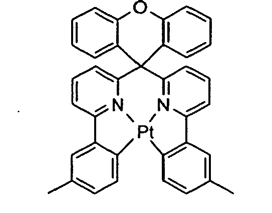 |
| (13) | (14) | (15) |
| 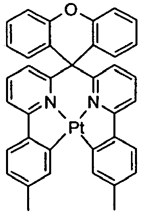 | 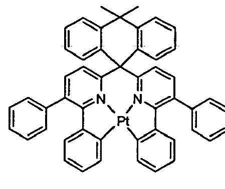 1 | 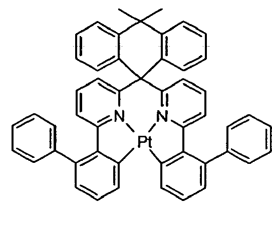 |
| (16) | (17) | (18) |
| 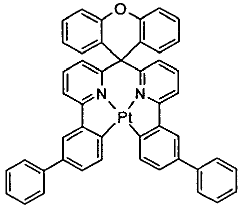 | 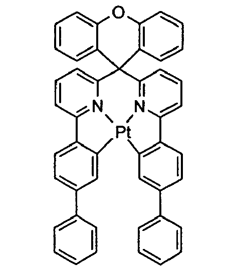 | 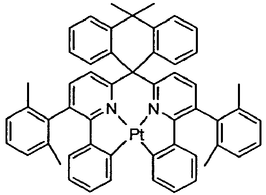 |
| (19) | (20) | (21) |
| 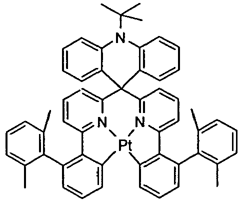 | 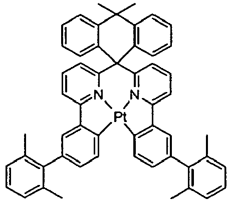 | 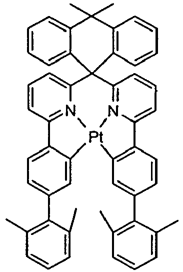 |
| (22) | (23) | (24) |
| 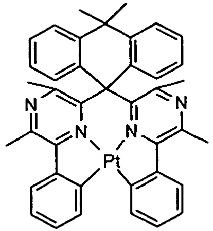 | 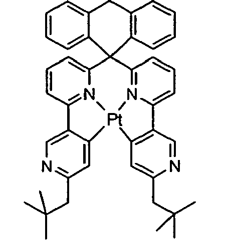 | 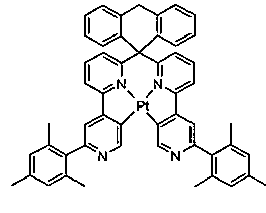 |
| (25) | (26) | (27) |
| 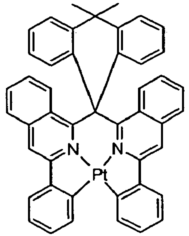 | 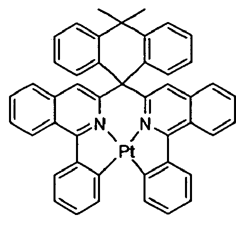 | 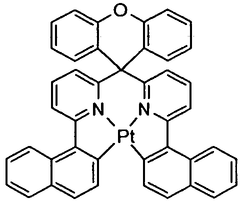 |
| (28) | (29) | (30) |
| 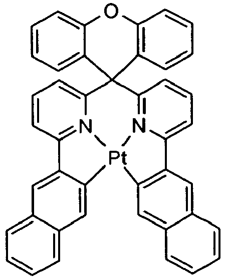 | 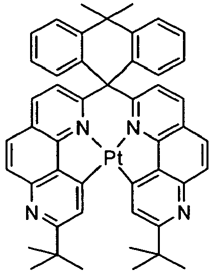 | 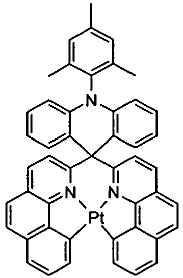 |
| (31) | (32) | (33) |
| 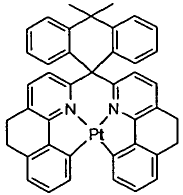 | 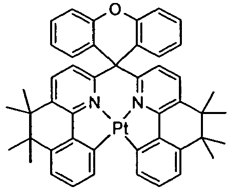 | 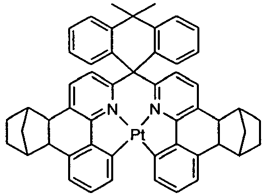 |
| (34) | (35) | (36) |
| 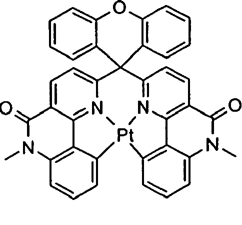 | 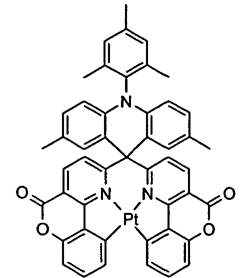 | 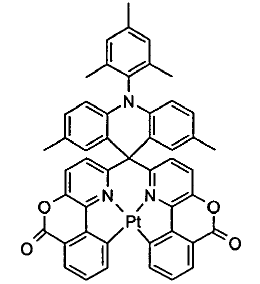 |
| (37) | (38) | (38) |
| 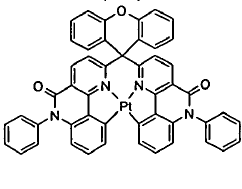 | 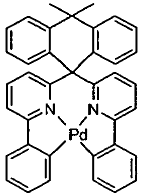 | 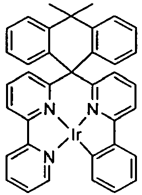 |
| (40) | (41) | (42) |
| 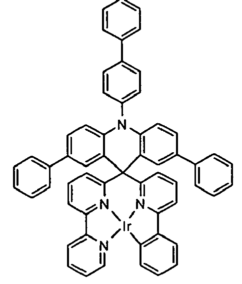 | 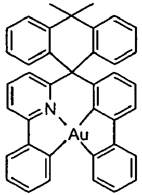 | 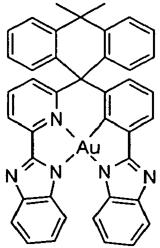 |
| (43) | (44) | (45) |
| 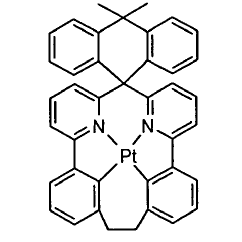 | 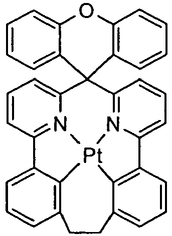 | 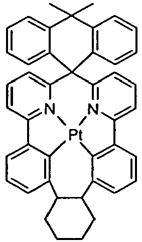 |
| (46) | (47) | (48) |
| 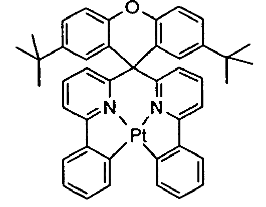 | 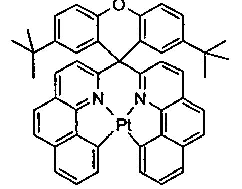 | 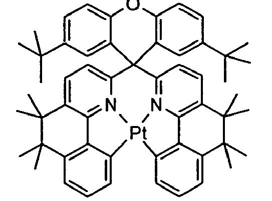 |
| (49) | (50) | (51) |
| 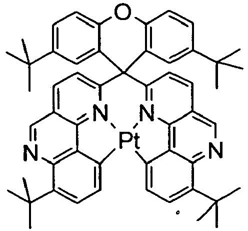 | 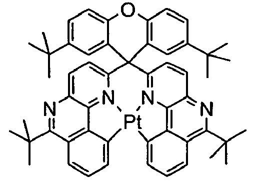 | 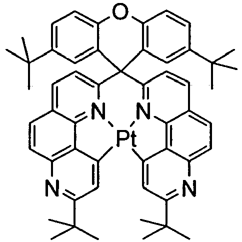 |
| (52) | (53) | (54) |
| 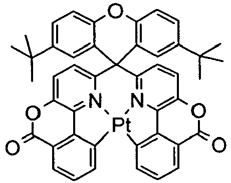 | 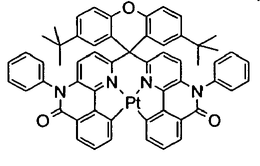 | 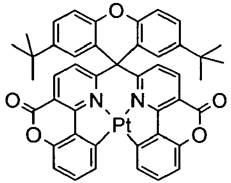 |
| (55) | (56) | (57) |
| 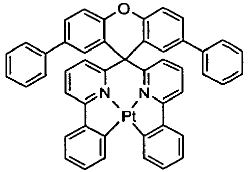 | 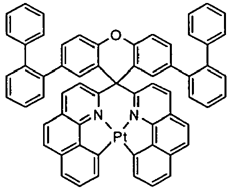 | 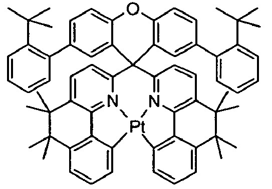 |
| (58) | (59) | (60) |
| 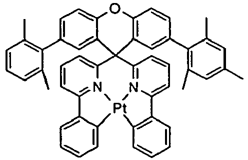 | 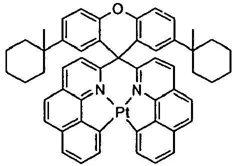 | 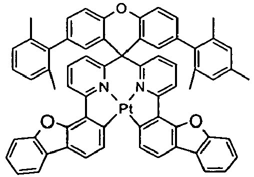 |
| (61) | (62) | (63) |
| 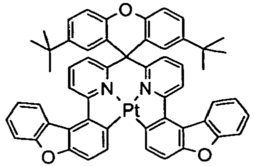 | 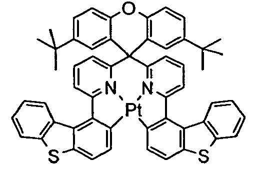 | 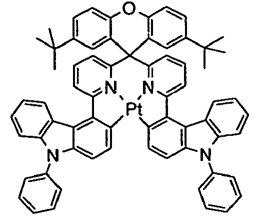 |
| (64) | (65) | (66) |
| 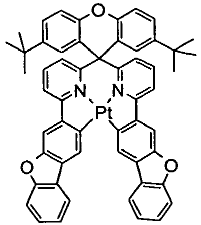 | 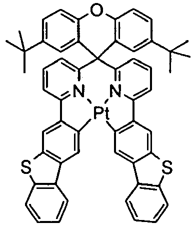 | 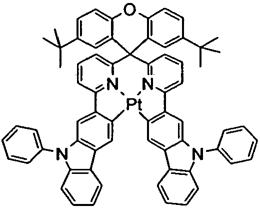 |
| (67) | (68) | (69) |
| 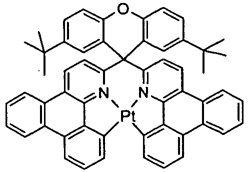 | 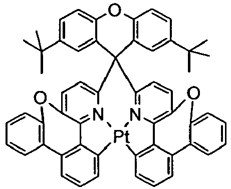 | 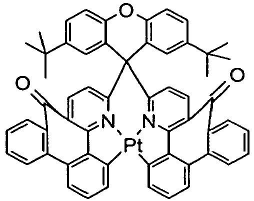 |
| (70) | (71) | (72) |
| 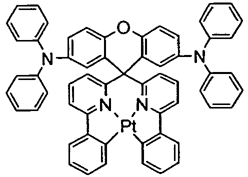 | 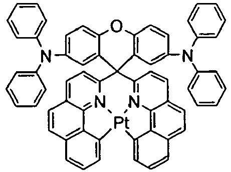 | 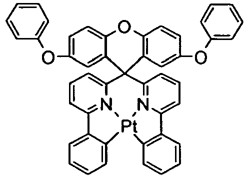 |
| (73) | (74) | (75) |
| 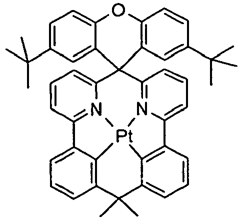 | 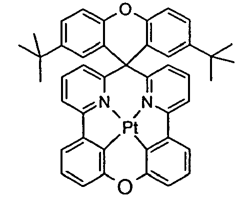 | 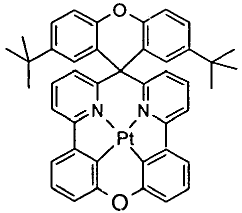 |
| (76) | (77) | (78) |
| 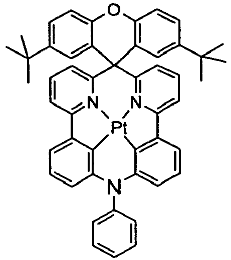 | 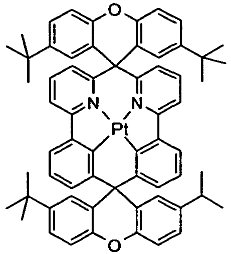 | 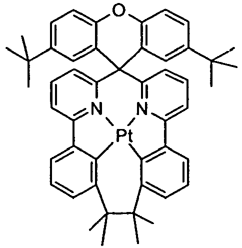 |
| (79) | (80) | (81) |
| 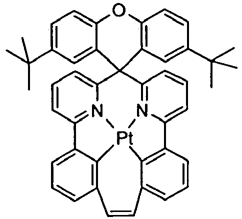 | 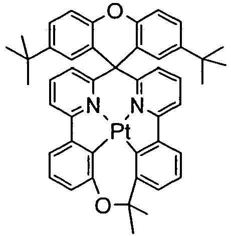 | 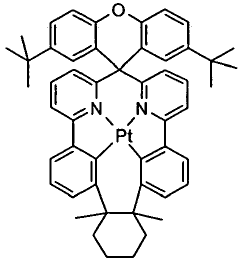 |
| (82) | (83) | (84) |
| 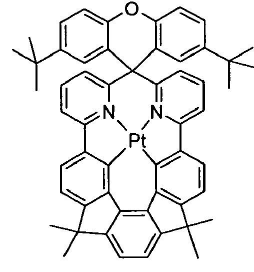 | 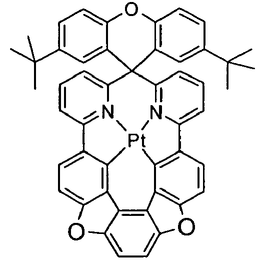 | 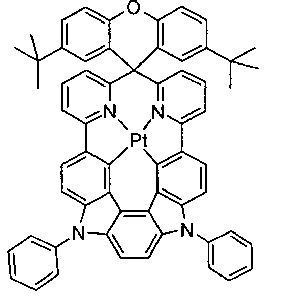 |
| (85) | (86) | (87) |
| 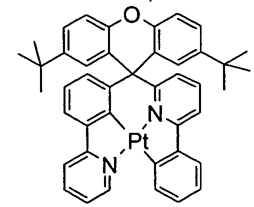 | 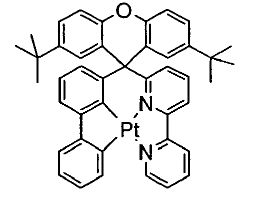 | 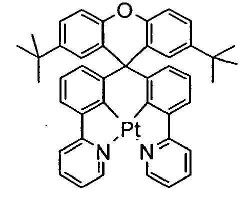 |
| (88) | (89) | (90) |
| 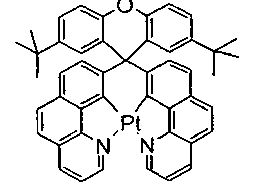 | 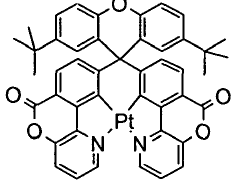 | 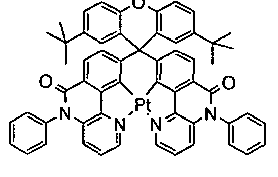 |
| (91) | (92) | (93) |
| 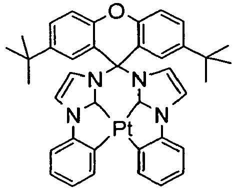 | 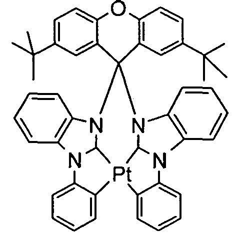 | 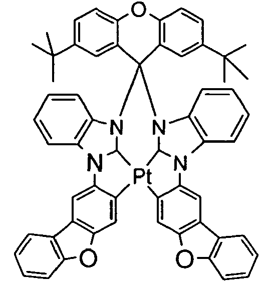 |
| (94) | (95) | (96) |
| 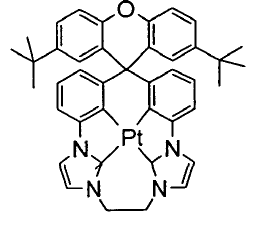 | 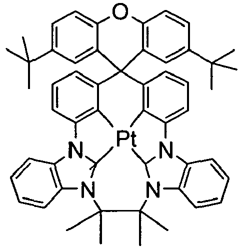 | 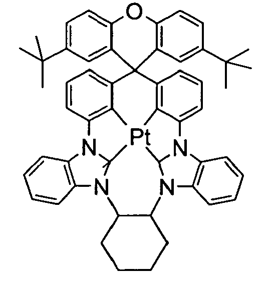 |
| (97) | (98) | (99) |
| 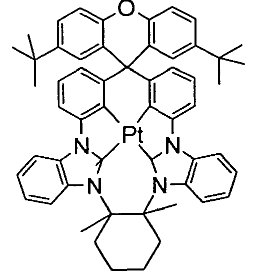 | 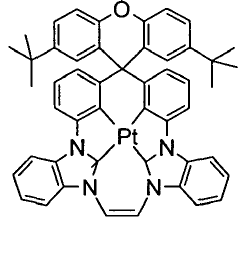 | 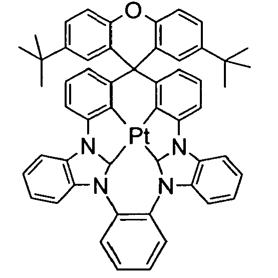 |
| (100) | (101) | (102) |

Die erfindungsgemäßen Verbindungen können auch durch geeignete Substitution, beispielsweise durch längere Alkylgruppen (ca. 4 bis 20 C-Atome), insbesondere verzweigte Alkylgruppen, oder gegebenenfalls substituierte Arylgruppen, beispielsweise Xylyl-, Mesityl- oder verzweigte Terphenyl- oder Quaterphenylgruppen, löslich gemacht werden. Solche Verbindungen sind dann in gängigen organischen Lösemitteln, wie beispielsweise Toluol oder Xylol bei Raumtemperatur in ausreichender Konzentration löslich, um die Komplexe aus Lösung verarbeiten zu können. Diese löslichen Verbindungen eignen sich besonders gut für die Verarbeitung beispielsweise durch Druckverfahren.

Ein weiterer Gegenstand der vorliegenden Erfindung ist daher eine Formulierung, insbesondere eine Lösung, eine Suspension oder eine Miniemulsion, enthaltend mindestens eine Verbindung gemäß Formel (1) bzw. die oben aufgeführten bevorzugten Ausführungsformen und mindestens ein Lösemittel.

Die oben beschriebenen Komplexe gemäß Formel (1) bzw. die oben aufgeführten bevorzugten Ausführungsformen können in einer elektronischen Vorrichtung als aktive Komponente verwendet werden. Ein weiterer Gegenstand der vorliegenden Erfindung ist daher die Verwendung einer Verbindung gemäß Formel (1) bzw. den oben aufgeführten bevorzugten Ausführungsformen in einer elektronischen Vorrichtung. Ein weiterer Gegenstand der vorliegenden Erfindung ist die Verwendung einer Verbindung gemäß Formel (1) bzw. den oben aufgeführten bevorzugten Ausführungsformen zur Erzeugung von Singulett-Sauerstoff bzw. in einem Sauerstoffsensor.

Nochmals eine weiterer Gegenstand der vorliegenden Erfindung ist eine elektronische Vorrichtung enthaltend mindestens eine Verbindung gemäß Formel (1) bzw. gemäß den oben aufgeführten bevorzugten Ausführungsformen. Die erfindungsgemäße elektronische Vorrichtung enthält Anode, Kathode und mindestens eine Schicht, welche mindestens eine Verbindung der oben aufgeführten Formel (1) enthält. Dabei sind bevorzugte elektronische Vorrichtungen ausgewählt aus der Gruppe bestehend aus organischen Elektrolumineszenzvorrichtungen (OLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen optischen Detektoren, organischen Photorezeptoren, organischen Feld-Quench-Devices (O-FQDs), lichtemittierenden elektrochemischen Zellen (LECs), organischen Laserdioden (O-Laser) oder Sauerstoff-Sensoren, enthaltend in mindestens einer Schicht mindestens eine Verbindung gemäß der oben aufgeführten Formel (1) bzw. gemäß den oben aufgeführten bevorzugten Ausführungsformen. Besonders bevorzugt sind organische Elektrolumineszenzvorrichtungen. Als aktive Komponente werden generell die organischen oder anorganischen Materialien bezeichnet, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Die erfindungsgemäßen Verbindungen zeigen besonders gute Eigenschaften als Emissionsmaterial in organischen Elektrolumineszenzvorrichtungen. Eine bevorzugte Ausführungsform der Erfindung sind daher organische Elektrolumineszenzvorrichtungen.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten und/oder organische oder anorganische p/n-Übergänge. Ebenso können zwischen zwei emittierende Schichten Zwischenschichten eingebracht sein, welche beispielsweise eine Exzitonenblockierende Funktion aufweisen und/oder die Ladungsbalance in der Elektrolumineszenzvorrichtung steuern. Es sei aber darauf hingewiesen, dass nicht notwendigerweise jede dieser Schichten vorhanden sein muss.

Dabei kann die organische Elektrolumineszenzvorrichtung eine oder mehrere emittierende Schicht enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen (für den prinzipiellen Aufbau siehe z. B. WO 2005/011013) bzw. Systeme, welche mehr als drei emittierende Schichten aufweisen. Es kann sich auch um ein Hybrid-System handeln, wobei eine oder mehrere Schichten fluoreszieren und eine oder mehrere andere Schichten phosphoreszieren.

In einer bevorzugten Ausführungsform der Erfindung enthält die organische Elektrolumineszenzvorrichtung die Verbindung gemäß Formel (1) bzw. die oben aufgeführten bevorzugten Ausführungsformen als emittierende Verbindung in einer oder mehreren emittierenden Schichten.

Wenn die Verbindung gemäß Formel (1) bzw. die oben aufgeführten bevorzugten Ausführungsformen als emittierende Verbindung in einer emittierenden Schicht eingesetzt wird, wird sie bevorzugt in Kombination mit einem oder mehreren Matrixmaterialien eingesetzt. Ein Matrixmaterial im Sinne der vorliegenden Erfindung ist ein Material, das in einer Emissionsschicht verwendet werden kann, um darin das emittierende Material in typischerweise einer Volumenkonzentration von < 25 % einzudotieren, das aber selbst, im Gegensatz zum eindotierten Emittermaterial, nicht signifikant zur Lichtemission beiträgt. Welche Materialien in einer Emitterschicht signifikant zur Lichtemission beitragen und welche nicht, und welche Materialien damit als Emitter und welche als Matrixmaterialien anzusehen sind, kann durch einen Vergleich des Elektrolumineszenzspektrums der OLED, in der die Emitterschicht vorhanden ist, mit Photolumineszenzspektren der einzelnen Materialien erkannt werden. Die Mischung aus der Verbindung gemäß Formel (1) bzw. den oben aufgeführten bevorzugten Ausführungsformen und dem Matrixmaterial enthält zwischen 0.1 und 99 Vol.-%, vorzugsweise zwischen 1 und 90 Vol.-%, besonders bevorzugt zwischen 3 und 40 Vol.-%, insbesondere zwischen 5 und 15 Vol.-% der Verbindung gemäß Formel (1) bzw. den oben aufgeführten bevorzugten Ausführungsformen, bezogen auf die Gesamtmischung aus Emitter und Matrixmaterial. Entsprechend enthält die Mischung zwischen 99.9 und 1 Vol.-%, vorzugsweise zwischen 99 und 10 Vol.-%. besonders bevorzugt zwischen 97 und 60 Vol.-%, insbesondere zwischen 95 und 85 Vol.-% des Matrixmaterials bezogen auf die Gesamtmischung aus Emitter und Matrixmaterial.

Als Matrixmaterial können generell alle Materialien eingesetzt werden, die gemäß dem Stand der Technik hierfür bekannt sind. Bevorzugt ist das Triplettniveau des Matrixmaterials höher als das Triplettniveau des Emitters.

Geeignete Matrixmaterialien für die erfindungsgemäßen Verbindungen sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Bis-carbazolylbiphenyl), m-CBP oder die in WO 2005/039246, US 2005/0069729, JP 2004/288381, EP 1205527, WO 2008/086851 oder US 2009/0134784 offenbarten Carbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, Dibenzofuranderivate, z. B. gemäß WO 2009/148015, oder verbrückte Carbazolderivate, z. B. gemäß US 2009/0136779, WO 2010/050778, WO 2011/042107 oder den nicht offen gelegten Anmeldungen DE 102010005697.9, DE 102010012738.8, DE 102010019306.2 und EP 11003232.3.

Es kann auch bevorzugt sein, mehrere verschiedene Matrixmaterialien als Mischung einzusetzen, insbesondere mindestens ein elektronenleitendes Matrixmaterial und mindestens ein lochleitendes Matrixmaterial. Eine bevorzugte Kombination ist beispielsweise die Verwendung eines aromatischen Ketons, eines Triazinderivats oder eines Phosphinoxidderivats mit einem Triarylaminderivat oder einem Carbazolderivat als gemischte Matrix für den erfindungsgemäßen Metallkomplex. Ebenso bevorzugt ist die Verwendung einer Mischung aus einem ladungstransportierenden Matrixmaterial und einem elektrisch inerten Matrixmaterial, welches nicht bzw. nicht in wesentlichem Maße am Ladungstransport beteiligt ist, wie z. B. in WO 2010/108579 beschrieben.

Weiterhin bevorzugt ist es, eine Mischung aus zwei oder mehr Triplett-Emittern zusammen mit einer Matrix einzusetzen. Dabei dient der TriplettEmitter mit dem kürzerwelligen Emissionsspektrum als Co-Matrix für den Triplett-Emitter mit dem längerwelligen Emissionsspektrum. So können beispielsweise die erfindungsgemäßen Komplexe gemäß Formel (1) als Co-Matrix für längerwellig emittierende Triplettemitter, beispielsweise für grün oder rot emittierende Triplettemitter, eingesetzt werden. Ebenso können die erfindungsgemäßen Komplexe als Triplettemitter zusammen mit einem kürzerwellig emittierenden Metallkomplex eingesetzt werden. Bevorzugt ist hierbei die Kombination von zwei Platinkomplexen oder die Kombination von einem Platinkomplex mit einem Iridiumkomplex.

Die erfindungsgemäßen Verbindungen lassen sich auch in anderen Funktionen in der elektronischen Vorrichtung einsetzen, beispielsweise als Lochtransportmaterial in einer Lochinjektions- oder -transportschicht, als Ladungserzeugungsmaterial oder als Elektronenblockiermaterial. Ebenso lassen sich die erfindungsgemäßen Komplexe als Matrixmaterial für andere phosphoreszierende Metallkomplexe in einer emittierenden Schicht einsetzen.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Mg/Ag, Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, BaF₂, MgO, NaF, CsF, Cs₂CO₃, etc.). Ebenso kommen hierfür organische Alkalimetallkomplexe in Frage, z. B. Liq (Lithiumchinolinat). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/NiOₓ, Al/PtOₓ) bevorzugt sein. Für einige Anwendungen muss mindestens eine der Elektroden transparent oder teiltransparent sein, um entweder die Bestrahlung des organischen Materials (O-SC) oder die Auskopplung von Licht (OLED/PLED, O-LASER) zu ermöglichen. Bevorzugte Anodenmaterialien sind hier leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere, z. B. PEDOT, PANI oder Derivate dieser Polymere.

In den weiteren Schichten können generell alle Materialien verwendet werden, wie sie gemäß dem Stand der Technik für die Schichten verwendet werden, und der Fachmann kann ohne erfinderisches Zutun jedes dieser Materialien in einer elektronischen Vorrichtung mit den erfindungsgemäßen Materialien kombinieren.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck von üblicherweise kleiner 10⁻⁵ mbar, bevorzugt kleiner 10⁻⁶ mbar aufgedampft. Es ist auch möglich, dass der Anfangsdruck noch geringer oder noch höher ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck oder Nozzle-Printing, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden.

Die organische Elektrolumineszenzvorrichtung kann auch als Hybrid-system hergestellt werden, indem eine oder mehrere Schichten aus Lösung aufgebracht werden und eine oder mehrere andere Schichten aufgedampft werden. So ist es beispielsweise möglich, eine emittierende Schicht enthaltend eine Verbindung gemäß Formel (1) und ein Matrixmaterial aus Lösung aufzubringen und darauf eine Lochblockierschicht und/oder eine Elektronentransportschicht im Vakuum aufzudampfen.

Diese Verfahren sind dem Fachmann generell bekannt und können von ihm ohne Probleme auf organische Elektrolumineszenzvorrichtungen enthaltend Verbindungen gemäß Formel (1) bzw. die oben aufgeführten bevorzugten Ausführungsformen angewandt werden.

Die erfindungsgemäßen elektronischen Vorrichtungen, insbesondere organische Elektrolumineszenzvorrichtungen, zeichnen sich durch folgende überraschende Vorteile gegenüber dem Stand der Technik aus:
1. Organische Elektrolumineszenzvorrichtungen enthaltend Verbindungen gemäß Formel (1) als emittierende Materialien weisen eine sehr gute Lebensdauer auf.
2. Organische Elektrolumineszenzvorrichtungen enthaltend Verbindungen gemäß Formel (1) als emittierende Materialien weisen gleichzeitig eine sehr gute Effizienz auf.

Insbesondere zeigen die erfindungsgemäßen Verbindungen eine Verbesserung bezüglich Effizienz und/oder Lebensdauer gegenüber Verbindungen, welche als Brückenkopf entweder eine Gruppe CR₂ enthalten, in der die beiden Gruppen R nicht miteinander einen Ring bilden, oder welche als Brückenkopf ein Fluoren enthalten, wobei die beiden Teilliganden jeweils an die 9-Position gebunden sind.

Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße elektronische Vorrichtungen herstellen und somit die Erfindung im gesamten beanspruchten Bereich ausführen.

### Beispiele:

Die nachfolgenden Synthesen werden, sofern nicht anders angegeben, unter einer Schutzgasatmosphäre in getrockneten Lösungsmitteln durchgeführt. Die Edukte können z. B. von ALDRICH bzw. ABCR bezogen werden. Die Angaben in eckigen Klammern bei den literaturbekannten Edukten beziehen sich auf die CAS-Nummern.

### A: Synthese von Synthonen

### Beispiel 1: (2-Brom-phenyl)-phenyl-(2,4,6-trimethyl-phenyl)-amin, S1

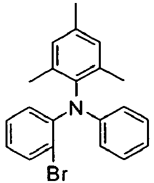

Ein Gemisch aus 21.1 g (100 mmol) Phenyl-(2,4,6-trimethylphenyl)amin [23592-67-8], 31.1 g (110 mmol) 1-Brom-2-iodbenzol [583-55-1] und 13.5 g (140 mmol) Natrium-tert-butylat in 600 ml Toluol wird mit 1.0 g (5 mmol) Tri-tert-butylphosphin und 561 mg (2.5 mmol) Palladium(II)acetat versetzt und dann 20 h unter Rückfluss erhitzt. Nach Abkühlen auf 60 °C wird die Reaktionsmischung mit 500 ml Wasser versetzt, die organische Phase wird angetrennt, zweimal mit je 300 ml Wasser gewaschen und über Magnesiumsulfat getrocknet. Nach Entfernen des Toluols im Vakuum wird der Rückstand aus Methanol unter Zusatz von wenig Ethylacetat umkristallisiert. Ausbeute: 25.7 g (70 mmol), 70 %; Reinheit ca. 96 % nach ¹H-NMR.

### Beispiel 2: Bis(2-brom-phenyl)-bis-phenyl-methan, S2

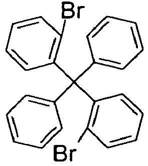

Eine Lösung von 34.0 g (100 mmol) 2,2'-Dibrombenzophenon [25187-01-3] in 500 ml THF wird tropfenweise mit 100 ml (100 mmol) einer 1 M Phenylmagnesiumbromidlösung versetzt und anschließend 3 h bei 50 °C gerührt. Nach Zugabe von 300 ml 1 N Essigsäure und 30 min. rühren bei Raumtemperatur trennt man die organische Phase ab, verdünnt mit 300 ml Ethylacetat, wäscht diese einmal mit 500 ml Wasser und einmal mit 500 ml gesättigter Kochsalzlösung, trocknet über Magnesiumsulfat und engt dann im Vakuum zur Trockene ein. Der so erhaltene Schaum wird in 300 ml Dichlormethan gelöst, mit 8.0 ml (110 mmol) Thionylchlorid und 2 Tropfen DMF versetzt und 30 min unter Rückfluss erhitzt. Nach beendeter Gasentwicklung engt man im Vakuum zu Trockene ein, nimmt den Rückstand in 27.4 ml (300 mmol) Anilin auf und erhitzt unter Rühren 5 min. auf 200 °C. Man lässt die Reaktionsmischung auf 80 °C abkühlen, gibt ein Gemisch aus 150 ml 2 N HCl und 120 ml Methanol zu und rührt 30 min. unter Rückfluss nach. Nach Erkalten saugt man vom Feststoff an, wäscht einmal mit wenig Methanol, suspendiert den Feststoff in einem Gemisch aus 200 ml Ethanol und 30 ml konz. Schwefelsäure, kühlt die Reaktionsmischung im Eis / Kochsalzbad auf -10 °C ab, gibt tropfenweise 25 ml (220 mmol) iso-Amylnitrit zu und rührt 30 min. nach. Dann versetzt man mit 50 ml 50 Gew.-%iger wässriger Hypophosphorsäure, erwärmt die Mischung langsam und rührt 30 min. unter Rückfluss nach. Nach Erkalten saugt man den Feststoff ab, wäscht diesen dreimal mit je 50 ml Ethanol und kristallisiert dann zweimal aus Dioxan um. Ausbeute: 32.6 g (68 mmol), 68 %; Reinheit ca. 97 % nach ¹H-NMR.

### Beispiel 3: 9,9-Bis(6-brom-pyridin-2-yl)-9,10-dihydroanthracen, S3

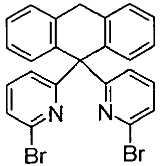

### Variante A: via Grignard-Reagenz

Aus mit lod aktivierten 2.7 g (110 mmol) Magnesiumspänen und einer Mischung aus 24.7 g (110 mmol) 2-Bromphenyl-phenyl-methan [23450-18-2], 0.8 ml 1,2-Dichlorethan, 30 ml 1,2-Dimethoxyethan und 200 ml THF wird unter Begleitheizen mit einem 70 °C warmen Ölbad das entsprechende Grignard-Reagenz dargestellt. Nachdem das Magnesium vollständig abreagiert hat, lässt man auf Raumtemperatur erkalten und tropft dann eine Lösung von 34.2 g (100 mmol) Bis-(6-brom-pyridin-2-yl)-methanon [42772-87-2] in 150 ml THF zu und rührt dann 12 h bei Raumtemperatur nach. Man gibt 100 ml Wasser zu, rührt kurz nach, trennt die organische Phase ab und entfernt das Lösungsmittel im Vakuum. Der Rückstand wird in der Wärme bei 40 °C in 500 ml Eisessig suspendiert, die Suspension wird mit 50 ml Essigsäureanhydrid und dann tropfenweise mit 10 ml konz. Schwefelsäure versetzt. Die so erhaltene Lösung wird noch 1 h bei 80 °C nachgerührt, dann wird das Lösungsmittel im Vakuum entfernt, der Rückstand wird in 500 ml Dichlormethan aufgenommen, einmal mit 500 ml 2 N NaOH, einmal mit 300 ml Wasser und einmal mit 300 ml gesättigter Kochsalzlösung gewaschen und dann über Magnesiumsulfat getrocknet. Nach Entfernen des Dichlormethans im Vakuum wird der Rückstand aus 40 ml Ethylacetat unter Zusatz von ca. 40 ml Ethanol umkristallisiert. Ausbeute: 27.6 g (56 mmol), 56 %; Reinheit ca. 98 % nach ¹H-NMR.

### Variante B: via Lithium-Reagenz

Eine auf -78 °C gekühlte Lösung von 24.7 g (110 mmol) 2-Bromphenyl-phenyl-methan [23450-18-2] in 300 ml THF wird unter Rühren tropfenweise mit 40.0 ml (100 mmol) n-Butyllithium (2.5 M in Hexan) versetzt. Man rührt 30 min. nach, tropft dann eine Lösung von 34.2 g (100 mmol) Bis-(6-brom-pyridin-2-yl)-methanon [42772-87-2] in 150 ml THF zu und lässt langsam auf Raumtemperatur erwärmen. Weitere Druchführung wie bei Variante A beschrieben. Ausbeute: 23.2 g (47 mmol), 47 %; Reinheit ca. 96 % nach ¹H-NMR.

Analog werden folgende Derivate dargestellt:

| Bsp. | Bromid Variante | Produkt | Ausbeute |
|---|---|---|---|
| 4 | 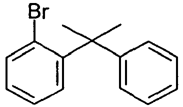 | 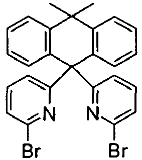 | 69 % |
| | [796966-97-7] | | |
| | A | S4 | |
| 5 | 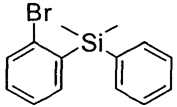 | 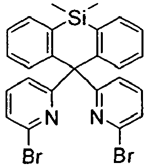 | 17 % |
| | [1160757-56-1] | | |
| | B | S5 | |
| 6 | 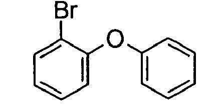 | 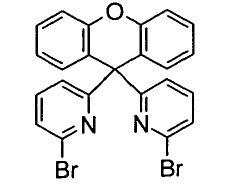 | 65 % |
| | [7025-06-1] | | |
| | A | S6 | |
| 7 | 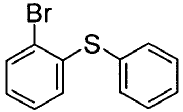 | 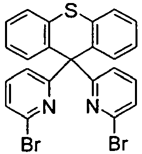 | 69 % |
| | [15861-48-0] | | |
| | B | S7 | |
| 8 | 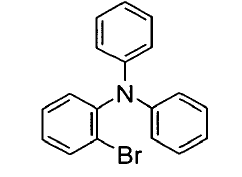 | 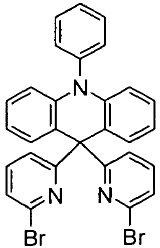 | 58 % |
| | [78600-31-4] | | |
| | B | S8 | |
| 9 | 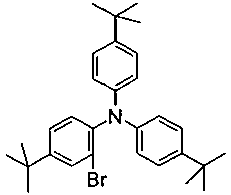 | 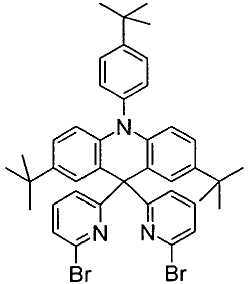 | 54 % |
| | [911830-76-7] | | |
| | B | S9 | |
| 10 | 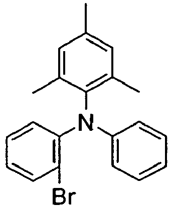 | 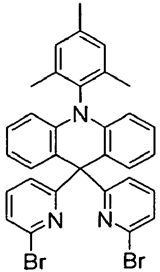 | 60 % |
| | S1 | | |
| | B | S10 | |
| 11 | 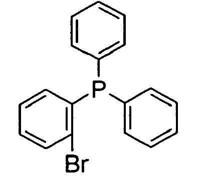 | 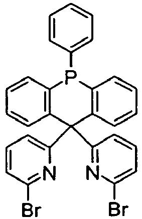 | 44 % |
| | [62336-24-7] | | |
| | B | S11 | |
| 12 | 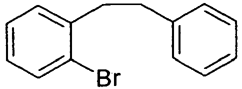 | 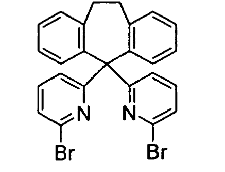 | 30% |
| | [57918-64-6] | | |
| | A | S12 | |
| 13 | 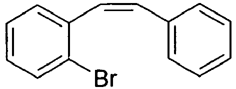 | 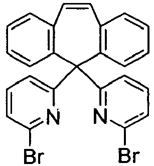 | **18%** |
| | [4877-77-4] | | |
| | B | S13 | |
| 14 | 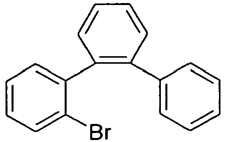 | 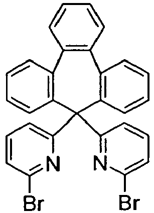 | **42%** |
| | [75295-57-7] | | |
| | A | S14 | |
| 15 | 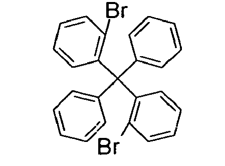 | 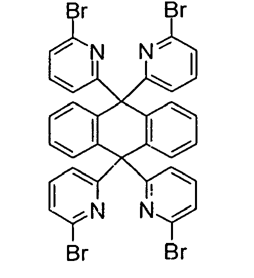 | **23%** |
| | S2 | | |
| | B | S15 | |

### Beispiel 16: 9,9-Bis(6-brom-pyridin-2-yl)-anthracen-9-on, S16

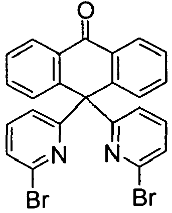

Eine gut gerührte Suspension von 49.2 g (100 mmol) 9,9-Bis(6-brom-pyridin-2-yl)-9,10-dihydroanthracen, S3 und 300 g Glaskugeln (Durchmesser 3 mm) in einem Gemisch aus 500 ml Essigsäure und 300 ml Wasser wird bei 100 °C tropfenweise mit einer Lösung von 20.0 g (200 mmol) Chromtrioxid in 200 ml Wasser versetzt. Man rührt die Reaktionsmischung 16 h bei 100 °C nach, lässt erkalten, versetzt mit 1000 ml Ethylacetat, wäscht dreimal mit je 500 ml Wasser, einmal mit 500 ml gesättigter Kochsalzlösung und trocknet die organische Phase über Magnesiumsulfat. Man entfernt das Ethylacetat im Vakuum und kristallisiert den Rückstand aus Toluol / Cyclohexan um. Ausbeute: 35.4 g (70 mmol), 70 %; Reinheit ca. 96 % nach ¹H-NMR.

### Beispiel 17: 9,9-Bis(6-brom-pyridin-2-yl)-anthracen-9-on, S17

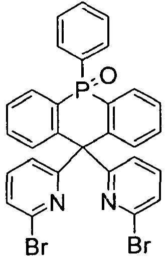

Eine Lösung von 58.6 g (100 mmol) 5,5-Bis(6-brom-pyridin-2-yl)-5,10-dihydro-10-phenylacridophosphinoxid, S11 in 500 ml Dichormethan wird unter Rühren portionsweise mit 27.1 g (110 mmol) m-Chlorperbenzoesäure, feucht, 70 %ig versetzt. Nach 16 h Nachrühren wäscht man die organsiche Phase einmal mit 500 ml 1 N NaOH und dreimal mit 300 ml Wasser und trocknet über Magnesiumsulfat. Nach Entfernen des Dichlormethans im Vakuum kristallisiert man den Rückstand aus Ethylacetat unter Zusatz von Ethanol um. Ausbeute: 47.1 g (78 mmol), 78 %; Reinheit ca. 97 % nach ¹H-NMR.

### Beispiel 18: 9,9-Bis(6-brom-pyridin-2-yl)-9,10-dihydroanthracen-10,10-spirobifluoren, S18

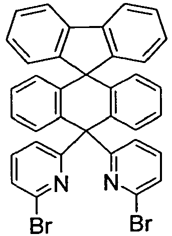

Aus mit lod aktivierten 2.7 g (110 mmol) Magnesiumspänen und einer Mischung aus 25.6 g (110 mmol) 2-Brombiphenyl, 0.8 ml 1,2-Dichlorethan, 50 ml 1,2-Dimethoxyethan, 400 ml THF und 200 ml Toluol wird unter Begleitheizen mit einem 70 °C warmen Ölbad das entsprechende Grignard-Reagenz dargestellt. Nachdem das Magnesium vollständig abreagiert hat, lässt man auf Raumtemperatur erkalten und tropft dann eine Lösung von 50.6 g (100 mmol) 9,9-Bis(6-brom-pyridin-2-yl)-anthracen-9-on, S16 in 300 ml THF zu und rührt 12 h bei Raumtemperatur nach. Man gibt 100 ml Wasser zu, rührt kurz nach, trennt die organische Phase ab und entfernt das Lösungsmittel im Vakuum. Der Rückstand wird in der Wärme bei 40 °C in 500 ml Eisessig suspendiert, die Suspension wird mit 0.2 ml konz. Schwefelsäure versetzt, und anschließend 2 h bei 100 °C nachgerührt. Dann wird das Lösungsmittel im Vakuum entfernt, der Rückstand wird in 1000 ml Dichlormethan aufgenommen, einmal mit 500 ml 2 N NaOH, einmal mit 300 ml Wasser und einmal mit 300 ml gesättigter Kochsalzlösung gewaschen und über Magnesiumsulfat getrocknet. Nach Entfernen des Dichlormethans im Vakuum wird der Rückstand aus Dioxan umkristallisiert. Ausbeute: 48.8 g (76 mmol), 76 %; Reinheit ca. 98 % n. ¹H-NMR.

### Synthese von Liganden

### Beispiel 19: L1

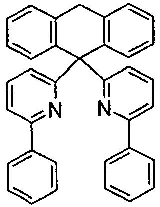

Ein gut gerührtes Gemisch aus 49.2 g (100 mmol) 9,9-Bis(6-brom-pyridin-2-yl)-9,10-dihydroanthracen, S3, 48.8 g (400 mmol) Phenylboronsäure [98-80-6], 35.0 g (600 mmol) Kaliumfluorid, wasserfrei und 700 ml THF wird mit 526 mg (2.6 mmol) Tri-tert-butylphosphin und mit 449 mg (2 mmol) Palladium(II)acetat versetzt und dann 8 h unter Rückfluss erhitzt. Nach Erkalten entfernt man das Lösungsmittel im Vakuum, nimmt den Rückstand in 500 ml Dichlormethan auf, wäscht dreimal mit je 300 ml Wasser und trocknet dann über Magnesiumsulfat. Nach Entfernen des Dichlormethans im Vakuum kristallisiert man den Rückstand aus Ethylacetat / Cyclohexan um und befreit den Feststoff anschließend durch fraktionierte Sublimation (p ca. 10⁻⁵ mbar, T ca. 260 - 280 °C) von leichtflüchtigen und nicht flüchtigen Komponenten. Ausbeute: 40.4 g (83 mmol), 83 %; Reinheit: ca. 99.0 %ig n. ¹H-NMR.

Analog werden folgende Derivate dargestellt:

| Bsp. | Bromid / Boronsäure | Ligand | Ausbeute |
|---|---|---|---|
| 20 | **S4 /** | 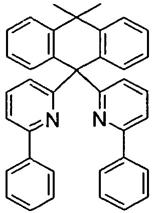 | **80 %** |
| | 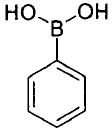 | | |
| | [98-80-6] | L2 | |
| **21** | **S4 /** | 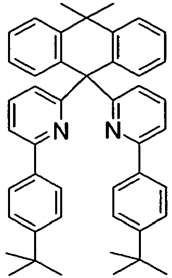 | **77 %** |
| | 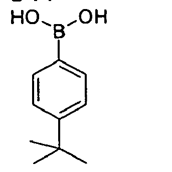 | | |
| | [123324-71-0] | L3 | |
| **22** | **S4 /** | 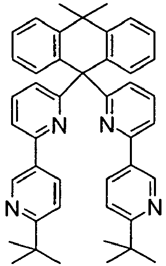 | **74 %** |
| | 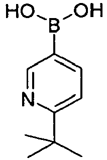 | | |
| | [1174312-53-8] | L4 | |
| **23** | **S5** | 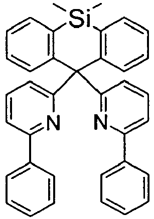 | **23 %** |
| | 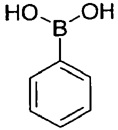 | | |
| | [98-80-6] | L5 | |
| **24** | **S6** | 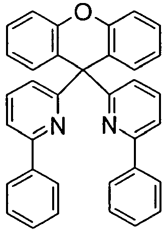 | **80 %** |
| | 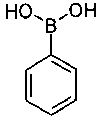 | | |
| | [98-80-6] | L6 | |
| **25** | **S6 /** | 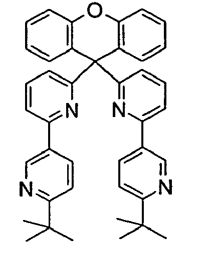 | **77 %** |
| | 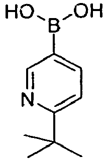 | | |
| | [1174312-53-8] | L7 | |
| **26** | **S6 /** | | **56 %** |
| | 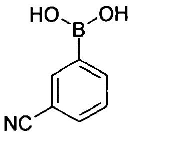 | 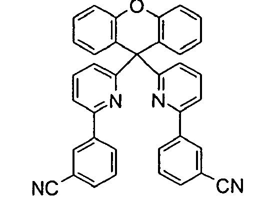 | |
| | [150255-96-2] | L8 | |
| **27** | **S6 /** | 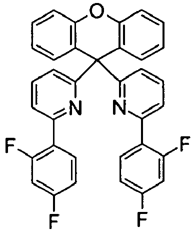 | **73 %** |
| | 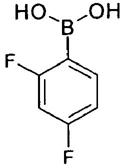 | | |
| | [144025-03-6] | L9 | |
| **28** | **S6 /** | 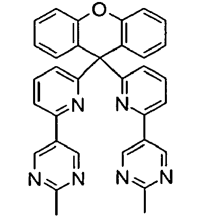 | **78 %** |
| | 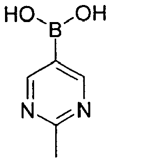 | | |
| | [1034924-06-5] | L10 | |
| **29** | **S6 /** | 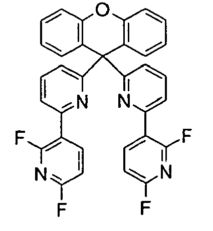 | **68 %** |
| | 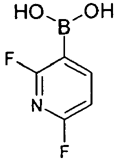 | | |
| | [136466-94-9] | L11 | |
| **30** | **S7 /** | 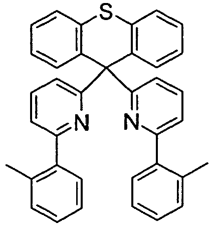 | **75 %** |
| | 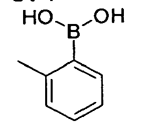 | | |
| | [16419-60-6] | L12 | |
| **31** | **S7 /** | 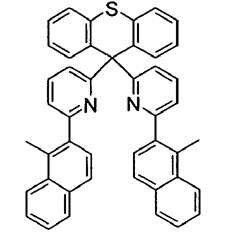 | **48 %** |
| | 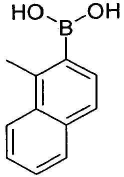 | | |
| | [590401-47-1] | L13 | |
| **32** | **S8 /** | 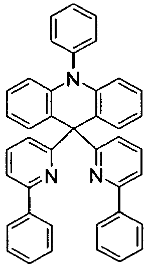 | **65 %** |
| | 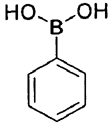 | | |
| | [98-80-6] | L14 | |
| **33** | **S8 /** | 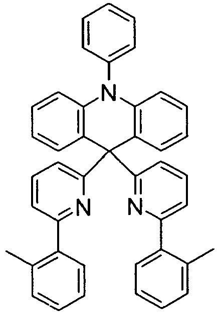 | **69 %** |
| | 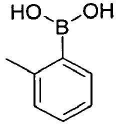 | | |
| | [16419-60-6] | L15 | |
| **34** | **S9 /** | 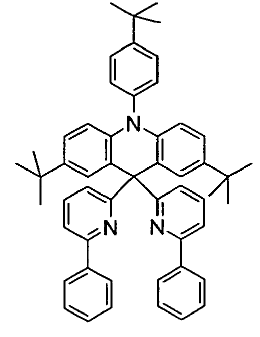 | **73 %** |
| | 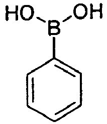 | | |
| | [98-80-6] | L16 | |
| **35** | **S10 /** | 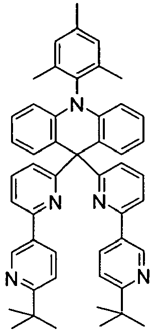 | **76 %** |
| | 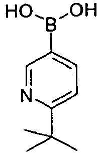 | | |
| | [1174312-53-8] | L17 | |
| **36** | **S10 /** | 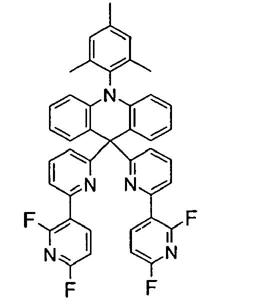 | **63 %** |
| | 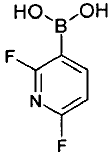 | | |
| | [136466-94-9] | L18 | |
| **37** | **S11 /** | 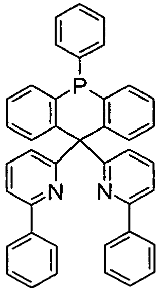 | **34 %** |
| | 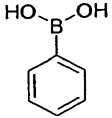 | | |
| | [98-80-6] | L19 | |
| **38** | **S12 /** | 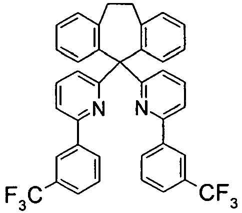 | **45 %** |
| | 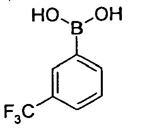 | | |
| | [1423-26-3] | L20 | |
| **39** | **S13 /** | 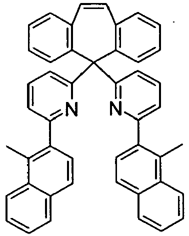 | **26 %** |
| | 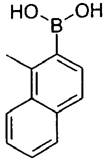 | | |
| | [590401-47-1] | L21 | |
| **40** | **S14 /** | 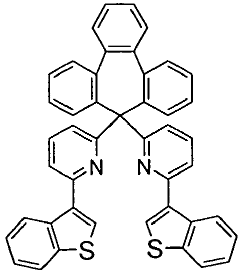 | **67 %** |
| | 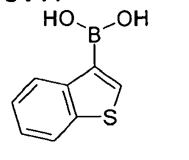 | | |
| | [113893-08-6] | L22 | |
| **41** | **S15 /** | 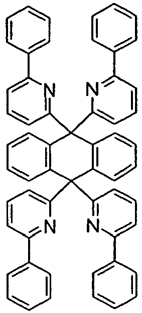 | **63 %** |
| | 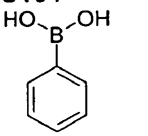 | | |
| | [98-80-6] Einsatz von 50 mmol S15 | L23 | |
| **42** | **S16 /** | 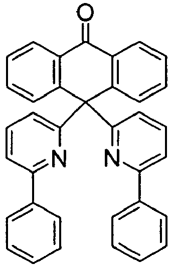 | **75 %** |
| | 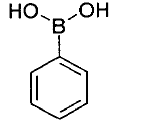 | | |
| | [98-80-6] | L24 | |
| **43** | **S16 /** | 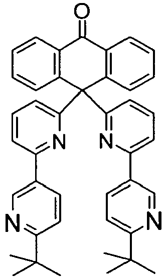 | **76 %** |
| | 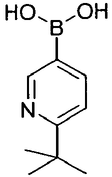 | | |
| | [1174312-53-8] | L25 | |
| **44** | **S17 /** | 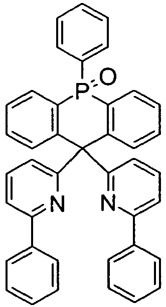 | **69 %** |
| | 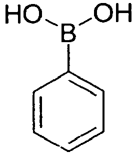 | | |
| | [98-80-6] | L26 | |
| **45** | **S18 /** | 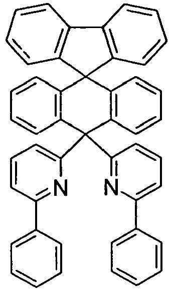 | **74 %** |
| | 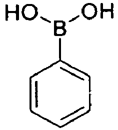 | | |
| | [98-80-6] | L27 | |

### Beispiel 46: 9,9-Bis(benzo[h]chinolin-2-yl)-10,10-dimethyl-9,10-dihydroanthracen, L28

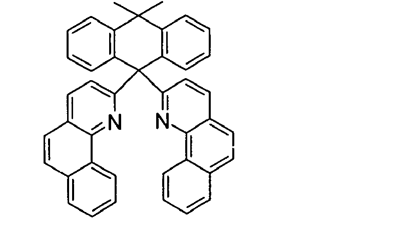

### a) Bis-benzo[h]chinolin-2-yl-methanon

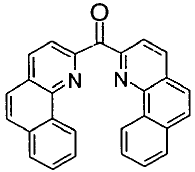

Eine auf -78 °C gekühlte Lösung von 51.6 g (200 mmol) 2-Brom-benzo[h]-chinolin [1097204-18-6] in 1000 ml THF wird tropfenweise mit 80.0 ml (200 mmol) n-Butyllithium (2.5 M in n-Hexan) versetzt und 1 h nachgerührt. Dann gibt man ein Gemisch aus 9.2 g (100 mmol) N,N-Dimethyl-carbamoylchlorid [79-44-7] und 30 ml THF unter gutem Rühren auf ein Mal zu. Man lässt die Reaktionsmischung langsam auf Raumtemperatur erwärmen, gibt ein Gemisch aus 8 ml Essigsäure und 200 ml Wasser zu, rührt 5 h bei Raumtemperatur nach, trennt die wässrige Phase ab und engt die organische Phase zur Trockene ein. Der Rückstand wird in ca. 300 ml siedendem DMF gelöst, die Lösung wird tropfenweise mit 10 ml Wasser und 1 ml Essigsäure versetzt und 2 h unter Rückfluss nachgerührt. Man lässt auf 80 °C erkalten, setzt tropfenweise 300 ml EtOH zu, lässt unter Rühren auf Raumtemperatur erkalten, saugt von den ausgefallenen Kristallen ab, wäscht diese zweimal mit ca. 50 ml EtOH und trocknet im Vakuum. Ausbeute: 26.2 g (68 mmol), 68 %; Reinheit ca. 97 % nach ¹H-NMR.

### b) L28

Durchführung analog Beispiel 3, S3, wobei anstelle von 2-Bromphenylphenyl-methan, 30.3 g (110 mmol) 1-Brom-2-(1-methyl-1-phenyl-ethyl)-benzol [796966-97-7] und anstelle von Bis-(6-brom-pyridin-2-yl)-methanon 38.4 g (100 mmol) Bis-benzo[h]chinolin-2-yl-methanon eingesetzt werden. Anschließend befreit man den Feststoff durch fraktionierte Sublimation (p ca. 10⁻⁵ mbar, T ca. 260 - 280 °C) von leichtflüchtigen und nicht flüchtigen Komponenten. Ausbeute: 23.1 g (41 mmol), 41 %; Reinheit: ca. 99.0 %ig nach ¹H-NMR.

Analog werden folgende Derivate dargestellt:

| Bsp. | Bromid / Variante | Produkt | Ausbeute |
|---|---|---|---|
| 47 | 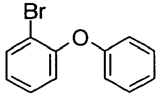 | 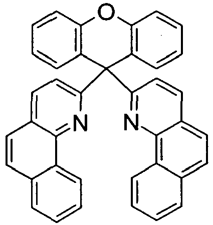 | **46 %** |
| | [7025-06-1] A | L29 | |
| 48 | 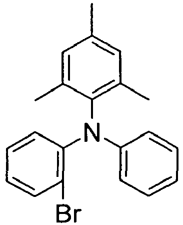 | 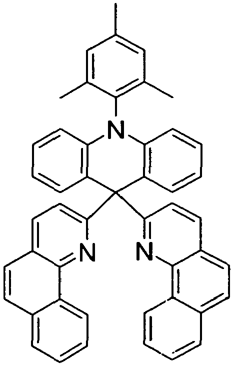 | **43 %** |
| | B | L30 | |

### Beispiel 59: L31

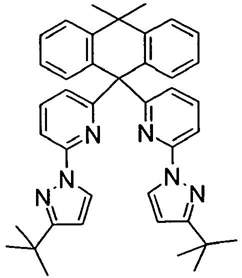

Ein Gemisch aus 52.0 g (100 mmol) S4, 31.0 g (250 mmol) 3-tert-Butyl-1 H-pyrazol [15802-80-9], 3.8 g (20 mmol) Kupfer(I)iodid, 200 g Glasperlen (Durchmesser 3 mm) und 200 ml Nitrobenzol wird 2 h auf 200 °C erhitzt. Nach Erkalten verdünnt man mit 1000 ml Dichlormethan, filtriert von den Glasperlen und den Salzen ab und engt im Vakuum zur Trockene ein. Man nimmt den Rückstand in 500 ml THF auf, filtriert über Kieselgel, um dunkle Anteile zu entfernen, engt dann auf ca. 100 ml ein, versetzt in der Wärme bis zur beginnenden Kristallisation mit Methanol (ca. 200 ml), lässt unter Rühren erkalten, saugt den Feststoff ab, wäscht diesen dreimal mit je ca. 50 ml Methanol und trocknet im Vakuum. Anschließend befreit den Feststoff durch fraktionierte Sublimation (p ca. 10⁻⁵ mbar, T ca. 260 - 280 °C) von leichtflüchtigen und nicht flüchtigen Komponenten. Ausbeute: 27.3 g (45 mmol), 45 %; Reinheit: ca. 99.0 %ig nach ¹H-NMR.

Analog wird folgendes Derivat dargestellt:

| Bsp. | Pyrazol | Produkt | Ausbeute |
|---|---|---|---|
| 50 | 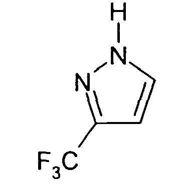 | 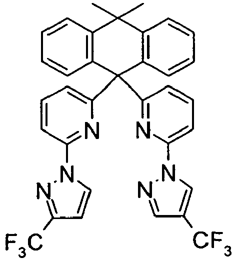 | **38 %** |
| | 7025-06-1 | L32 | |

### Synthese von Metallkomplexen

### Beispiel 51: Synthese von Platin-Komplexen

### Variante A:

Ein gut gerührtes Gemisch aus 10 mmol Kalium-tetrachloroplatinat, 10 mmol des Liganden L, 150 g Glaskugeln (Durchmesser 3 mm) und 300 ml Eisessig wird 48 bis 60 h unter Rückfluss erhitzt, bis die o-Metallierung vollständig ist. Nach tropfenweiser Zugabe eines Gemischs aus 300 ml Wasser und 300 ml Ethanol zur erkalteten Reaktionsmischung wird vom Feststoff abgesaugt, dieser wird fünfmal mit je 25 ml Ethanol gewaschen und im Vakuum getrocknet. Der Feststoff wird in 100 ml Eisessig suspendiert, die Suspension wird mit 20 ml Pyridin und 2.0 g Zinkstaub versetzt und 12 h bei 60 °C gerührt. Nach Erkalten saugt man vom Feststoff ab, wäscht diesen dreimal mit je 25 ml Ethanol und trocknet diesen im Vakuum. Der so erhaltene Feststoff wird in einem Heißextraktor auf einem 3 cm hohen Celite-Bett platziert und mit Toluol (Vorlagemenge ca. 200 ml) extrahiert. Metallkomplexe, die im Extraktionsmittel eine zu gute Löslichkeit aufweisen, werden durch Zutropfen von 200 ml Ethanol zur Kristallisation gebracht. Der Feststoff der so erhaltenen Suspensionen wird abgesaugt, einmal mit ca. 50 ml Ethanol gewaschen und getrocknet. Nach Trocknen wird die Reinheit des Metallkomplexes mittels NMR und/oder HPLC bestimmt. Liegt die Reinheit unter 99.5 % wird der Heißextraktionsschritt wiederholt; ist eine Reinheit von 99.5 - 99.9 % erreicht, wird der Pt-Komplex sublimiert. Die Sublimation erfolgt im Hochvakuum (p ca. 10⁻⁶ mbar) im Temperaturbereich von ca. 320 bis ca. 380 °C, wobei die Sublimation bevorzugt in Form einer fraktionierten Sublimation durchgeführt wird.

### Variante B:

Ein Gemisch aus 10 mmol Bis(benzonitril)-dichloro-platin(II) und 10 mmol des Liganden L in 100 ml Benzonitril wird 6 bis 48 h unter Rückfluss erhitzt, bis die o-Metallierung vollständig ist. Nach tropfenweiser Zugabe von 100 ml Ethanol zur erkalteten Reaktionsmischung wird vom Feststoff abgesaugt, dieser wird fünfmal mit je 25 ml Ethanol gewaschen und im Vakuum getrocknet. Weitere Durchführung wie unter Variante A beschrieben.

Analog werden folgende Derivate dargestellt:

| Bsp. | Ligand | Pt-Komplex / Variante | Ausbeute |
|---|---|---|---|
| 52 | 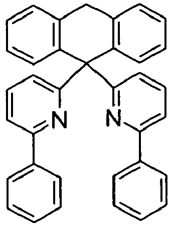 | 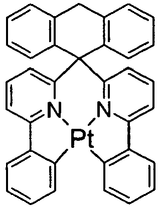 | **41 %** |
| | | **A** | |
| 53 | **L2** | **PtL2 A** | **38 %** |
| 54 | **L3** | **PtL3 A** | **37 %** |
| 55 | **L4** | **PtL4 B** | **44 %** |
| 56 | **L5** | **PtL5 B** | **13 %** |
| 57 | **L6** | **PtL6 A** | **45 %** |
| 58 | **L7** | **PtL7 B** | **47 %** |
| 59 | **L8** | **PtL8 B** | **46 %** |
| 60 | **L9** | **PtL9 B** | **43 %** |
| 61 | **L10** | **PtL10 B** | **38 %** |
| 62 | **L11** | **PtL11 B** | **28 %** |
| 63 | **L12** | **PtL12 A** | **35 %** |
| 64 | **L13** | **PtL13 A** | **38 %** |
| 65 | **L14** | **PtL14 A** | **41 %** |
| 66 | **L15** | **PtL15 A** | **44 %** |
| 67 | **L16** | **PtL16 B** | **40 %** |
| 68 | **L17** | **PtL17 B** | **36 %** |
| 69 | **L18** | **PtL18 B** | **43 %** |
| 70 | **L19** | **PtL19 A** | **38 %** |
| 71 | **L20** | **PtL20 B** | **35 %** |
| 72 | **L21** | **PtL21 B** | **16 %** |
| 73 | **L22** | **PtL22 B** | **37 %** |
| 74 | **L23 Einsatz von 20 mmol K₂PtCl₄** | 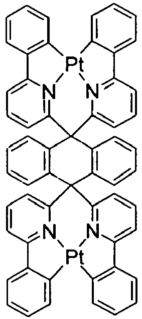 | **23 %** |
| | | **PtL23 A** | |
| 75 | **L24** | **PtL24 A** | **45 %** |
| 76 | **L25** | **PtL25 B** | **46 %** |
| 77 | **L26** | **PtL26 A** | **39 %** |
| 78 | **L27** | **PtL27 B** | **46 %** |
| 79 | **L28** | 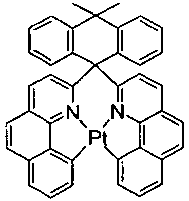 | **40 %** |
| | | **PtL28 B** | |
| 80 | **L29** | **PtL29 B** | **46 %** |
| 81 | **L30** | **PtL30 B** | **41 %** |
| 82 | **L31** | 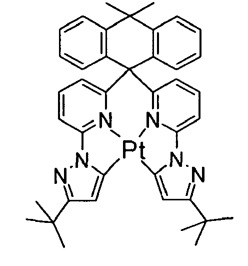 | **36 %** |
| | | **PtL31 B** | |
| 83 | **L32** | **PtL32 B** | **28 %** |

### Beispiel 84: Herstellung der OLEDs

Die Herstellung von erfindungsgemäßen OLEDs sowie OLEDs nach dem Stand der Technik erfolgt nach einem allgemeinen Verfahren gemäß WO 2004/058911, das auf die hier beschriebenen Gegebenheiten (Schichtdickenvariation, verwendete Materialien) angepasst wird.

In den folgenden Beispielen (siehe Tabellen 1 und 2) werden die Ergebnisse verschiedener OLEDs vorgestellt. Glasplättchen, die mit strukturiertem ITO (Indium Zinn Oxid) der Dicke 150 nm beschichtet sind, werden zur verbesserten Prozessierung mit 20 nm PEDOT beschichtet (Poly(3,4-ethylendioxy-2,5-thiophen), aus Wasser aufgeschleudert; bezogen von H. C. Starck, Goslar, Deutschland). Diese beschichteten

Glasplättchen bilden die Substrate, auf welche die OLEDs aufgebracht werden. Die OLEDs haben prinzipiell folgenden Schichtaufbau:

| Substrat | |
|---|---|
| Lochinjektionsschicht 1: | HIL1, 10 nm |
| Lochinjektionsschicht 2: | HIL2, 10 nm |
| Lochinjektionsschicht 3: | HIL1, 200 nm |
| Lochinjektionsschicht 4: | HIL2, 10 nm |
| Lochtransportschicht 1: | HTL1, 20 nm |
| Elektronenblockerschicht 1: | EBL1, optional, s. Tabelle 1, 10 nm |
| Emissionsschicht: | s. Tabelle 1 |
| Lochblockierschicht 1: | M1, 10 nm |
| Elektronentransportschicht : | ETM1 + LiQ, 50%:50%, 30 nm |
| Kathode: | Aluminium, 100 nm |

Für die vakuumprozessierten OLEDs werden alle Materialien in einer Vakuumkammer thermisch aufgedampft. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Coverdampfung in einem bestimmten Volumenanteil beigemischt wird. Eine Angabe wie M1:M2:PtL (55%:35%:10%) bedeutet hierbei, dass das Material M1 in einem Volumenanteil von 55%, M2 in einem Anteil von 35% und der Emitter PtL in einem Anteil von 10% in der Schicht vorliegt. Analog besteht auch die Elektronentransportschicht aus einer Mischung zweier Materialien. Der genaue Aufbau der Emissionsschicht ist Tabelle 1 zu entnehmen. Die zur Herstellung der OLEDs verwendeten Materialien sind in Tabelle 3 gezeigt.

Die OLEDs werden standardmäßig charakterisiert. Hierfür werden die Elektrolumineszenzspektren, die Stromeffizienz (gemessen in cd/A) und die Spannung (gemessen bei 1000 cd/m² in V) bestimmt aus Strom-Spannungs-Helligkeits-Kennlinien (IUL-Kennlinien). Für ausgewählte Versuche wird die Lebensdauer bestimmt. Als Lebensdauer wird die Zeit definiert, nach der die Leuchtdichte von einer bestimmten Startleuchtdichte aus auf einen gewissen Anteil abgesunken ist. Die Angabe LD50 bedeutet, dass es sich bei der genannten Lebensdauer um die Zeit handelt, bei der die Leuchtdichte auf 50 % der Startleuchtdichte abgefallen ist, also von z. B. 4000 cd/m² auf 2000 cd/m². Je nach Emissionsfarbe wurden unterschiedliche Starthelligkeiten gewählt. Die Werte für die Lebensdauer können mit Hilfe dem Fachmann bekannten Umrechnungsformeln auf eine Angabe für andere Startleuchtdichten umgerechnet werden. Hierbei ist die Lebensdauer für eine Startleuchtdichte von 1000 cd/m² eine übliche Angabe.

### Verwendung von erfindungsgemäßen Verbindungen als Emittermaterialien in phosphoreszierenden OLEDs

Die erfindungsgemäßen Verbindungen lassen sich unter anderem als phosphoreszierende Emittermaterialien in der Emissionsschicht in OLEDs einsetzen. Bei den OLEDs zeigt sich hier, dass die erfindungsgemäßen Materialien zu effizienten blau, grün bzw. rot emittierenden OLEDs führen.

**Tabelle 1: Verwendung von erfindungsgemäßen Verbindungen als Emitter in phosphoreszenten OLEDs**

| Bsp. | EBL | EML / Dicke |
|---|---|---|
| 85 | - | M1:M2:PtL1 |
| | | (80%:15%:5%) |
| | | 30 nm |
| 86 | - | M1:M2:PtL2 |
| | | (80%:15%:5%) |
| | | 30 nm |
| 87 | - | M1:M2:PtL3 |
| | | (80%:15%:5%) |
| | | 30 nm |
| 88 | 10 nm | M4:M2:PtL4 |
| | | (70%:25%:5%) |
| | | 30 nm |
| 89 | - | M1:M2:PtL5 |
| | | (75%:20%:5%) |
| | | 30 nm |
| 90 | - | M1:M2:PtL6 |
| | | (80%:15%:5%) |
| | | 30 nm |
| 91 | 10 nm | M4:M2:PtL7 |
| | | (70%:25%:5%) |
| | | 30 nm |
| 92 | - | M1:M2:PtL8 |
| | | (80%:15%:5%) |
| | | 30 nm |
| 93 | 10 nm | M4:M2:PtL9 |
| | | (75%:20%:5%) |
| | | 30 nm |
| 94 | 10 nm | M4:M2:PtL10 |
| | | (70%:25%:5%) |
| | | 30 nm |
| 95 | 10 nm | M4:M2:PtL11 |
| | | (70%:25%:5%) |
| | | 30 nm |
| 96 | - | M1:M2:PtL12 |
| | | (80%:15%:5%) |
| | | 30 nm |
| 97 | - | M1:M2:PtL13 |
| | | (80%:15%:5%) |
| | | 30 nm |
| 98 | - | M1:PtL14 |
| | | (85%:15%) |
| | | 30 nm |
| 99 | - | M1:M2:PtL15 |
| | | (80%:15%:5%) |
| | | 30 nm |
| 100 | - | M1:M2:PtL16 |
| | | (80%:15%:5%) |
| | | 30 nm |
| 101 | 10 nm | M4:M2:PtL17 |
| | | (75%:20%:5%) |
| | | 30 nm |
| 102 | 10 nm | M4:M2:PtL18 |
| | | (60%:35%:5%) |
| | | 30 nm |
| 103 | - | M1:M2:PtL19 |
| | | (80%:15%:5%) |
| | | 30 nm |
| 104 | - | M1:M2:PtL20 |
| | | (80%:15%:5%) |
| | | 30 nm |
| 105 | - | M1:M2:PtL21 |
| | | (80%:10%:10%) |
| | | 30 nm |
| 106 | - | M1:M2:PtL22 |
| | | (80%:15%:5%) |
| | | 30 nm |
| 107 | - | M1:M2:PtL23 |
| | | (80%:15%:5%) |
| | | 30 nm |
| 108 | 10 nm | M4:M2:PtL24 |
| | | (65%:30%:5%) |
| | | 30 nm |
| 109 | 10 nm | M4:M2:PtL25 |
| | | (60%:35%:5%) |
| | | 30 nm |
| 110 | 10 nm | M4:M2:PtL26 |
| | | (60%:35%:5%) |
| | | 30 nm |
| 111 | - | M1:M2:PtL27 |
| | | (80%:15%:5%) |
| | | 30 nm |
| 112 | - | M1:M2:PtL28 |
| | | (80%:15%:5%) |
| | | 30 nm |
| 113 | - | M1:M2:PtL29 |
| | | (80%:15%:5%) |
| | | 30 nm |
| 114 | - | M1:M2:PtL30 |
| | | (80%:15%:5%) |
| | | 30 nm |
| 115 | 10 nm | M4:M2:PtL31 |
| | | (60%:35%:5%) |
| | | 30 nm |
| 116 | 10 nm | M4:M2:PtL32 |
| | | (60%:35%:5%) |
| | | 30 nm |

**Tabelle 2: Verwendung von erfindungsgemäßen Verbindungen als Emitter in phosphoreszenten OLEDs**

| Bsp. | EQE [%] bei 1000 cd/m² | Spannung (V) bei 1000 cd/m² | CIE x/y bei 1000 cd/m² | LD50 (h) bei 1000 cd/m² |
|---|---|---|---|---|
| 85 | 20.0 | 3.4 | 0.32/0.64 | 800 |
| 86 | 20.3 | 3.3 | 0.32/0.64 | 34000 |
| 87 | 20.7 | 3.6 | 0.32/0.64 | 38000 |
| 88 | 14.0 | 4.8 | 0.15/0.24 | 800 |
| 89 | 18.9 | 3.5 | 0.32/0.64 | 18000 |
| 90 | 20.2 | 3.6 | 0.32/0.64 | 45000 |
| 91 | 14.8 | 4.3 | 0.16/0.27 | --- |
| 92 | 18.6 | 3.5 | 0.27/0.58 | 27000 |
| 93 | 18.1 | 4.3 | 0.16/0.34 | --- |
| 94 | 13.5 | 4.6 | 0.15/0.26 | 1600 |
| 95 | 12.9 | 4.9 | 0.15/0.24 | |
| 96 | 19.6 | 3.6 | 0.33/0.63 | 37000 |
| 97 | 14.8 | 3.5 | 0.68/0.32 | 25000 |
| 98 | 19.9 | 3.5 | 0.32/0.64 | 41000 |
| 99 | 21.0 | 3.6 | 0.32/0.64 | 43000 |
| 100 | 20.4 | 4.2 | 0.32/0.64 | 40000 |
| 101 | 16.2 | 4.3 | 0.16/0.27 | --- |
| 102 | 13.4 | 4.8 | 0.15/0.25 | --- |
| 103 | 18.8 | 3.7 | 0.32/0.64 | 29000 |
| 104 | 16.0 | 4.6 | 0.29/0.59 | --- |
| 105 | 11.2 | 3.5 | 0.68/0.32 | 17000 |
| 106 | 14.5 | 3.6 | 0.68/0.32 | --- |
| 107 | 21.4 | 3.5 | 0.33/0.63 | 44000 |
| 108 | 20.4 | 3.5 | 0.33/0.63 | 45000 |
| 109 | 11.5 | 4.5 | 0.16/0.28 | 1100 |
| 110 | 18.5 | 3.7 | 0.33/0.63 | 30000 |
| 111 | 20.4 | 4.0 | 0.33/0.63 | 39000 |
| 112 | 20.8 | 3.6 | 0.26/0.63 | 54000 |
| 113 | 21.0 | 3.7 | 0.26/0.63 | 52000 |
| 114 | 20.3 | 3.4 | 0.25/0.62 | 55000 |
| 115 | 12.0 | 4.6 | 0.15/0.25 | --- |
| 116 | 11.8 | 5.3 | 0.15/0.22 | --- |

**Tabelle 3: Strukturformeln der verwendeten Materialien**

| | |
|---|---|
| 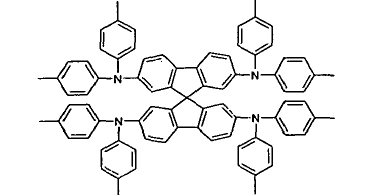 | 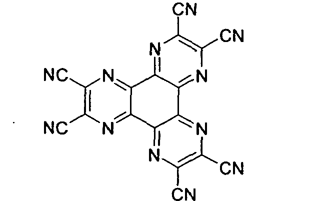 |
| HIL1 | HIL2 |
| 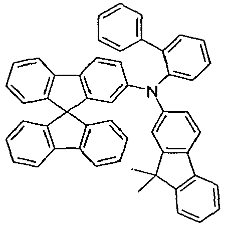 | 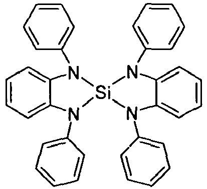 |
| HTL1 | EBL1 |
| 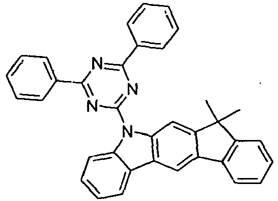 | 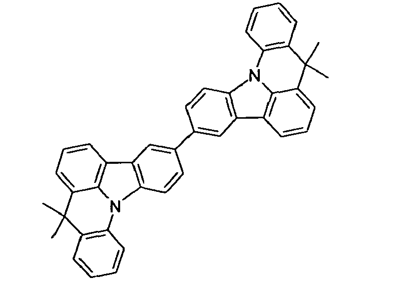 |
| M1 | M2 |
| 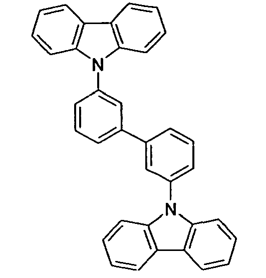 | 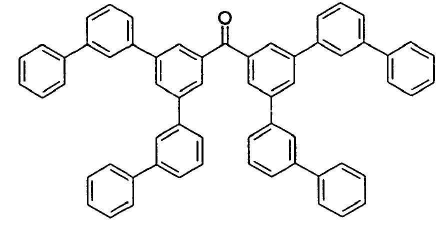 |
| M3 | M4 |
| 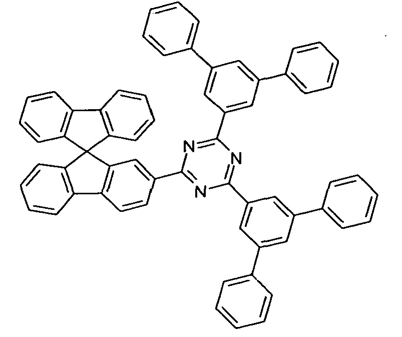 | 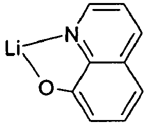 |
| ETM1 | LiQ |

## Patentansprüche

1. Verbindung gemäß Formel (1), 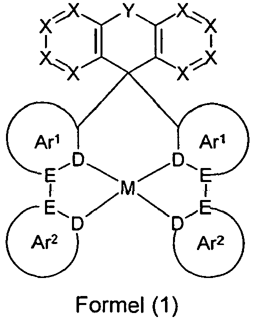 wobei für die verwendeten Symbole gilt:
M ist bei jedem Auftreten gleich oder verschieden ausgewählt aus der Gruppe bestehend aus Platin, Palladium, Nickel, Rhodium, Iridium und Gold;
X ist bei jedem Auftreten gleich oder verschieden CR¹ oder N;
Y ist CR₂, C=O, BR, SiR₂, NR, PR, P(=O)R, O, S, CR=CR, CR₂-CR₂ oder CR=N;
oder Y steht für eine Gruppe der Formel (2), 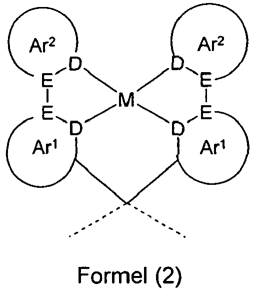 wobei die gestrichelten Bindungen die Verknüpfung dieser Gruppe andeutet;
D ist bei jedem Auftreten gleich oder verschieden C oder N;
E ist C, wenn der Cyclus, in dem dieses E gebunden ist, ein aromatischer oder heteroaromatischer Sechsring ist; bzw. ist C oder N, wenn der Cyclus, in dem dieses E gebunden ist, ein heteroaromatischer Fünfring ist;
Ar¹ ist bei jedem Auftreten gleich oder verschieden zusammen mit den Gruppen D und E eine Aryl- oder Heteroarylgruppe mit 5 bis 18 aromatischen Ringatomen, die durch einen oder mehrere Reste R¹ substituiert sein kann; dabei können benachbarte Gruppen Ar¹ und Ar² auch durch zwei Reste R¹, die miteinander verknüpft sind, oder durch eine Gruppe CR²=N miteinander verknüpft sein;
Ar² ist bei jedem Auftreten gleich oder verschieden zusammen mit den Gruppen D und E eine Aryl- oder Heteroarylgruppe mit 5 bis 18 aromatischen Ringatomen, die durch einen oder mehrere Reste R¹ substituiert sein kann; dabei können benachbarte Gruppen Ar² und Ar¹ auch durch zwei Reste R¹, die miteinander verknüpft sind, oder durch eine Gruppe CR²=N miteinander verknüpft sein;
R ist bei jedem Auftreten gleich oder verschieden H, D, F, N(R²)₂, CN, C(=O)N(R²)₂, Si(R²)₃, B(OR²)₂, C(=O)R², P(=O)(R²)₂, S(=O)R², S(=O)₂R², eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten R² substituiert sein kann, wobei eine oder mehrere nicht benachbarte CH₂-Gruppen durch R²C=CR², C≡C, Si(R²)₂, C=O, NR², O, S oder CONR² ersetzt sein können und wobei ein oder mehrere H-Atome durch D, F, Cl, Br, I oder CN ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 40 aromatischen Ringatomen, die durch einen oder mehrere Reste R² substituiert sein kann, oder eine Aralkyl- oder Heteroaralkylgruppe mit 5 bis 40 aromatischen Ringatomen, die durch einen oder mehrere Reste R² substituiert sein kann; dabei können auch zwei Reste R, die an dasselbe C- bzw. Si-Atom binden, miteinander ein mono- oder polycyclisches, aliphatisches oder aromatisches Ringsystem bilden;
R¹ ist bei jedem Auftreten gleich oder verschieden H, D, F, Cl, Br, I, N(R²)₂, CN, NO₂, OH, COOH, C(=O)N(R²)₂, Si(R²)₃, B(OR²)₂, C(=O)R², P(=O)(R²)₂, S(=O)R², S(=O)₂R², OSO₂R², eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten R² substituiert sein kann, wobei eine oder mehrere nicht benachbarte CH₂-Gruppen durch R²C=CR², C≡C, Si(R²)₂, C=O, NR², O, S oder CONR² ersetzt sein können und wobei ein oder mehrere H-Atome durch D, F, Cl, Br, I oder CN ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 40 aromatischen Ringatomen, die durch einen oder mehrere Reste R² substituiert sein kann, oder eine Aralkyl- oder Heteroaralkylgruppe mit 5 bis 40 aromatischen Ringatomen, die durch einen oder mehrere Reste R² substituiert sein kann; dabei können zwei benachbarte Reste R¹ auch miteinander ein mono- oder polycyclisches, aliphatisches oder aromatisches Ringsystem bilden; weiterhin können auch die Reste R¹, die an benachbarte Gruppen Ar¹ und Ar² binden, miteinander ein mono- oder polycyclisches, aliphatisches oder aromatisches Ringsystem bilden; weiterhin können auch zwei Reste R¹ an den beiden Gruppen Ar² miteinander ein Ringsystem bilden;
R² ist bei jedem Auftreten gleich oder verschieden H, D, F, Cl, Br, I, N(R³)₂, CN, NO₂, Si(R³)₃, B(OR³)₂, C(=O)R³, P(=O)(R³)₂, S(=O)R³, S(=O)₂R³, OSO₂R³, eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten R³ substituiert sein kann, wobei eine oder mehrere nicht benachbarte CH₂-Gruppen durch R³C=CR³, C≡C, Si(R³)₂, C=O, NR³, O, S oder CONR³ ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 40 aromatischen Ringatomen, die durch einen oder mehrere Reste R³ substituiert sein kann, oder eine Aralkyl- oder Heteroaralkylgruppe mit 5 bis 40 aromatischen Ringatomen, die durch einen oder mehrere Reste R³ substituiert sein kann; dabei können zwei oder mehrere benachbarte Reste R³ miteinander ein mono- oder polycyclisches, aliphatisches Ringsystem bilden;
R³ ist bei jedem Auftreten gleich oder verschieden H, D, F oder ein aliphatischer, aromatischer und/oder heteroaromatischer Kohlenwasserstoffrest mit 1 bis 20 C-Atomen, in dem auch ein oder mehrere H-Atome durch F ersetzt sein können; dabei können zwei oder mehrere Substituenten R³ auch miteinander ein mono- oder polycyclisches, aliphatisches Ringsystem bilden;
dabei können auch zwei Gruppen Ar² durch eine Gruppe Y miteinander verbrückt sein.

2. Verbindung nach Anspruch 1, **dadurch gekennzeichnet, dass** M ausgewählt ist aus der Gruppe bestehend aus Pt(II), Pd(II), Ni(II), Rh(I), Ir(I) und Au(III), bevorzugt Pt(II).

3. Verbindung nach Anspruch 1 oder 2, ausgewählt aus den Strukturen
der Formel (3), (4), (5) oder (6), 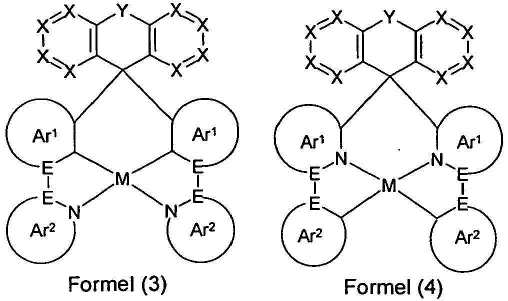 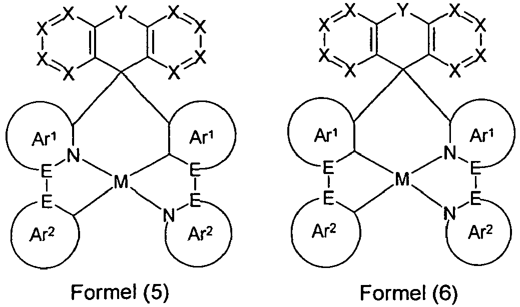 wobei die verwendeten Symbole die in Anspruch 1 genannten Bedeutungen aufweisen.

4. Verbindung nach einem oder mehreren der Ansprüche 1 bis 3, ausgewählt aus den Strukturen gemäß den Formeln (3a), (4a), (5a) und (6a), 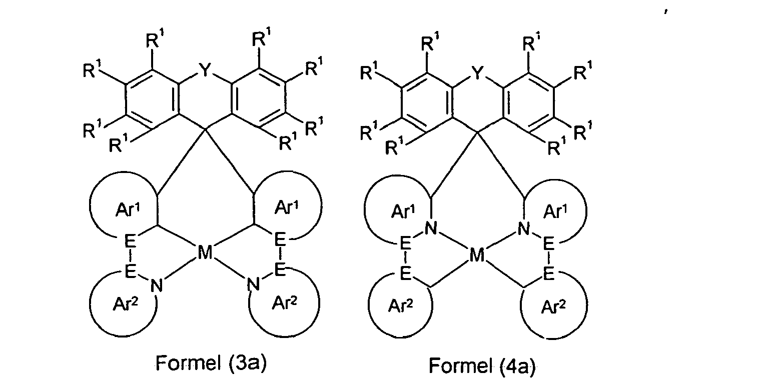 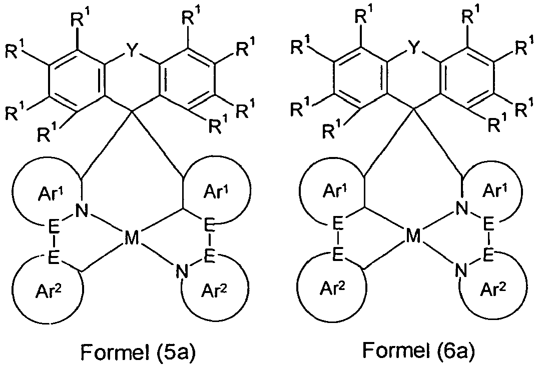 wobei die verwendeten Symbole die in Anspruch 1 genannten Bedeutungen aufweisen und R¹ bevorzugt für H steht.

5. Verbindung nach einem oder mehreren der Ansprüche 1 bis 4,
**dadurch gekennzeichnet, dass** E für C steht.

6. Verbindung nach einem oder mehreren der Ansprüche 1 bis 5,
**dadurch gekennzeichnet, dass** alle Gruppen Ar¹ gleich gewählt und gleich substituiert sind und dass alle Gruppen Ar² gleich gewählt und gleich substituiert sind.

7. Verbindung nach einem oder mehreren der Ansprüche 1 bis 6,
**dadurch gekennzeichnet, dass** Ar¹ gleich oder verschieden bei jedem Auftreten ausgewählt ist aus den Strukturen der Formeln (7) bis (26h), 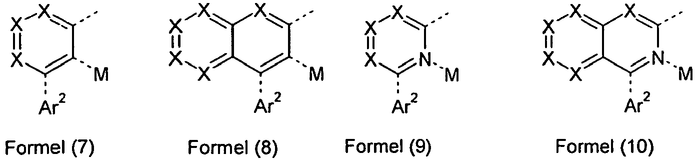 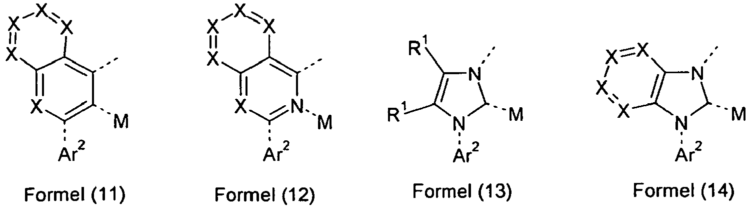 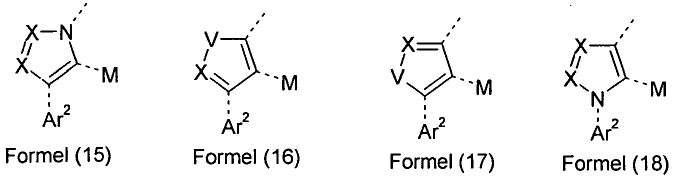 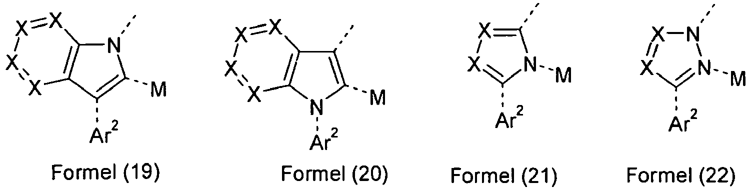 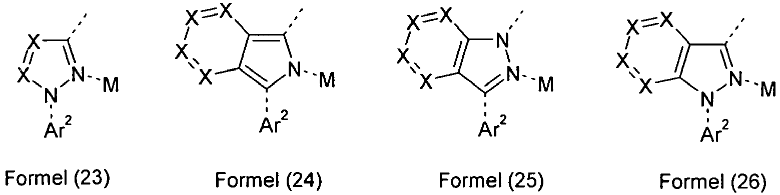 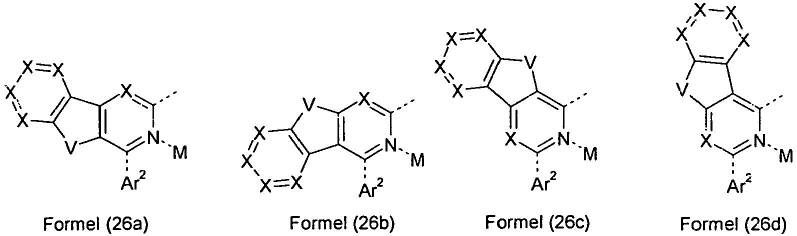 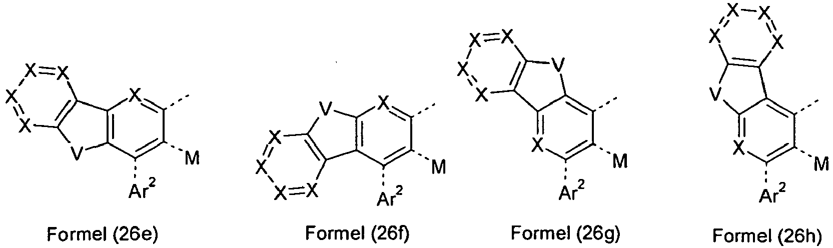 und dass Ar² gleich oder verschieden bei jedem Auftreten ausgewählt ist aus den Strukturen der Formeln (27) bis (48d), 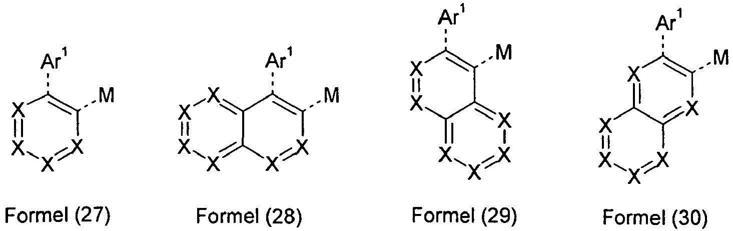 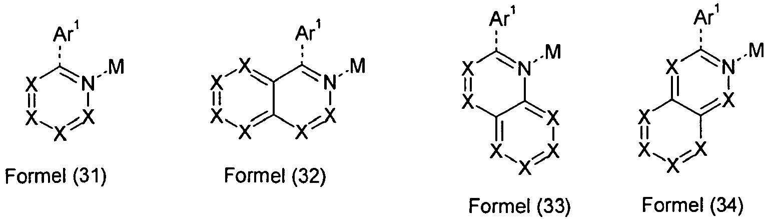 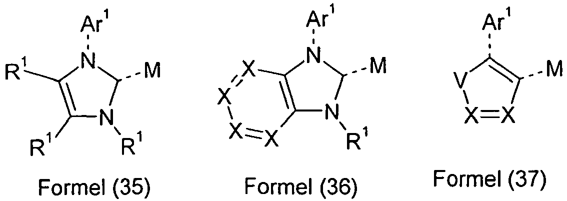 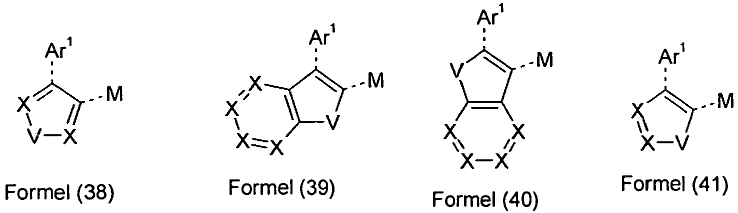 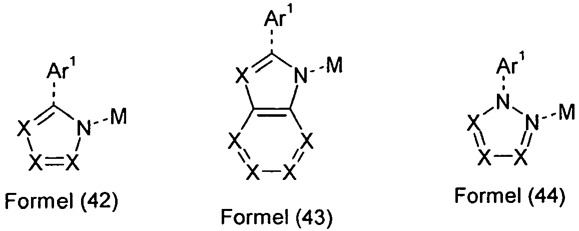 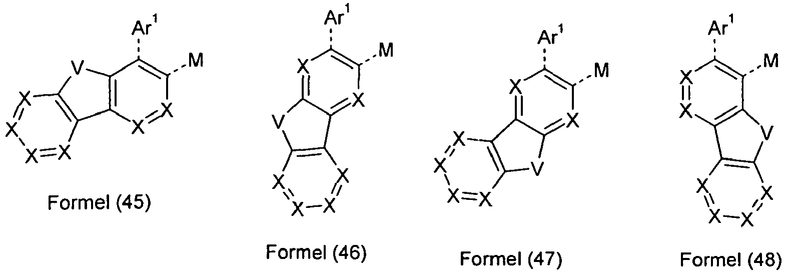 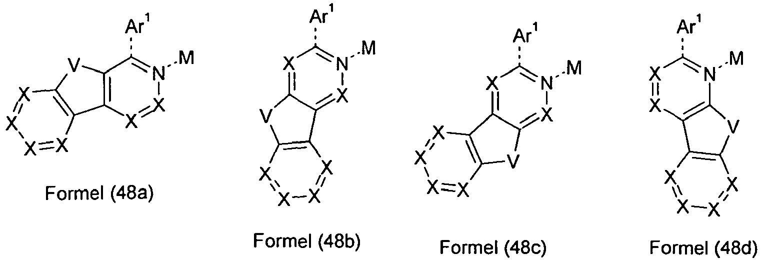 wobei durch gestrichelte Bindungen jeweils die Bindung an das Kohlenstoffatom des Brückenkopfes, an M und an Ar¹ bzw. an Ar² angedeutet ist und X und R¹ die in Anspruch 1 genannte Bedeutung aufweisen; V steht bei jedem Auftreten gleich oder verschieden für O, S, NR¹ oder C(R¹)₂.

8. Verbindung nach einem oder mehreren der Ansprüche 1 bis 7,
**dadurch gekennzeichnet, dass** benachbarte Gruppen Ar¹ und Ar² miteinander einen Ring bilden, wobei der Ringschluss über eine Gruppe CR²=CR², CR²=N, C(R²)₂-C(R²)₂, C(=O)-O oder C(=O)-NR² erfolgt.

9. Verbindung nach einem oder mehreren der Ansprüche 1 bis 8,
**dadurch gekennzeichnet, dass** eine oder beide Gruppen Ar¹-Ar² ausgewählt sind aus den Gruppen der Formeln (49) bis (59), 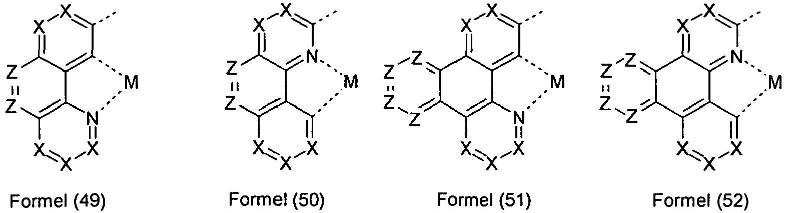 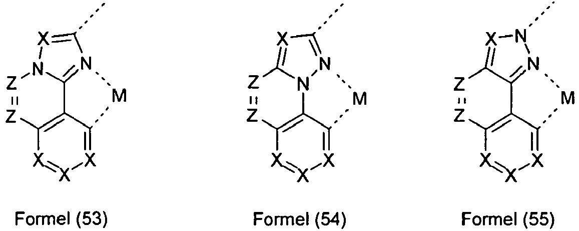 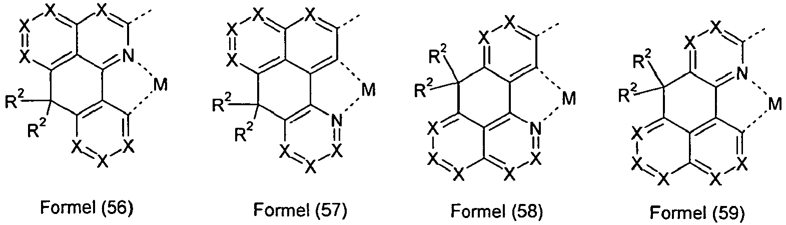 wobei durch gestrichelte Bindungen jeweils die Bindung an das Metall bzw: an das Brückenkopfkohlenstoffatom angedeutet sind, Z bei jedem Auftreten gleich oder verschieden für CR² oder N steht, wobei maximal eine Gruppe Z für N steht, und die weiteren Symbole die in Anspruch 1 genannten Bedeutungen aufweisen.

10. Verbindung nach einem oder mehreren der Ansprüche 1 bis 9, **dadurch gekennzeichnet, dass** die Verbindung ungeladen ist und weiterhin gilt:
M ist ausgewählt aus der Gruppe bestehend aus Pt(II), Pd(II), Ni(II), Rh(I), Ir(I) und Au(III);
Y ist ausgewählt aus der Gruppe bestehend aus CR₂, C=O, NR, O und S;
X ist gleich oder verschieden bei jedem Auftreten CR¹ oder N, wobei maximal zwei Symbole X pro Cyclus für N und die weiteren Symbole X für CR¹ stehen;
Ar¹ ist gleich oder verschieden bei jedem Auftreten ausgewählt aus den Strukturen der Formeln (7) bis (26) gemäß Anspruch 7;
Ar² ist gleich oder verschieden bei jedem Auftreten ausgewählt aus den Strukturen der Formeln (27) bis (48) gemäß Anspruch 7;
oder
Ar¹-Ar² ist gleich oder verschieden bei jedem Auftreten ausgewählt aus den Strukturen der Formeln (49) bis (59) gemäß Anspruch 9;
R¹ ist bei jedem Auftreten gleich oder verschieden ausgewählt aus der Gruppe bestehend aus H, D, F, N(R²)₂, CN, C(=O)R², einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, die jeweils mit einem oder mehreren Resten R² substituiert sein kann, wobei ein oder mehrere H-Atome durch D oder F ersetzt sein können, oder einem aromatischen oder heteroaromatischen Ringsystem mit 5 bis 30 aromatischen Ringatomen, das jeweils durch einen oder mehrere Reste R² substituiert sein kann;
R steht für Y = CR₂ gleich oder verschieden bei jedem Auftreten für eine geradkettige Alkylgruppe mit 1 bis 10 C-Atomen oder eine Alkenylgruppe mit 2 bis 10 C-Atomen oder eine verzweigte oder cyclische Alkylgruppe mit 3 bis 10 C-Atomen, die jeweils mit einem oder mehreren Resten R² substituiert sein kann, wobei ein oder mehrere H-Atome durch D oder F ersetzt sein können, oder ein aromatisches oder heteroaromatisches Ringsystem mit 5 bis 18 aromatischen Ringatomen, das jeweils durch einen oder mehrere Reste R² substituiert sein kann und das bevorzugt keine kondensierten Aryl- oder Heteroarylgruppen enthält; dabei können zwei oder mehrere Reste R, welche an dasselbe Kohlenstoff- bzw. Siliciumatom binden, auch miteinander ein mono- oder polycyclisches, aliphatisches oder aromatisches Ringsystem bilden, wodurch ein Spirosystem entsteht; und steht für Y = NR für ein aromatisches oder heteroaromatisches Ringsystem mit 5 bis 18 aromatischen Ringatomen, das jeweils durch einen oder mehrere Reste R² substituiert sein kann und das bevorzugt keine kondensierten Aryl- oder Heteroarylgruppen enthält.

11. Verfahren zur Herstellung einer Verbindung nach einem oder mehreren der Ansprüche 1 bis 10, **dadurch gekennzeichnet, dass** der entsprechende Ligand mit einem Metalledukt umgesetzt wird.

12. Formulierung, insbesondere eine Lösung, eine Suspension oder eine Miniemulsion, enthaltend mindestens eine Verbindung nach einem oder mehreren der Ansprüche 1 bis 10 und mindestens ein Lösemittel.

13. Verwendung einer Verbindung nach einem oder mehreren der Ansprüche 1 bis 10 in einer elektronischen Vorrichtung.

14. Elektronische Vorrichtung, insbesondere ausgewählt aus der Gruppe bestehend aus organischen Elektrolumineszenzvorrichtungen, organischen integrierten Schaltungen, organischen Feld-Effekt-Transistoren, organischen Dünnfilmtransistoren, organischen lichtemittierenden Transistoren, organischen Solarzellen, organischen optischen Detektoren, organischen Photorezeptoren, organischen Feld-Quench-Devices, lichtemittierenden elektrochemischen Zellen oder organischen Laserdioden, enthaltend in mindestens einer Schicht mindestens eine Verbindung nach einem oder mehreren der Ansprüche 1 bis 10.

15. Elektronische Vorrichtung nach Anspruch 14, **dadurch gekennzeichnet, dass** es sich um eine organische Elektrolumineszenzvorrichtung handelt und die Verbindung nach einem oder mehreren der Ansprüche 1 bis 10 als emittierende Verbindung in einer oder mehreren emittierenden Schichten eingesetzt werden.

16. Elektronische Vorrichtung nach Anspruch 15, **dadurch gekennzeichnet, dass** die Verbindung nach einem oder mehreren der Ansprüche 1 bis 10 in Kombination mit einem oder mehreren Matrixmaterialien eingesetzt wird, welches bevorzugt ausgewählt ist aus der Gruppe bestehend aus Ketonen, Phosphinoxiden, Sulfoxiden, Sulfonen, Triarylaminen, Carbazolderivaten, Indolocarbazolderivaten, Indenocarbazolderivaten, Azacarbazolen, bipolaren Matrixmaterialien, Silanen, Azaborolen, Boronestern, Diazasilolderivaten, Diazaphospholderivaten, Triazinderivaten, Zinkkomplexen, Dibenzofuranderivaten oder verbrückten Carbazolderivaten.

## Claims

1. Compound of the formula (1), 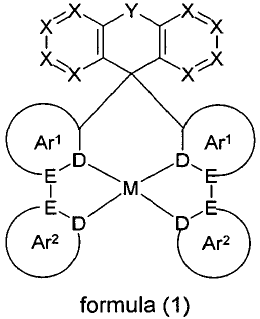 where the following applies to the symbols used:
M is selected on each occurrence, identically or differently, from the group consisting of platinum, palladium, nickel, rhodium, iridium and gold;
X is on each occurrence, identically or differently, CR¹ or N;
Y is CR₂, C=O, BR, SiR₂, NR, PR, P(=O)R, O, S, CR=CR, CR₂-CR₂ or CR=N;
or Y stands for a group of the formula (2), 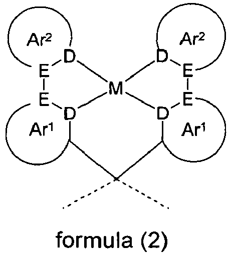 where the dashed bonds indicate the linking of this group;
D is on each occurrence, identically or differently, C or N;
E is C if the ring in which this E is bonded is an aromatic or heteroaromatic six-membered ring; or is C or N if the ring in which this E is bonded is a heteroaromatic five-membered ring;
Ar¹ is on each occurrence, identically or differently, together with the groups D and E, an aryl or heteroaryl group having 5 to 18 aromatic ring atoms, which may be substituted by one or more radicals R¹; adjacent groups Ar¹ and Ar² here may also be linked to one another by two radicals R¹ which are linked to one another or by a group CR²=N;
Ar² is on each occurrence, identically or differently, together with the groups D and E, an aryl or heteroaryl group having 5 to 18 aromatic ring atoms, which may be substituted by one or more radicals R¹; adjacent groups Ar² and Ar¹ here may also be linked to one another by two radicals R¹ which are linked to one another or by a group CR²=N;
R is on each occurrence, identically or differently, H, D, F, N(R²)₂, CN, C(=O)N(R²)₂, Si(R²)₃, B(OR²)₂, C(=O)R², P(=O)(R²)₂, S(=O)R², S(=O)₂R², a straight-chain alkyl, alkoxy or thioalkoxy group having 1 to 20 C atoms or an alkenyl or alkynyl group having 2 to 20 C atoms or a branched or cyclic alkyl, alkoxy or thioalkoxy group having 3 to 20 C atoms, each of which may be substituted by one or more radicals R², where one or more non-adjacent CH₂ groups may be replaced by R²C=CR², C≡C, Si(R²)₂, C=O, NR², O, S or CONR² and where one or more H atoms may be replaced by D, F, Cl, Br, I or CN, or an aromatic or heteroaromatic ring system having 5 to 60 aromatic ring atoms, which may in each case be substituted by one or more radicals R², or an aryloxy or heteroaryloxy group having 5 to 40 aromatic ring atoms, which may be substituted by one or more radicals R², or an aralkyl or heteroaralkyl group having 5 to 40 aromatic ring atoms, which may be substituted by one or more radicals R²; two radicals R here which are bonded to the same C or Si atom may also form a mono- or polycyclic, aliphatic or aromatic ring system with one another;
R¹ is on each occurrence, identically or differently, H, D, F, Cl, Br, I, N(R²)₂, CN, NO₂, OH, COOH, C(=O)N(R²)₂, Si(R²)₃, B(OR²)₂, C(=O)R², P(=O)(R²)₂, S(=O)R², S(=O)₂R², OSO₂R², a straight-chain alkyl, alkoxy or thioalkoxy group having 1 to 20 C atoms or an alkenyl or alkynyl group having 2 to 20 C atoms or a branched or cyclic alkyl, alkoxy or thioalkoxy group having 3 to 20 C atoms, each of which may be substituted by one or more radicals R², where one or more non-adjacent CH₂ groups may be replaced by R²C=CR², C=C, Si(R²)₂, C=O, NR², O, S or CONR² and where one or more H atoms may be replaced by D, F, Cl, Br, I or CN, or an aromatic or heteroaromatic ring system having 5 to 60 aromatic ring atoms, which may in each case be substituted by one or more radicals R², or an aryloxy or heteroaryloxy group having 5 to 40 aromatic ring atoms, which may be substituted by one or more radicals R², or an aralkyl or heteroaralkyl group having 5 to 40 aromatic ring atoms, which may be substituted by one or more radicals R²; two adjacent radicals R¹ here may also form a mono- or polycyclic, aliphatic or aromatic ring system with one another; furthermore, the radicals R¹ which are bonded to adjacent groups Ar¹ and Ar² may also form a mono- or polycyclic, aliphatic or aromatic ring system with one another; furthermore, two radicals R¹ on the two groups Ar² may also form a ring system with one another;
R² is on each occurrence, identically or differently, H, D, F, Cl, Br, I, N(R³)₂, CN, NO₂, Si(R³)₃, B(OR³)₂, C(=O)R³, P(=O)(R³)₂, S(=O)R³, S(=O)₂R³, OSO₂R³, a straight-chain alkyl, alkoxy or thioalkoxy group having 1 to 20 C atoms or an alkenyl or alkynyl group having 2 to 20 C atoms or a branched or cyclic alkyl, alkoxy or thioalkoxy group having 3 to 20 C atoms, each of which may be substituted by one or more radicals R³, where one or more non-adjacent CH₂ groups may be replaced by R³C=CR³, C=C, Si(R³)₂, C=O, NR³, O, S or CONR³ and where one or more H atoms may be replaced by D, F, Cl, Br, I, CN or NO₂, or an aromatic or heteroaromatic ring system having 5 to 60 aromatic ring atoms, which may in each case be substituted by one or more radicals R³, or an aryloxy or heteroaryloxy group having 5 to 40 aromatic ring atoms, which may be substituted by one or more radicals R³, or an aralkyl or heteroaralkyl group having 5 to 40 aromatic ring atoms, which may be substituted by one or more radicals R³; two or more adjacent radicals R³ here may form a mono- or polycyclic, aliphatic ring system with one another;
R³ is on each occurrence, identically or differently, H, D, F or an aliphatic, aromatic and/or heteroaromatic hydrocarbon radical having 1 to 20 C atoms, in which, in addition, one or more H atoms may be replaced by F; two or more substituents R³ here may also form a mono- or polycyclic, aliphatic ring system with one another;
two groups Ar² here may also be bridged to one another by a group Y.

2. Compound according to Claim 1, **characterised in that** M is selected from the group consisting of Pt(II), Pd(II), Ni(II), Rh(I), Ir(I) and Au(III), preferably Pt(II).

3. Compound according to Claim 1 or 2, selected from the structures of the formula (3), (4), (5) or (6), 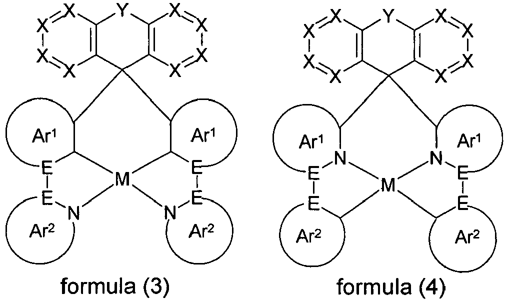 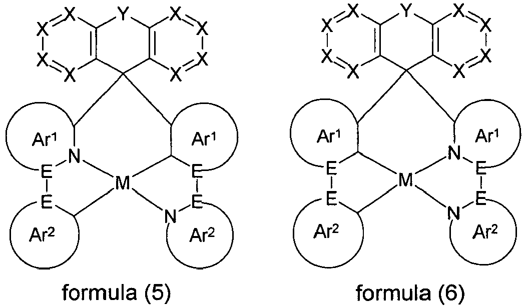 where the symbols used have the meanings given in Claim 1.

4. Compound according to one or more of Claims 1 to 3, selected from the structures of the formulae (3a), (4a), (5a) and (6a), 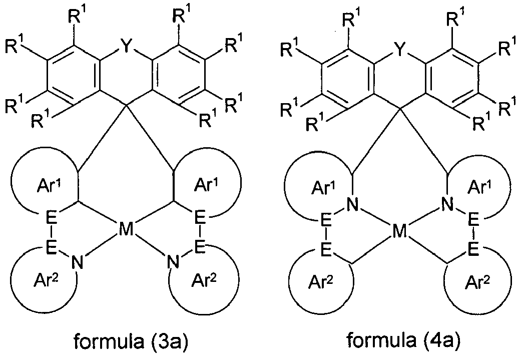 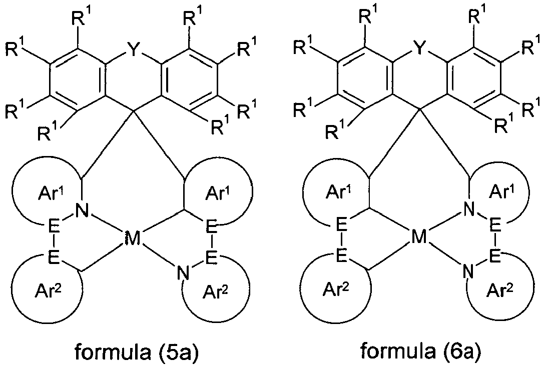 where the symbols used have the meanings given in Claim 1 and R¹ preferably stands for H.

5. Compound according to one or more of Claims 1 to 4, **characterised in that** E stands for C.

6. Compound according to one or more of Claims 1 to 5, **characterised in that** all groups Ar¹ are selected identically and are identically substituted and **in that** all groups Ar² are selected identically and are identically substituted.

7. Compound according to one or more of Claims 1 to 6, **characterised in that** Ar¹ is selected, identically or differently on each occurrence, from the structures of the formulae (7) to (26h), 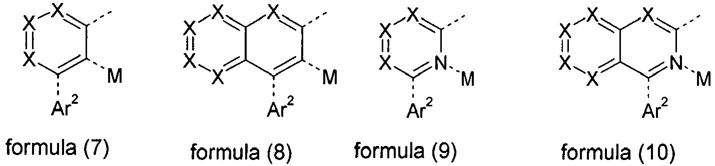 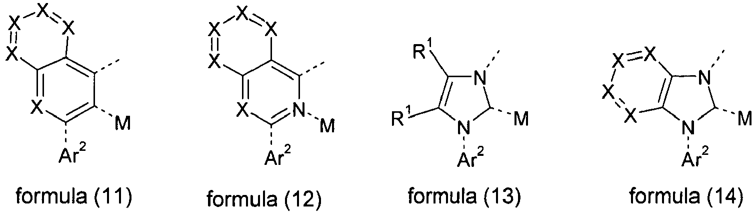 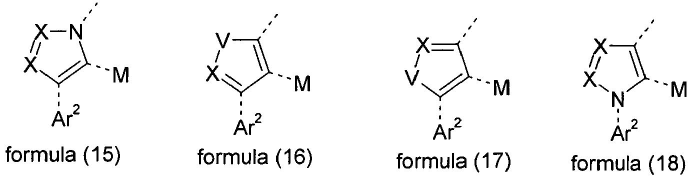 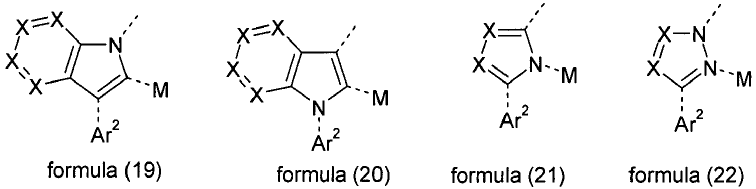 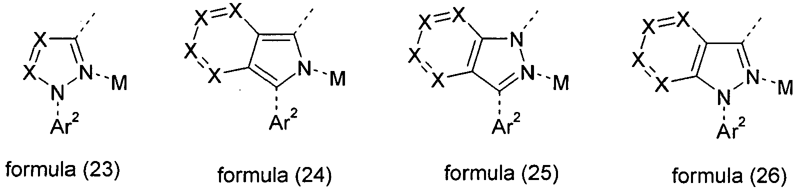 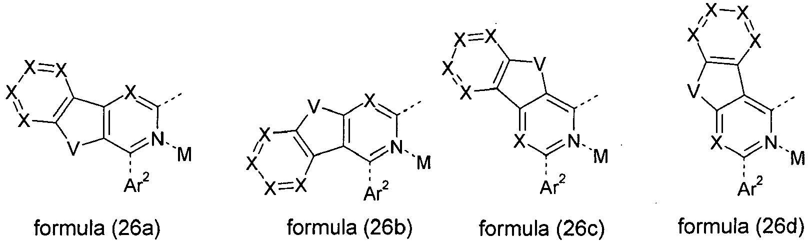 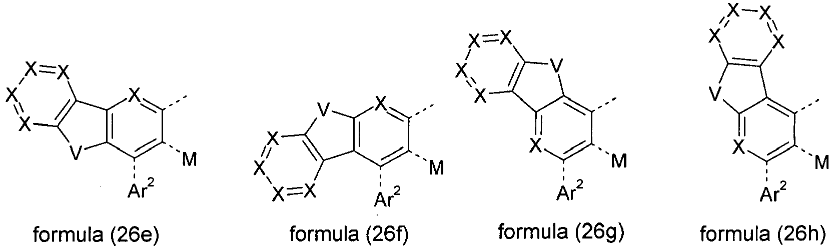 and **in that** Ar² is selected, identically or differently on each occurrence, from the structures of the formulae (27) to (48d), 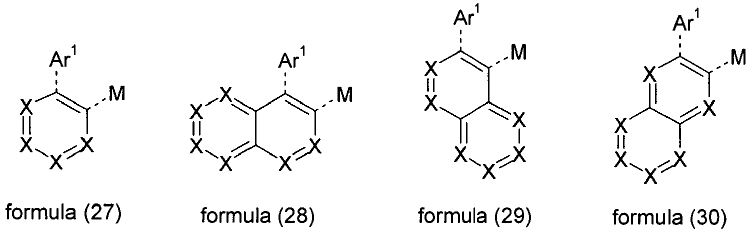 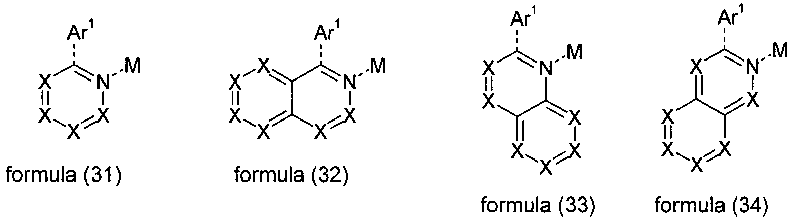 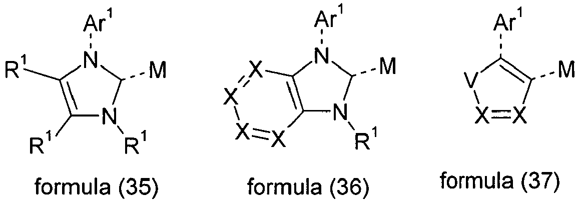 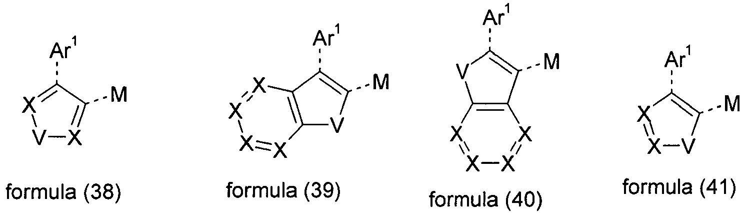 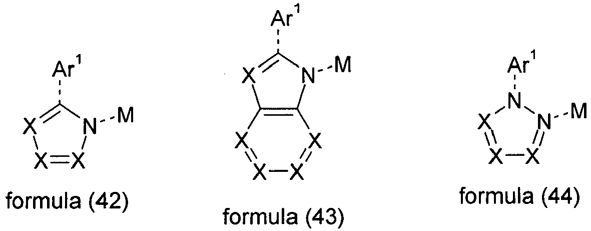 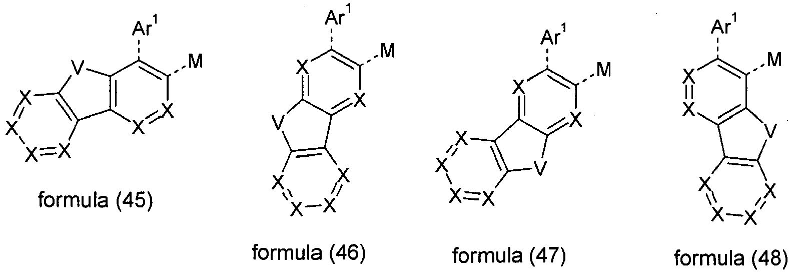 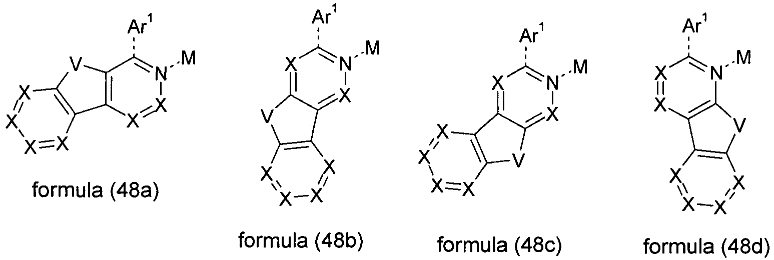 where the bond to the carbon atom of the bridgehead, to M and to Ar¹ or to Ar² is in each case indicated by dashed bonds and X and R¹ have the meaning given in Claim 1; V stands on each occurrence, identically or differently, for O, S, NR¹ or C(R¹)₂.

8. Compound according to one or more of Claims 1 to 7, **characterised in that** adjacent groups Ar¹ and Ar² form a ring with one another, where the ring closure takes place via a group CR²=CR², CR²=N, C(R²)₂-C(R²)₂, C(=O)-O or C(=O)-NR².

9. Compound according to one or more of Claims 1 to 8, **characterised in that** one or both groups Ar¹-Ar² are selected from the groups of the formulae (49) to (59), 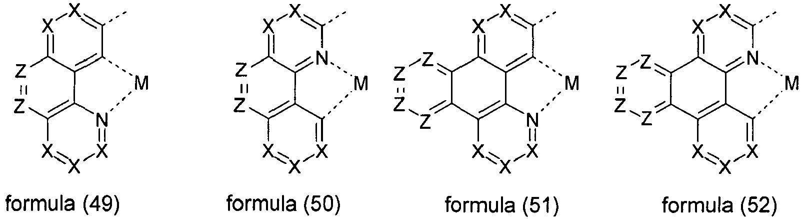 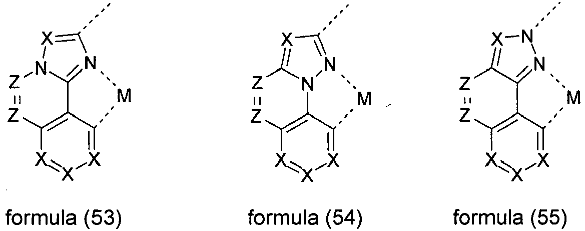 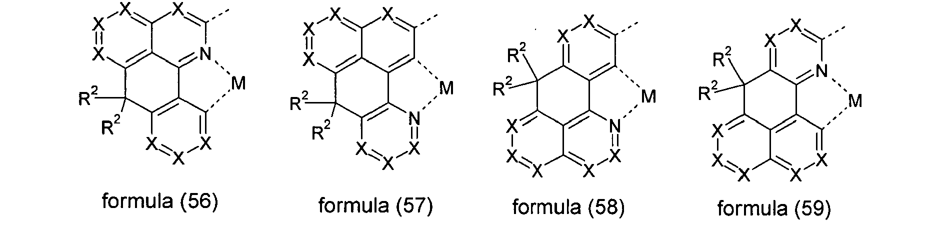 where the bond to the metal or to the bridgehead carbon atom are in each case indicated by dashed bonds, Z stands on each occurrence, identically or differently, for CR² or N, where a maximum of one group Z stands for N, and the other symbols have the meanings given in Claim 1.

10. Compound according to one or more of Claims 1 to 9, **characterised in that** the compound is uncharged and the following furthermore applies:
M is selected from the group consisting of Pt(II), Pd(II), Ni(II), Rh(I), Ir(I) and Au(III);
Y is selected from the group consisting of CR₂, C=O, NR, O and S;
X is, identically or differently on each occurrence, CR¹ or N, where a maximum of two symbols X per ring stand for N and the other symbols X stand for CR¹;
Ar¹ is selected, identically or differently on each occurrence, from the structures of the formulae (7) to (26) according to Claim 7;
Ar² is selected, identically or differently on each occurrence, from the structures of the formulae (27) to (48) according to Claim 7;
or
Ar¹-Ar² is selected, identically or differently on each occurrence, from the structures of the formulae (49) to (59) according to Claim 9;
R¹ is selected on each occurrence, identically or differently, from the group consisting of H, D, F, N(R²)₂, CN, C(=O)R², a straight-chain alkyl group having 1 to 10 C atoms or an alkenyl group having 2 to 10 C atoms or a branched or cyclic alkyl group having 3 to 10 C atoms, each of which may be substituted by one or more radicals R², where one or more H atoms may be replaced by D or F, or an aromatic or heteroaromatic ring system having 5 to 30 aromatic ring atoms, which may in each case be substituted by one or more radicals R²;
R, for Y = CR₂, stands, identically or differently on each occurrence, for a straight-chain alkyl group having 1 to 10 C atoms or an alkenyl group having 2 to 10 C atoms or a branched or cyclic alkyl group having 3 to 10 C atoms, each of which may be substituted by one or more radicals R², where one or more H atoms may be replaced by D or F, or an aromatic or heteroaromatic ring system having 5 to 18 aromatic ring atoms, which may in each case be substituted by one or more radicals R² and which preferably contains no condensed aryl or heteroaryl groups; two or more radicals R which are bonded to the same carbon or silicon atom may also form a mono- or polycyclic, aliphatic or aromatic ring system with one another here, resulting in the formation of a spiro system; and, for Y = NR, stands for an aromatic or heteroaromatic ring system having 5 to 18 aromatic ring atoms, which may in each case be substituted by one or more radicals R² and which preferably contains no condensed aryl or heteroaryl groups.

11. Process for the preparation of a compound according to one or more of Claims 1 to 10, **characterised in that** the corresponding ligand is reacted with a metal starting material.

12. Formulation, in particular a solution, a suspension or a mini-emulsion, comprising at least one compound according to one or more of Claims 1 to 10 and at least one solvent.

13. Use of a compound according to one or more of Claims 1 to 10 in an electronic device.

14. Electronic device, in particular selected from the group consisting of organic electroluminescent devices, organic integrated circuits, organic field-effect transistors, organic thin-film transistors, organic light-emitting transistors, organic solar cells, organic optical detectors, organic photoreceptors, organic field-quench devices, light-emitting electrochemical cells or organic laser diodes, comprising at least one compound according to one or more of Claims 1 to 10 in at least one layer.

15. Electronic device according to Claim 14, **characterised in that** it is an organic electroluminescent device and the compound according to one or more of Claims 1 to 10 is employed as emitting compound in one or more emitting layers.

16. Electronic device according to Claim 15, **characterised in that** the compound according to one or more of Claims 1 to 10 is employed in combination with one or more matrix materials, which are preferably selected from the group consisting of ketones, phosphine oxides, sulfoxides, sulfones, triarylamines, carbazole derivatives, indolocarbazole derivatives, indenocarbazole derivatives, azacarbazoles, bipolar matrix materials, silanes, azaboroles, boronic esters, diazasilole derivatives, diazaphosphole derivatives, triazine derivatives, zinc complexes, dibenzofuran derivatives or bridged carbazole derivatives.

## Revendications

1. Composé de la formule (1) : 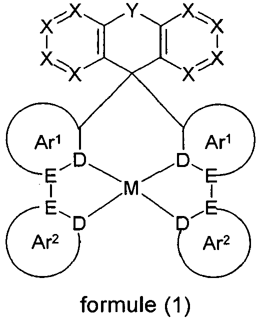 dans laquelle ce qui suit s'applique aux symboles utilisés :
M est choisi, pour chaque occurrence, de manière identique ou différente, parmi le groupe constitué par platine, palladium, nickel, rhodium, iridium et or ;
X est, pour chaque occurrence, de manière identique ou différente, CR¹ ou N ;
Y est CR₂, C=O, BR, SiR₂, NR, PR, P(=O)R, O, S, CR=CR, CR₂-CR₂ ou CR=N ;
ou Y représente un groupe de la formule (2) : 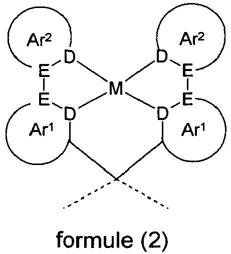 dans laquelle les liens en pointillés représentent la liaison de ce groupe ;
D est, pour chaque occurrence, de manière identique ou différente, CouN;
E est C si le cycle dans lequel ce E est lié est un cycle à six éléments aromatique ou hétéroaromatique ; ou est C ou N si le cycle dans lequel ce E est lié est un cycle à cinq éléments hétéroaromatique ;
Ar¹ est, pour chaque occurrence, de manière identique ou différente, en association avec les groupes D et E, un groupe aryle ou hétéroaryle comportant 5 à 18 atomes de cycle aromatique, lequel peut être substitué par un radical ou plusieurs radicaux R¹ ; des groupes adjacents Ar¹ et Ar² peuvent ici également être liés l'un à l'autre ou les uns aux autres par deux radicaux R¹ qui sont liés l'un à l'autre ou par un groupe CR²=N ;
Ar² est, pour chaque occurrence, de manière identique ou différente, en association avec les groupes D et E, un groupe aryle ou hétéroaryle comportant 5 à 18 atomes de cycle aromatique, lequel peut être substitué par un radical ou plusieurs radicaux R¹ ; des groupes adjacents Ar¹ et Ar² peuvent ici également être liés l'un à l'autre ou les uns aux autres par deux radicaux R¹ qui sont liés l'un à l'autre ou par un groupe CR²=N ;
R est, pour chaque occurrence, de manière identique ou différente, H, D, F, N(R²)₂, CN, C(=O)N(R²)₂, Si(R²)₃, B(OR²)₂, C(=O)R², P(=O)(R²)₂, S(=O)R², S(=O)₂R², un groupe alkyle, alcoxy ou thioalcoxy en chaîne droite comportant 1 à 20 atome(s) de C ou un groupe alkényle ou alkynyle comportant 2 à 20 atomes de C ou un groupe alkyle, alcoxy ou thioalcoxy ramifié ou cyclique comportant 3 à 20 atomes de C, dont chacun peut être substitué par un radical ou plusieurs radicaux R², où un ou plusieurs groupe(s) CH₂ non adjacents peut/peuvent être remplacé(s) par R²C=CR², C≡C, Si(R²)₂, C=O, NR², O, S ou CONR² et où un ou plusieurs atome(s) de H peut/peuvent être remplacé(s) par D, F, Cl, Br, I ou CN, ou un système de cycle aromatique ou hétéroaromatique comportant 5 à 60 atomes de cycle aromatique, lequel peut dans chaque cas être substitué par un radical ou plusieurs radicaux R², ou un groupe aryloxy ou hétéroaryloxy comportant 5 à 40 atomes de cycle aromatique, lequel peut être substitué par un radical ou plusieurs radicaux R², ou un groupe aralkyle ou hétéroaralkyle comportant 5 à 40 atomes de cycle aromatique, lequel peut être substitué par un radical ou plusieurs radicaux R² ; deux radicaux R ici qui sont liés au même atome de C ou de Si peuvent également former un système de cycle aliphatique ou aromatique monocyclique ou polycyclique l'un avec l'autre ;
R¹ est, pour chaque occurrence, de manière identique ou différente, H, D, F, Cl, Br, I, N(R²)₂, CN, NO₂, OH, COOH, C(=O)N(R²)₂, Si(R²)₃, B(OR²)₂, C(=O)R², P(=O)(R²)₂, S(=O)R², S(=O)₂R², OSO₂R², un groupe alkyle, alcoxy ou thioalcoxy en chaîne droite comportant 1 à 20 atome(s) de C ou un groupe alkényle ou alkynyle comportant 2 à 20 atomes de C ou un groupe alkyle, alcoxy ou thioalcoxy ramifié ou cyclique comportant 3 à 20 atomes de C, dont chacun peut être substitué par un radical ou plusieurs radicaux R², où un ou plusieurs groupe(s) CH₂ non adjacents peut/peuvent être remplacé(s) par R²C=CR², C=C, Si(R²)₂, C=O, NR², O, S ou CONR² et où un ou plusieurs atome(s) de H peut/peuvent être remplacé(s) par D, F, Cl, Br, I ou CN, ou un système de cycle aromatique ou hétéroaromatique comportant 5 à 60 atomes de cycle aromatique, lequel peut dans chaque cas être substitué par un radical ou plusieurs radicaux R², ou un groupe aryloxy ou hétéroaryloxy comportant 5 à 40 atomes de cycle aromatique, lequel peut être substitué par un radical ou plusieurs radicaux R², ou un groupe aralkyle ou hétéroaralkyle comportant 5 à 40 atomes de cycle aromatique, lequel peut être substitué par un radical ou plusieurs radicaux R² ; deux radicaux adjacents R¹ ici peuvent également former un système de cycle aliphatique ou aromatique monocyclique ou polycyclique l'un avec l'autre ; en outre, les radicaux R¹ qui sont liés à des groupes adjacents Ar¹ et Ar² peuvent également former un système de cycle aliphatique ou aromatique monocyclique ou polycyclique l'un avec l'autre ou les uns avec les autres ; en outre, deux radicaux R¹ sur les deux groupes Ar² peuvent également former un système de cycle l'un avec l'autre ;
R² est, pour chaque occurrence, de manière identique ou différente, H, D, F, Cl, Br, I, N(R³)₂, CN, NO₂, Si(R³)₃, B(OR³)₂, C(=O)R³, P(=O)(R³)₂, S(=O)R³, S(=O)₂R³, OSO₂R³, un groupe alkyle, alcoxy ou thioalcoxy en chaîne droite comportant 1 à 20 atome(s) de C ou un groupe alkényle ou alkynyle comportant 2 à 20 atomes de C ou un groupe alkyle, alcoxy ou thioalcoxy ramifié ou cyclique comportant 3 à 20 atomes de C, dont chacun peut être substitué par un radical ou plusieurs radicaux R³, où un ou plusieurs groupe(s) CH₂ non adjacents peut/peuvent être remplacé(s) par R³C=CR³, C=C, Si(R³)₂, C=O, NR³, O, S ou CONR³ et où un ou plusieurs atome(s) de H peut/peuvent être remplacé(s) par D, F, Cl, Br, I, CN ou NO₂, ou un système de cycle aromatique ou hétéroaromatique comportant 5 à 60 atomes de cycle aromatique, lequel peut dans chaque cas être substitué par un,radical ou plusieurs radicaux R³, ou un groupe aryloxy ou hétéroaryloxy comportant 5 à 40 atomes de cycle aromatique, lequel peut être substitué par un radical ou plusieurs radicaux R³, ou un groupe aralkyle ou hétéroaralkyle comportant 5 à 40 atomes de cycle aromatique, lequel peut être substitué par un radical ou plusieurs radicaux R³ ; deux radicaux R³ adjacents ou plus ici peuvent former un système de cycle aliphatique monocyclique ou polycyclique l'un avec l'autre ou les uns avec les autres ;
R³ est, pour chaque occurrence, de manière identique ou différente, H, D, F ou un radical hydrocarbone aliphatique, aromatique et/ou hétéroaromatique comportant 1 à 20 atome(s) de C, où, en outre, un ou plusieurs atome(s) de H peut/peuvent être remplacé(s) par F ; deux substituants R³ ou plus ici peuvent également former un système de cycle aliphatique monocyclique ou polycyclique l'un avec l'autre ou les uns avec les autres ;
deux groupes Ar² ici peuvent également être pontés l'un à l'autre par un groupe Y.

2. Composé selon la revendication 1, **caractérisé en ce que** M est choisi parmi le groupe constitué par Pt(II), Pd(II), Ni(II), Rh(I), Ir(I) et Au(III), de façon préférable Pt(II).

3. Composé selon la revendication 1 ou 2, choisi parmi les structures des formules (3), (4), (5) ou (6) : 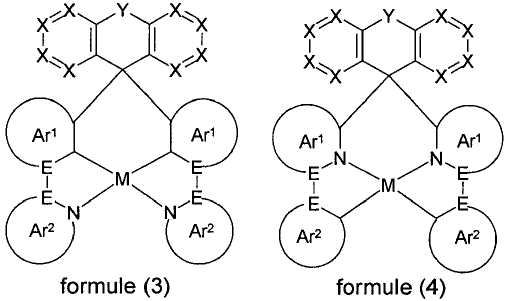 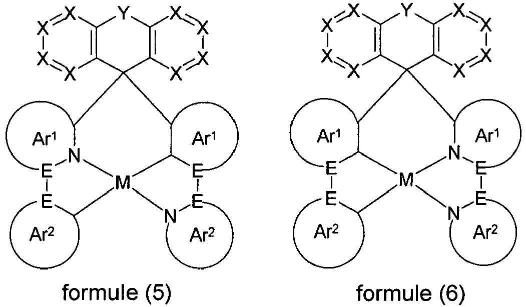 dans lesquelles les symboles utilisés présentent les significations données selon la revendication 1.

4. Composé selon une ou plusieurs des revendications 1 à 3, choisi parmi les structures des formules (3a), (4a), (5a) et (6a) : 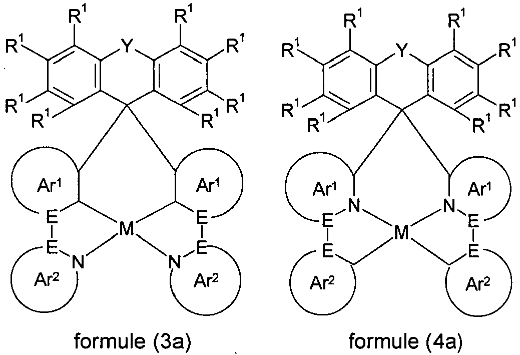 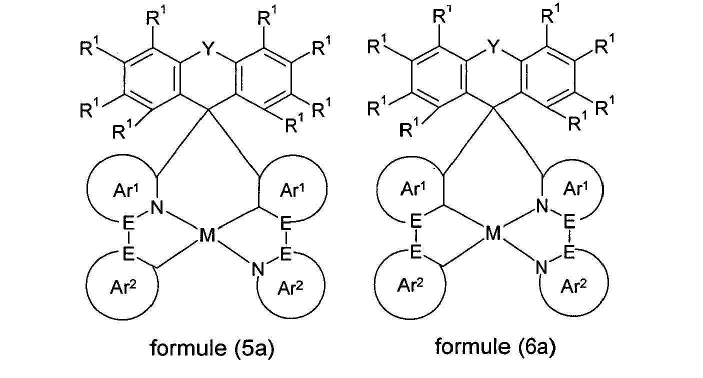 dans lesquelles les symboles utilisés présentent les significations données selon la revendication 1 et R¹ représente, de façon préférable, H.

5. Composé selon une ou plusieurs des revendications 1 à 4, **caractérisé en ce que** E représente C.

6. Composé selon une ou plusieurs des revendications 1 à 5, **caractérisé en ce que** tous les groupes Ar¹ sont choisis de manière identique et sont substitués de manière identique et **en ce que** tous les groupes Ar² sont choisis de manière identique et sont substitués de manière identique.

7. Composé selon une ou plusieurs des revendications 1 à 6, **caractérisé en ce que** Ar¹ est choisi, de manière identique ou différente pour chaque occurrence, parmi les structures des formules (7) à (26h) : 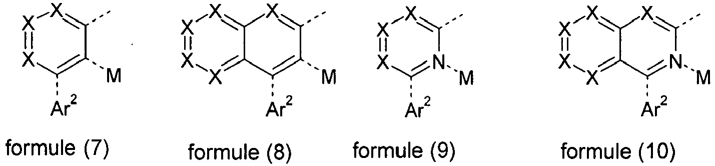 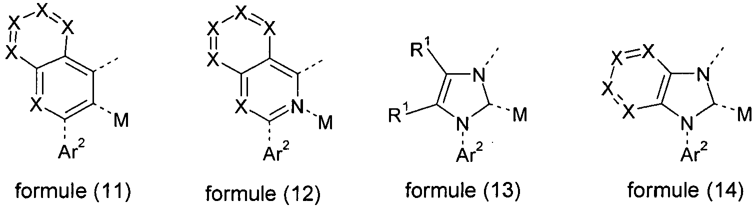 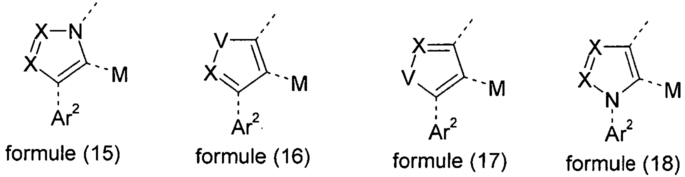 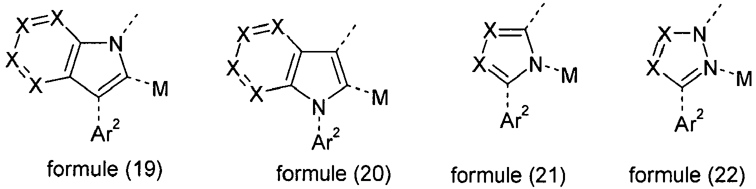 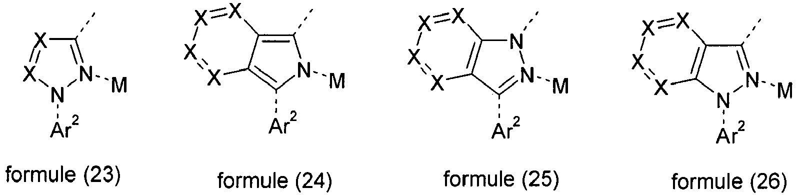 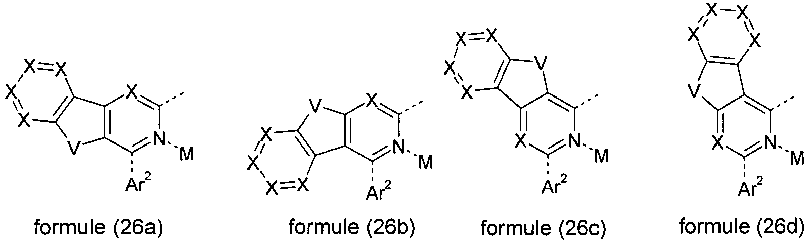 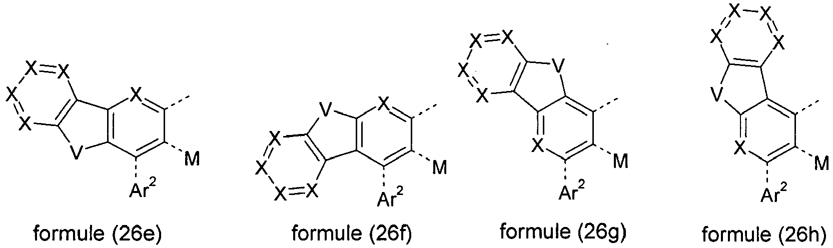 et **en ce que** Ar² est choisi, de manière identique ou différente pour chaque occurrence, parmi les structures des formules (27) à (48d) : 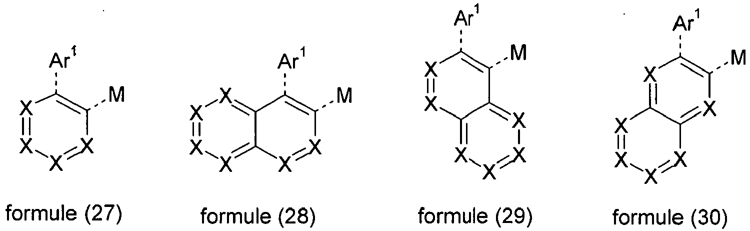 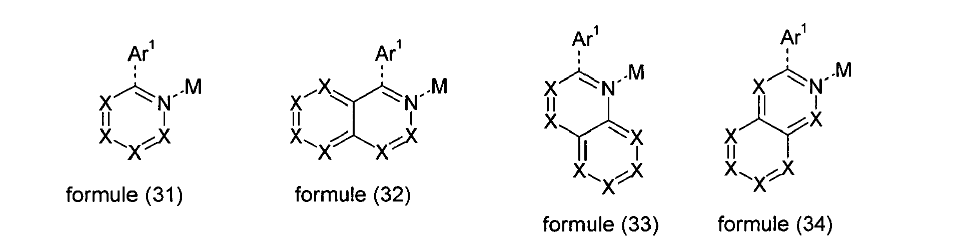 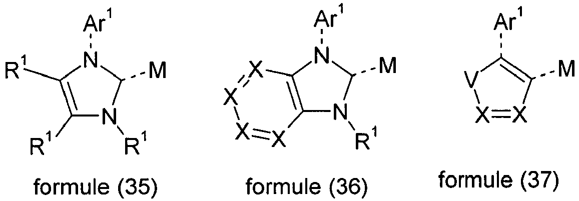 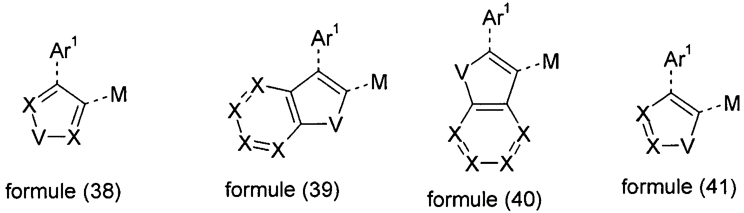 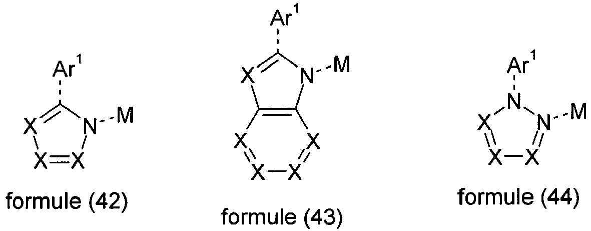 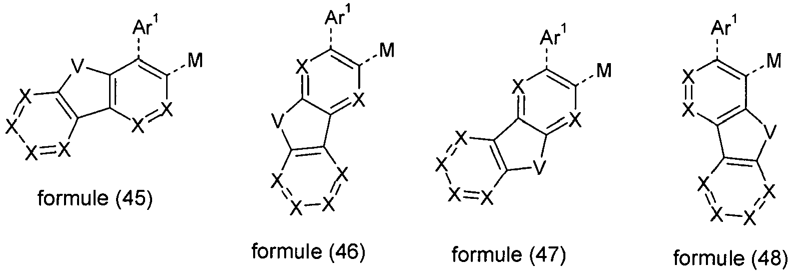 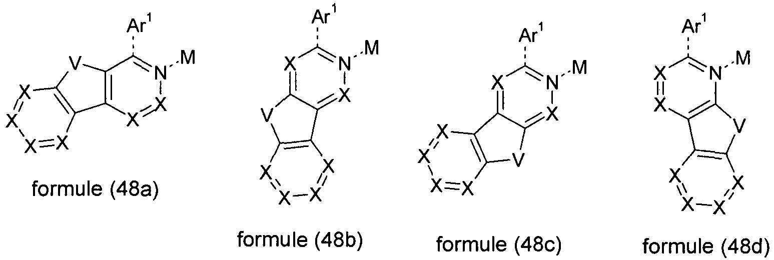 où la liaison sur l'atome de carbone de la tête de pont, sur M et sur Ar¹ ou sur Ar² est, dans chaque cas, indiquée par des liens en pointillés et X et R¹ présentent la signification donnée selon la revendication 1 ; V représente, pour chaque occurrence, de manière identique ou différente, O, S, NR¹ ou C(R¹)₂.

8. Composé selon une ou plusieurs des revendications 1 à 7, **caractérisé en ce que** des groupes adjacents Ar¹ et Ar² forment un cycle l'un avec l'autre ou les uns avec les autres, où la fermeture du cycle est réalisée via un groupe CR²=CR², CR²=N, C(R²)₂-C(R²)₂, C(=O)-O ou C(=O)-NR².

9. Composé selon une ou plusieurs des revendications 1 à 8, **caractérisé en ce qu'**un groupe ou les deux groupes Ar¹-Ar² est/sont choisi(s) parmi les groupes des formules (49) à (59) : 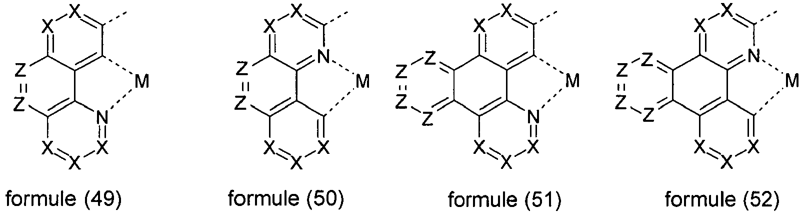 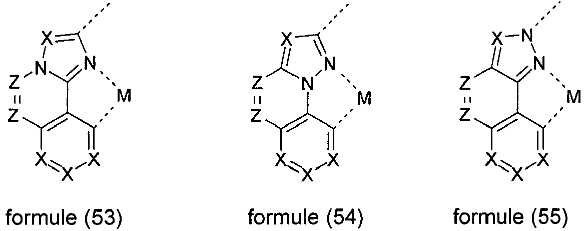 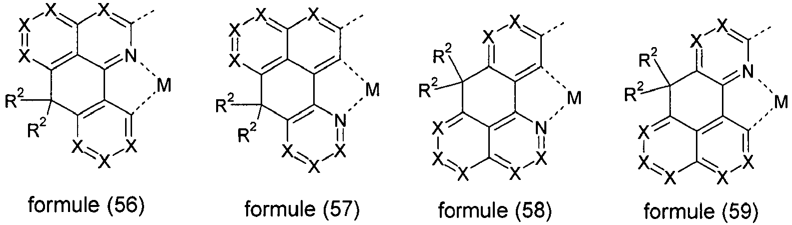 où le lien sur le métal ou sur l'atome de carbone de tête de pont est, dans chaque cas, indiqué par des liens en pointillés, Z représente, pour chaque occurrence, de manière identique ou différente, CR² ou N, où un maximum d'un groupe Z représente N, et les autres symboles présentent les significations données selon la revendication 1.

10. Composé selon une ou plusieurs des revendications 1 à 9, **caractérisé en ce que** le composé est non chargé et les significations supplémentaires qui suivent s'appliquent :
M est choisi parmi le groupe constitué par Pt(II), Pd(II), Ni(II), Rh(I), Ir(I) et Au(III) ;
Y est choisi parmi le groupe constitué par CR₂, C=O, NR, O et S ;
X est, de manière identique ou différente pour chaque occurrence, CR¹ ou N, où un maximum de deux symboles X par cycle représentent N et les autres symboles X représentent CR¹ ;
Ar¹ est choisi, de manière identique ou différente pour chaque occurrence, parmi les structures des formules (7) à (26) selon la revendication 7 ;
Ar² est choisi, de manière identique ou différente pour chaque occurrence, parmi les structures des formules (27) à (48) selon la revendication 7 ;
ou
Ar¹-Ar² est choisi, de manière identique ou différente pour chaque occurrence, parmi les structures des formules (49) à (59) selon la revendication 9 ;
R¹ est choisi, pour chaque occurrence, de manière identique ou différente, parmi le groupe constitué par H, D, F, N(R²)₂, CN, C(=O)R², un groupe alkyle en chaîne droite comportant 1 à 10 atome(s) de C ou un groupe alkényle comportant 2 à 10 atomes de C ou un groupe alkyle ramifié ou cyclique comportant 3 à 10 atomes de C, dont chacun peut être substitué par un radical ou plusieurs radicaux R², où un ou plusieurs atome(s) de H peut/ peuvent être remplacé(s) par D ou F, ou un système de cycle aromatique ou hétéroaromatique comportant 5 à 30 atomes de cycle aromatique, lequel peut dans chaque cas être substitué par un radical ou plusieurs radicaux R² ;
R, pour Y = CR₂, représente, de manière identique ou différente pour chaque occurrence, un groupe alkyle en chaîne droite comportant 1 à 10 atome(s) de C ou un groupe alkényle comportant 2 à 10 atomes de C ou un groupe alkyle ramifié ou cyclique comportant 3 à 10 atomes de C, dont chacun peut être substitué par un radical ou plusieurs radicaux R², où un ou plusieurs atome(s) de H peut/peuvent être remplacé(s) par D ou F, ou un système de cycle aromatique ou hétéroaromatique comportant 5 à 18 atomes de cycle aromatique, lequel peut dans chaque cas être substitué par un radical ou plusieurs radicaux R² et lequel ne contient de façon préférable ni groupes aryle condensés, ni groupes hétéroaryle condensés ; deux radicaux R ou plus qui sont liés au même atome de carbone ou de silicium peuvent également former un système de cycle aliphatique ou aromatique monocyclique ou polycyclique l'un avec l'autre ou les uns avec les autres ici, ce qui aboutit à la formation d'un système spiro ; et, pour Y = NR, représente un système de cycle aromatique ou hétéroaromatique comportant 5 à 18 atomes de cycle aromatique, lequel peut dans chaque cas être substitué par un radical ou plusieurs radicaux R² et lequel ne contient de façon préférable ni groupes aryle condensés, ni groupes hétéroaryle condensés.

11. Procédé pour la préparation d'un composé selon une ou plusieurs des revendications 1 à 10, **caractérisé en ce que** le ligand correspondant est amené à réagir avec un matériau de départ métal.

12. Formulation, en particulier une solution, une suspension ou une miniémulsion, comprenant au moins un composé selon une ou plusieurs des revendications 1 à 10 et au moins un solvant.

13. Utilisation d'un composé selon une ou plusieurs des revendications 1 à 10 dans un dispositif électronique.

14. Dispositif électronique, en particulier choisi parmi le groupe constitué par des dispositifs électroluminescents organiques, des circuits intégrés organiques, des transistors à effet de champ organiques, des transistors à film mince organiques, des transistors à émission de lumière organiques, des cellules solaires organiques, des détecteurs optiques organiques, des photorécepteurs organiques, des dispositifs à extinction de champ organiques, des cellules électrochimiques à émission de lumière ou des diodes laser organiques, comprenant au moins un composé selon une ou plusieurs des revendications 1 à 10 dans au moins une couche.

15. Dispositif électronique selon la revendication 14, **caractérisé en ce qu'**il s'agit d'un dispositif électroluminescent organique et le composé selon une ou plusieurs des revendications 1 à 10 est utilisé en tant que composé d'émission dans une ou plusieurs couches d'émission.

16. Dispositif électronique selon la revendication 15, **caractérisé en ce que** le composé selon une ou plusieurs des revendications 1 à 10 est utilisé en combinaison avec un matériau ou plusieurs matériaux de matrice, lequel/lesquels est/sont de façon préférable choisi(s) parmi le groupe constitué par les cétones, les oxydes de phosphine, les sulfoxydes, les sulfones, les triarylamines, les dérivés de carbazole, les dérivés d'indolocarbazole, les dérivés d'indénocarbazole, les azacarbazoles, les matériaux de matrice bipolaires, les silanes, les azaboroles, les esters boroniques, les dérivés de diazasilole, les dérivés de diazaphosphole, les dérivés de triazine, les complexes de zinc, les dérivés de dibenzofurane ou les dérivés de carbazole pontés.
